# EUROPEAN PATENT APPLICATION

(11) **EP 4 691 838 A1**
(43) Date of publication of application: **11.02.2026**
(21) Application number: 25191431.3
(22) Date of filing: 24.07.2025
(51) Int. Cl.: B60L 53/18, B60L 53/302, B60H 1/00

(54) **CHARGING DEVICE AND CHARGING PILE**

(30) Priority: 24.07.2024 CN 202411001553
(71) Applicant: HUAWEI DIGITAL POWER TECHNOLOGIES CO., LTD., Shenzhen Guangdong 518043 (CN)
(72) Inventor: LIN, Ying, Shenzhen, 518043 (CN); SONG, Jinliang, Shenzhen, 518043 (CN); GAO, Qiang, Shenzhen, 518043 (CN)
(74) Representative: Gill Jennings & Every LLP

(57) **Abstract**

Embodiments of this application provide a charging device and a charging pile. The charging pile includes one or more groups of charging connectors, a thermal management system, a first liquid outlet connector, and a first liquid inlet connector. Each group of charging connectors is configured to output electric energy to an electric vehicle, the first liquid outlet connector is configured to connect to a liquid injection port of the electric vehicle, and the first liquid inlet connector is configured to connect to a liquid return port of the electric vehicle. The thermal management system forms a coolant circulation loop with the electric vehicle via the first liquid outlet connector and the first liquid inlet connector, so that the thermal management system dissipates heat from a power battery of the electric vehicle. In addition, the thermal management system may further provide coolant for a liquid cooling cable connected to each group of charging connectors, to implement heat dissipation of the liquid cooling cable by the thermal management system.

## Description

### TECHNICAL FIELD

This application relates to the charging field, and more specifically, to a charging device and a charging pile.

### BACKGROUND

With acceleration of a process of a carbon peaking and carbon neutrality strategy and an increase in a popularization rate of electric vehicles, an increasing quantity of cities have begun to build ultra-fast charging cities. This drives development of a charging pile toward a high-power ultra-fast charging pile, to quickly supplement energy for an electric vehicle with "one kilometer of driving range per second", and achieve brand-new charging experience of "Charge up while you coffee up".

During actual application, a charging device transmits charging power to a power battery of the electric vehicle via a charger. However, as the charging power continuously increases, heat generated by a charging cable of the charger and the power battery of the electric vehicle greatly increases accordingly. This easily causes temperatures of the charging cable and the power battery to increase together in a high-power charging process of the electric vehicle. Consequently, efficiency and safety of charging the electric vehicle by the charging device are reduced, and normal high-power charging of the power battery by the charging device is affected.

### SUMMARY

This application provides a charging device and a charging pile. A thermal management system in the charging pile may separately provide coolant for a liquid cooling cable connected to a charging connector and an electric vehicle, to dissipate heat from the liquid cooling cable and a power battery of the electric vehicle. In this way, heat dissipation requirements of both the liquid cooling cable and the power battery during high-power charging can be met, efficiency and safety of charging the electric vehicle by the charging pile can be improved, and the thermal management system can have high utilization.

According to a first aspect, a charging pile is provided. The charging pile includes one or more groups of charging connectors, a thermal management system, a first liquid outlet connector, and a first liquid inlet connector. Each of the one or more groups of charging connectors is configured to output electric energy to an electric vehicle, the first liquid outlet connector is configured to connect to a liquid injection port of the electric vehicle, and the first liquid inlet connector is configured to connect to a liquid return port of the electric vehicle. The thermal management system includes a first compressor, a first heat exchanger, a first expansion valve, and a second heat exchanger that are sequentially connected. The first heat exchanger includes a first refrigerant path and a first coolant path. The first refrigerant path is connected between the first compressor and the first expansion valve, and the first refrigerant path is used to exchange heat with the first coolant path. A liquid outlet of the first coolant path is connected to the first liquid outlet connector and a liquid inlet of a liquid cooling cable connected to each group of charging connectors, and a liquid inlet of the first coolant path is connected to the first liquid inlet connector.

In the charging pile provided in this embodiment of this application, the first coolant path of the first heat exchanger in the thermal management system may form a coolant circulation loop with the electric vehicle via the first liquid outlet connector and the first liquid inlet connector, so that coolant circulates between the first coolant path and the electric vehicle, and the thermal management system can dissipate heat from a power battery of the electric vehicle. In addition, the first coolant path of the first heat exchanger may further provide coolant for the liquid cooling cable connected to the charging connector, so that the liquid cooling cable dissipates heat by using the coolant provided by the thermal management system.

Therefore, the thermal management system may be configured to dissipate heat from both the power battery of the electric vehicle and the liquid cooling cable connected to the charging connector. This can meet heat dissipation requirements of both the liquid cooling cable and the power battery during high-power charging, and improve efficiency and safety of charging the electric vehicle by the charging pile, thereby ensuring normal high-power charging of the electric vehicle. In addition, because the power battery and the liquid cooling cable share the thermal management system for heat dissipation, the thermal management system has high utilization, and cost optimization of the charging pile is facilitated.

In a possible implementation, the thermal management system further includes a first liquid storage tank, and the liquid outlet of the first coolant path is connected to the first liquid outlet connector and the liquid inlet of the liquid cooling cable connected to each group of charging connectors via the first liquid storage tank. A first liquid inlet of the first liquid storage tank is connected to the liquid outlet of the first coolant path, a first liquid outlet of the first liquid storage tank is connected to the first liquid outlet connector, and a second liquid outlet of the first liquid storage tank is connected to the liquid inlet of the liquid cooling cable connected to each group of charging connectors.

Based on the foregoing design, the cooled coolant in the first coolant path of the first heat exchanger may flow into the first liquid storage tank in advance for storage. When the electric vehicle and/or the liquid cooling cable connected to the charging connector need/needs to dissipate heat, coolant whose temperature decreases and that is stored in the first liquid storage tank may quickly flow into the electric vehicle and/or the liquid cooling cable. This helps improve timeliness of performing heat dissipation by the thermal management system on the electric vehicle and the liquid cooling cable connected to the charging connector, and further improves efficiency of charging the power battery by the charging pile.

In a possible implementation, a liquid outlet of the liquid cooling cable connected to each group of charging connectors is connected to the liquid inlet of the first coolant path, or a liquid outlet of the liquid cooling cable connected to each group of charging connectors is connected to a second liquid inlet of the first liquid storage tank.

Based on the foregoing design, the coolant in the liquid cooling cable may flow back to the first heat exchanger for cooling and then flow into the first liquid storage tank. In this way, the coolant in the first liquid storage tank can maintain a low temperature, so that the first liquid storage tank has a good cold storage capability. Alternatively, the coolant in the liquid cooling cable may directly flow back to the first liquid storage tank, so that a coolant circulation loop is separately formed between the liquid cooling cable and the first liquid storage tank. This helps improve efficiency of performing heat dissipation on the liquid cooling cable by the thermal management system.

In a possible implementation, a third liquid outlet of the first liquid storage tank is connected to the liquid inlet of the first coolant path. Based on the foregoing design, a coolant circulation loop may be formed between the first liquid storage tank and the first coolant path of the first heat exchanger. Therefore, the first heat exchanger may dissipate heat from the coolant in the first liquid storage tank, so that the coolant in the first liquid storage tank maintains a low temperature, and the first liquid storage tank has a good cold storage capability. This helps improve timeliness and heat dissipation effect of performing heat dissipation on the electric vehicle and the liquid cooling cable by the thermal management system.

In a possible implementation, the thermal management system further includes a first three-way valve. A first valve port of the first three-way valve is connected to the first liquid inlet connector, a second valve port of the first three-way valve is connected to the third liquid outlet of the first liquid storage tank, and a third valve port of the first three-way valve is connected to the liquid inlet of the first coolant path. Based on the foregoing design, on/off states of different valve ports of the first three-way valve may be adjusted to switch heat exchange between the first heat exchanger and the coolant in the first liquid storage tank, or heat exchange between the first heat exchanger and the coolant in the electric vehicle.

In a possible implementation, the charging pile is configured to: when each group of charging connectors does not transmit the electric energy to the electric vehicle, control the first three-way valve to connect a path between the third liquid outlet of the first liquid storage tank and the liquid inlet of the first coolant path, and disconnect a path between the first liquid inlet connector and the liquid inlet of the first coolant path.

In the foregoing technical solution, when each group of charging connectors in the charging pile is in an idle state, on/off states of different valve ports of the first three-way valve may be adjusted, so that the first heat exchanger cools the coolant in the first liquid storage tank. In this way, the coolant in the first liquid storage tank can maintain a low temperature, so that the first liquid storage tank has a good cold storage capability. Further, when the charging connector in the charging pile charges the electric vehicle, the coolant with the low temperature stored in the first liquid storage tank may quickly flow into the electric vehicle and the liquid cooling cable connected to the currently operating charging connector, to improve timeliness and cooling effect of performing heat dissipation by the thermal management system on the power battery and the liquid cooling cable.

In a possible implementation, the charging pile is configured to: when a charging connector in the one or more groups of charging connectors transmits electric energy to the electric vehicle, control the first three-way valve to connect the path between the first liquid inlet connector and the liquid inlet of the first coolant path, and disconnect the path between the third liquid outlet of the first liquid storage tank and the liquid inlet of the first coolant path.

In the foregoing technical solution, when at least one group of connectors in the charging pile charges the electric vehicle, the first heat exchanger may perform heat exchange with only the coolant in the electric vehicle by adjusting on/off states of different valve ports of the first three-way valve. This helps ensure heat dissipation effect of the thermal management system on the power battery.

In a possible implementation, the charging pile further includes one first water pump and one second water pump. The first water pump is connected between the first liquid outlet of the first liquid storage tank and the first liquid outlet connector. The second water pump is connected between the second liquid outlet of the first liquid storage tank and the liquid inlet of the liquid cooling cable connected to each group of charging connectors, or the second water pump is connected between the second liquid inlet of the first liquid storage tank and the liquid outlet of the liquid cooling cable connected to each group of charging connectors, or the second water pump is connected between the liquid inlet of the first coolant path and the liquid outlet of the liquid cooling cable connected to each group of charging connectors.

In the foregoing technical solution, the coolant in the first liquid storage tank can be driven, via two water pumps, to separately flow into the electric vehicle and the liquid cooling cable connected to each group of charging connectors. In this way, the thermal management system can dissipate heat from the power battery of the electric vehicle and the liquid cooling cable, and a small quantity of water pumps can be disposed in the charging pile. In this way, complexity of a pipe connection in the charging pile can be reduced, an increase in costs of the charging pile can be reduced, and cost optimization of the charging pile can be facilitated.

In a possible implementation, the charging pile further includes a liquid cooling device and a charging device, the thermal management system is located in the liquid cooling device, and each group of charging connectors is located in the charging device. The liquid cooling device further includes one second liquid outlet connector and one second liquid inlet connector. The second liquid outlet connector is connected to the second liquid outlet of the first liquid storage tank, and the second liquid inlet connector is connected to the second liquid inlet of the first liquid storage tank, or the second liquid inlet connector is connected to the liquid inlet of the first coolant path. The charging device includes one first liquid injection port and one first liquid return port. The first liquid injection port is connected to the liquid inlet of the liquid cooling cable connected to each group of charging connectors, and the first liquid return port is connected to the liquid outlet of the liquid cooling cable connected to each group of charging connectors. The first liquid injection port is further connected to the second liquid outlet connector, and the first liquid return port is further connected to the second liquid inlet connector. The second water pump is located in the liquid cooling device, or the second water pump is located in the charging device. When the second water pump is located in the liquid cooling device, the second water pump is connected between the second liquid outlet of the first liquid storage tank and the second liquid outlet connector, or the second water pump is connected between the second liquid inlet of the first liquid storage tank and the second liquid inlet connector, or the second water pump is connected between the liquid inlet of the first coolant path and the second liquid inlet connector. When the second water pump is located in the charging device, the second water pump is connected between the first liquid injection port and the liquid inlet of the liquid cooling cable connected to each group of charging connectors, or the second water pump is connected between the first liquid return port and the liquid outlet of the liquid cooling cable connected to each group of charging connectors.

In the foregoing technical solution, when the charging pile includes one second water pump, the thermal management system located in the liquid cooling device is connected, via the first water pump, to the liquid cooling cable connected to each group of charging connectors located in the charging device through a coordinated connection between a group of connectors disposed in the liquid cooling device and a group of interfaces disposed in the charging device. This can reduce complexity of a pipe connection between the liquid cooling device and the charging device, and facilitate cost optimization of the charging pile.

In addition, during actual application, the first water pump configured to drive the first liquid storage tank to provide coolant for the electric vehicle and the second water pump configured to drive the first liquid storage tank to provide coolant for the liquid cooling cable may be disposed in the liquid cooling device together. This facilitates an integrated design of the liquid cooling device. Alternatively, the first water pump may be disposed in the liquid cooling device, and the second water pump may be disposed in the charging device, so that the first water pump and the second water pump are decoupled. This can reduce mutual impact of a performance difference between the first water pump and the second water pump, and reduce logic complexity of performing flow distribution and abnormal working condition protection by the charging pile on the first water pump and the second water pump.

In a possible implementation, the charging pile further includes one first water pump and a plurality of second water pumps, and the one or more groups of charging connectors include a plurality of groups of charging connectors. The first water pump is connected between the first liquid outlet of the first liquid storage tank and the first liquid outlet connector. The plurality of second water pumps are in a one-to-one correspondence with liquid cooling cables connected to the plurality of groups of charging connectors. Each of the plurality of second water pumps is connected between the second liquid outlet of the first liquid storage tank and a liquid inlet of a corresponding liquid cooling cable, or each second water pump is connected between the second liquid inlet of the first liquid storage tank and a liquid outlet of a corresponding liquid cooling cable, or each second water pump is connected between the liquid inlet of the first coolant path and a liquid outlet of a corresponding liquid cooling cable.

In the foregoing technical solution, the first water pump and the plurality of second water pumps may drive the coolant in the first liquid storage tank to separately flow to the electric vehicle and the liquid cooling cable connected to each group of charging connectors, so that the thermal management system can dissipate heat from the power battery of the electric vehicle and the liquid cooling cable. In addition, second water pumps connected to all the groups of charging connectors are different, that is, the thermal management system performs, via different second water pumps, heat dissipation on the liquid cooling cables connected to all the groups of charging connectors. Therefore, when any second water pump is faulty, heat dissipation performed by the thermal management system on a liquid cooling cable connected to another second water pump may not be affected. Further, reliability of heat dissipation performed by the thermal management system on the liquid cooling cables connected to the plurality of groups of charging connectors in the charging pile can be improved.

In a possible implementation, the charging pile further includes a liquid cooling device and a charging device, the thermal management system is located in the liquid cooling device, and each group of charging connectors is located in the charging device. The liquid cooling device includes a plurality of second liquid outlet connectors and a plurality of second liquid inlet connectors. Each of the plurality of second liquid outlet connectors is connected to the second liquid outlet of the first liquid storage tank, and each of the plurality of second liquid inlet connectors is connected to the second liquid inlet of the first liquid storage tank, or each second liquid inlet connector is connected to the liquid inlet of the first coolant path. The charging device includes a plurality of first liquid injection ports and a plurality of first liquid return ports. The plurality of first liquid injection ports are connected, in a one-to-one correspondence, to liquid inlets of the liquid cooling cables connected to the plurality of groups of charging connectors, and the plurality of first liquid return ports are connected, in a one-to-one correspondence, to liquid outlets of the liquid cooling cables connected to the plurality of groups of charging connectors. The plurality of first liquid injection ports are further connected to the plurality of second liquid outlet connectors in a one-to-one correspondence, and the plurality of first liquid return ports are further connected to the plurality of second liquid inlet connectors in a one-to-one correspondence. Each second water pump is located in the liquid cooling device, or each second water pump is located in the charging device. When each second water pump is located in the liquid cooling device, each second water pump is connected between the second liquid outlet of the first liquid storage tank and a second liquid outlet connector connected to the corresponding liquid cooling cable, or each second water pump is connected between the second liquid inlet of the first liquid storage tank and a second liquid inlet connector connected to the corresponding liquid cooling cable, or each second water pump is connected between the liquid inlet of the first coolant path and a second liquid inlet connector connected to the corresponding liquid cooling cable. When each second water pump is located in the charging device, each second water pump is connected between the liquid inlet of the corresponding liquid cooling cable and a first liquid injection port connected to the corresponding liquid cooling cable, or each second water pump is connected between the liquid outlet of the corresponding liquid cooling cable and a first liquid return port connected to the corresponding liquid cooling cable.

In the foregoing technical solution, when the charging pile includes a plurality of second water pumps and a plurality of groups of charging connectors, each second water pump located in the liquid cooling device is connected, through an independent pipe, to a liquid cooling cable connected to a corresponding charging connector located in the charging device, or each second water pump located in the charging device is connected to the thermal management system located in the liquid cooling device through an independent pipe. This can avoid mutual impact between connection pipes in which different second water pumps are located. Further, reliability of heat dissipation performed by the thermal management system on the liquid cooling cables connected to the plurality of groups of charging connectors in the charging pile can be improved.

In addition, during actual application, the first water pump configured to drive the first liquid storage tank to provide coolant for the electric vehicle and the plurality of second water pumps configured to drive the first liquid storage tank to provide coolant for the liquid cooling cable may be disposed in the liquid cooling device together. This facilitates an integrated design of the liquid cooling device. Alternatively, the first water pump may be disposed in the liquid cooling device, and the plurality of second water pumps may be disposed in the charging device, so that the first water pump and the plurality of second water pumps are decoupled. This can reduce mutual impact of a performance difference between the first water pump and the second water pump, and reduce logic complexity of performing flow distribution and abnormal working condition protection by the charging pile on the first water pump and the second water pump.

In a possible implementation, the charging pile further includes a plurality of charging modules, a switch, and a third heat exchanger, and the liquid cooling cable connected to each group of charging connectors is connected to output ends of the plurality of charging modules via the switch. The third heat exchanger includes a first gas path and a second coolant path, and the second coolant path is used to exchange heat with the first gas path. An inlet of the first gas path and an outlet of the first gas path are connected to an environment in which the switch is located. A liquid inlet of the second coolant path is connected to the second liquid outlet of the first liquid storage tank. A liquid outlet of the second coolant path is connected to the liquid inlet of the first coolant path, or a liquid outlet of the second coolant path is connected to the second liquid inlet of the first liquid storage tank.

Based on the foregoing design, in addition to being configured to dissipate heat from the power battery of the electric vehicle and the liquid cooling cable connected to the charging connector, the thermal management system may be further configured to dissipate heat from the switch that is in a power distribution cabin and that is connected between the charging module and a charger. This can further improve utilization of the thermal management system, and further facilitate cost optimization of the charging pile.

In a possible implementation, the thermal management system further includes an expansion tank, and a liquid inlet of the expansion tank is connected between the liquid outlet of the first coolant path and the first liquid inlet of the first liquid storage tank. Based on the foregoing design, coolant that passes through the first coolant path to the first liquid storage tank may flow into the expansion tank, so that the expansion tank has a pressure relief function. This improves operation reliability of the thermal management system.

In a possible implementation, when a temperature of an environment in which the thermal management system is located is lower than a preset temperature, the first compressor is in an off state, and the first coolant path is used to perform heat exchange with gas in the environment in which the thermal management system is located. In this way, energy consumption of the thermal management system can be reduced.

In a possible implementation, the thermal management system further includes a second compressor, a second expansion valve, and a fourth heat exchanger. The second compressor, the first heat exchanger, the second expansion valve, and the fourth heat exchanger are sequentially connected. The first heat exchanger further includes a second refrigerant path. The second refrigerant path is connected between the second compressor and the second expansion valve. The second refrigerant path is used to exchange heat with the first coolant path.

Based on the foregoing design, both the two refrigerant paths in the first heat exchanger are used to exchange heat with the first coolant path. This can improve heat dissipation efficiency of the coolant in the first coolant path. Further, heat dissipation efficiency of the thermal management system for the power battery of the electric vehicle and the liquid cooling cable connected to each group of charging connectors can be improved.

According to a second aspect, a charging pile is provided. The charging pile includes one or more groups of charging connectors, one or more fifth heat exchangers, a thermal management system, a first liquid outlet connector, and a first liquid inlet connector. Each of the one or more groups of charging connectors is configured to output electric energy to an electric vehicle, the first liquid outlet connector is configured to connect to a liquid injection port of the electric vehicle, and the first liquid inlet connector is configured to connect to a liquid return port of the electric vehicle. The thermal management system includes a first compressor, a first heat exchanger, a first expansion valve, and a second heat exchanger that are sequentially connected. The first heat exchanger includes a first refrigerant path and a first coolant path. The first refrigerant path is connected between the first compressor and the first expansion valve, and the first refrigerant path is used to exchange heat with the first coolant path. A liquid outlet of the first coolant path is connected to the first liquid outlet connector, and a liquid inlet of the first coolant path is connected to the first liquid inlet connector. Each of the one or more fifth heat exchangers includes a third coolant path and a fourth coolant path. A liquid inlet of the third coolant path is connected to the liquid outlet of the first coolant path, and the third coolant path is used to exchange heat with the fourth coolant path. A liquid outlet of the fourth coolant path of each fifth heat exchanger is connected to a liquid inlet of a liquid cooling cable connected to at least one of the one or more groups of charging connectors, and a liquid inlet of the fourth coolant path of each fifth heat exchanger is connected to a liquid outlet of the liquid cooling cable connected to the at least one group of charging connectors.

In the charging pile provided in this embodiment of this application, the first coolant path of the first heat exchanger in the thermal management system may form a coolant circulation loop with the electric vehicle via the first liquid outlet connector and the first liquid inlet connector, so that coolant circulates between the first coolant path and the electric vehicle, and the thermal management system can dissipate heat from a power battery of the electric vehicle. In addition, the first coolant path of the first heat exchanger may further provide coolant to the third coolant path of the fifth heat exchanger, and coolant in the liquid cooling cable connected to the charging connector may circulate in the fourth coolant path of the fifth heat exchanger, so that the thermal management system can dissipate heat from the liquid cooling cable via the fifth heat exchanger.

Therefore, the thermal management system may be configured to dissipate heat from both the power battery of the electric vehicle and the liquid cooling cable connected to the charging connector. This can meet heat dissipation requirements of both the liquid cooling cable and the power battery during high-power charging, and improve efficiency and safety of charging the electric vehicle by the charging pile, thereby ensuring normal high-power charging of the electric vehicle. In addition, because the power battery and the liquid cooling cable share the thermal management system for heat dissipation, the thermal management system has high utilization, and cost optimization of the charging pile is facilitated. In addition, because coolant in the thermal management system and coolant in the liquid cooling cable flow in different paths of the fifth heat exchanger, doping of the coolant in the thermal management system and the coolant in the liquid cooling cable can be avoided. This helps improve cleanliness of the coolant in the thermal management system and the coolant in the liquid cooling cable.

In a possible implementation, the thermal management system further includes a first liquid storage tank, and the liquid outlet of the first coolant path is connected to the first liquid outlet connector and the liquid inlet of the third coolant path via the first liquid storage tank. A first liquid inlet of the first liquid storage tank is connected to the liquid outlet of the first cooling path, a first liquid outlet of the first liquid storage tank is connected to the first liquid outlet connector, and a second liquid outlet of the first liquid storage tank is connected to the liquid inlet of the third coolant path.

In a possible implementation, a liquid outlet of the third coolant path is connected to the liquid inlet of the first coolant path, or a liquid outlet of the third coolant path is connected to a second liquid inlet of the first liquid storage tank.

In a possible implementation, a third liquid outlet of the first liquid storage tank is connected to the liquid inlet of the first coolant path.

In a possible implementation, the thermal management system further includes a first three-way valve. A first valve port of the first three-way valve is connected to the first liquid inlet connector, a second valve port of the first three-way valve is connected to the third liquid outlet of the first liquid storage tank, and a third valve port of the first three-way valve is connected to the liquid inlet of the first coolant path.

In a possible implementation, the charging pile is configured to: when each group of charging connectors does not transmit the electric energy to the electric vehicle, control the first three-way valve to connect a path between the third liquid outlet of the first liquid storage tank and the liquid inlet of the first coolant path, and disconnect a path between the first liquid inlet connector and the liquid inlet of the first coolant path.

In a possible implementation, the charging pile is configured to: when a charging connector in the one or more groups of charging connectors transmits electric energy to the electric vehicle, control the first three-way valve to connect the path between the first liquid inlet connector and the liquid inlet of the first coolant path, and disconnect the path between the third liquid outlet of the first liquid storage tank and the liquid inlet of the first coolant path.

In a possible implementation, the charging pile further includes a first water pump and one or more second water pumps. The first water pump is connected between the first liquid outlet of the first liquid storage tank and the first liquid outlet connector. The one or more second water pumps are in a one-to-one correspondence with the one or more fifth heat exchangers. Each of the one or more second water pumps is connected between the second liquid outlet of the first liquid storage tank and a liquid inlet of a third coolant path of a corresponding fifth heat exchanger, or each second water pump is connected between the second liquid inlet of the first liquid storage tank and a liquid outlet of a third coolant path of a corresponding fifth heat exchanger, or each second water pump is connected between the liquid inlet of the first coolant path and a liquid outlet of a third coolant path of a corresponding fifth heat exchanger.

In the foregoing technical solution, the first water pump and the plurality of second water pumps may drive coolant in the first liquid storage tank to separately flow to the electric vehicle and the third coolant path of each fifth heat exchanger, so that the thermal management system can dissipate heat from the power battery of the electric vehicle and the liquid cooling cable. In addition, the thermal management system is connected to all the fifth heat exchangers via different second water pumps. Therefore, when any second water pump is faulty, the thermal management system may not be affected in providing coolant to a fifth heat exchanger connected to another second water pump. Further, reliability of heat dissipation performed by the thermal management system on liquid cooling cables connected to the plurality of groups of charging connectors in the charging pile can be improved.

In a possible implementation, when the one or more fifth heat exchangers include one fifth heat exchanger, a liquid outlet of a fourth coolant path of the fifth heat exchanger is connected to a liquid inlet of a liquid cooling cable connected to each group of charging connectors, and a liquid inlet of the fourth coolant path of the fifth heat exchanger is connected to a liquid outlet of the liquid cooling cable connected to each group of charging connectors. Alternatively, when the one or more fifth heat exchangers include a plurality of fifth heat exchangers, and the one or more groups of charging connectors include a plurality of groups of charging connectors, the plurality of fifth heat exchangers are in a one-to-one correspondence with liquid cooling cables connected to the plurality of groups of charging connectors, the liquid outlet of the fourth coolant path of each of the plurality of fifth heat exchangers is connected to a liquid inlet of a corresponding liquid cooling cable, and the liquid inlet of the fourth coolant path of each of the plurality of fifth heat exchangers is connected to a liquid outlet of the corresponding liquid cooling cable.

In the foregoing technical solution, the thermal management system may perform, via one fifth heat exchanger, heat dissipation on the liquid cooling cable connected to each group of charging connectors. In this way, the thermal management system can dissipate heat from the liquid cooling cable connected to each group of charging connectors, and a small quantity of fifth heat exchangers may be disposed in the charging pile. In this way, complexity of a pipe connection in the charging pile can be reduced, and an increase in costs of the charging pile can be reduced.

Alternatively, the thermal management system may perform, via different fifth heat exchangers, heat dissipation on the liquid cooling cables connected to all the groups of charging connectors. This can avoid a case in which heat dissipation performed by the thermal management system on the liquid cooling cables connected to the plurality of groups of charging connectors is affected because one fifth heat exchanger is faulty. Further, reliability of heat dissipation performed by the thermal management system on the liquid cooling cables connected to the plurality of groups of charging connectors can be improved.

In a possible implementation, the one or more fifth heat exchangers include one fifth heat exchanger, the charging pile further includes a liquid cooling device and a charging device, the thermal management system is located in the liquid cooling device, and each group of charging connectors is located in the charging device. The fifth heat exchanger and each second water pump are located in the liquid cooling device, the liquid cooling device includes one second liquid outlet connector and one second liquid inlet connector, and the charging device includes one first liquid injection port and one first liquid return port. The liquid outlet of the fourth coolant path of the fifth heat exchanger is connected to the second liquid outlet connector, and the liquid inlet of the fourth coolant path of the fifth heat exchanger is connected to the second liquid inlet connector. The second liquid outlet connector is further connected to the first liquid injection port, and the second liquid inlet connector is further connected to the first liquid return port. The first liquid injection port is connected to the liquid inlet of the liquid cooling cable connected to each group of charging connectors, and the first liquid return port is connected to the liquid outlet of the liquid cooling cable connected to each group of charging connectors.

In the foregoing technical solution, when the charging pile includes one fifth heat exchanger, the fifth heat exchanger located in the liquid cooling device is connected to the liquid cooling cable connected to each group of charging connectors in the charging device through a coordinated connection between a group of connectors in the liquid cooling device and a group of interfaces in the charging device. This can reduce complexity of a pipe connection between the liquid cooling device and the charging device, and facilitate cost optimization of the charging pile. In addition, during actual application, the fifth heat exchanger and a corresponding second water pump may be disposed in the liquid cooling device. This facilitates an integrated design of the liquid cooling device.

In a possible implementation, the one or more fifth heat exchangers include one fifth heat exchanger, the charging pile further includes a liquid cooling device and a charging device, the thermal management system is located in the liquid cooling device, and each group of charging connectors is located in the charging device. The fifth heat exchanger is located in the charging device, the liquid cooling device includes one second liquid outlet connector and one second liquid inlet connector, and the charging device includes one first liquid injection port and one first liquid return port. The second liquid outlet connector is connected to the second liquid outlet of the first liquid storage tank. The second liquid inlet connector is connected to the second liquid inlet of the first liquid storage tank, or the second liquid inlet connector is connected to the liquid inlet of the first coolant path. The second liquid outlet connector is further connected to the first liquid injection port, and the second liquid inlet connector is further connected to the first liquid return port. A liquid inlet of a third coolant path of the fifth heat exchanger is connected to the first liquid injection port, and a liquid outlet of the third coolant path of the fifth heat exchanger is connected to the first liquid return port.

In the foregoing technical solution, when the charging pile includes one fifth heat exchanger, the fifth heat exchanger located in the charging device is connected to the thermal management system in the liquid cooling device through a coordinated connection between a group of connectors in the liquid cooling device and a group of interfaces in the charging device. This can reduce complexity of a pipe connection between the liquid cooling device and the charging device, and facilitate cost optimization of the charging pile.

In a possible implementation, the one or more fifth heat exchangers include a plurality of fifth heat exchangers, the charging pile further includes a liquid cooling device and a charging device, the thermal management system is located in the liquid cooling device, and each group of charging connectors is located in the charging device. The plurality of fifth heat exchangers and each second water pump are located in the liquid cooling device. The liquid cooling device includes a plurality of second liquid outlet connectors and a plurality of second liquid inlet connectors. The charging device includes a plurality of first liquid injection ports and a plurality of first liquid return ports. Liquid outlets of fourth coolant paths of the plurality of fifth heat exchangers are connected to the plurality of second liquid outlet connectors in a one-to-one correspondence, and liquid inlets of the fourth coolant paths of the plurality of fifth heat exchangers are connected to the plurality of second liquid inlet connectors in a one-to-one correspondence. The plurality of second liquid outlet connectors are further connected to the plurality of first liquid injection ports in a one-to-one correspondence, and the plurality of second liquid inlet connectors are further connected to the plurality of first liquid return ports in a one-to-one correspondence. The plurality of first liquid injection ports are connected, in a one-to-one correspondence, to liquid inlets of the liquid cooling cables connected to the plurality of groups of charging connectors, and the plurality of first liquid return ports are connected, in a one-to-one correspondence, to liquid outlets of the liquid cooling cables connected to the plurality of groups of charging connectors.

In the foregoing technical solution, when the charging pile includes a plurality of fifth heat exchangers, each fifth heat exchanger located in the liquid cooling device is connected, through an independent pipe, to a liquid cooling cable connected to a corresponding charging connector located in the charging device. This can avoid mutual impact between different fifth heat exchangers and connection pipes of corresponding liquid cooling cables. Further, reliability of heat dissipation performed by the thermal management system on the liquid cooling cables connected to the plurality of groups of charging connectors in the charging pile can be improved. In addition, the plurality of fifth heat exchangers and a plurality of corresponding second water pumps are disposed in the liquid cooling device. This further facilitates an integrated design of the liquid cooling device.

In a possible implementation, the one or more fifth heat exchangers include a plurality of fifth heat exchangers, the charging pile further includes a liquid cooling device and a charging device, the thermal management system is located in the liquid cooling device, and each group of charging connectors is located in the charging device. The plurality of fifth heat exchangers are located in the charging device, the liquid cooling device includes a plurality of second liquid outlet connectors and a plurality of second liquid inlet connectors, and the charging device includes a plurality of first liquid injection ports and a plurality of first liquid return ports. Each second liquid outlet connector is connected to the second liquid outlet of the first liquid storage tank. Each second liquid inlet connector is connected to the second liquid inlet of the first liquid storage tank, or each second liquid inlet connector is connected to the liquid inlet of the first coolant path. The plurality of second liquid outlet connectors are further connected to the plurality of first liquid injection ports in a one-to-one correspondence, and the plurality of second liquid inlet connectors are further connected to the plurality of first liquid return ports in a one-to-one correspondence. Liquid inlets of third coolant paths of the plurality of fifth heat exchangers are connected to the plurality of first liquid injection ports in a one-to-one correspondence, and liquid outlets of the third coolant paths of the plurality of fifth heat exchangers are connected to the plurality of first liquid return ports in a one-to-one correspondence.

In the foregoing technical solution, when the charging pile includes the plurality of fifth heat exchangers, each fifth heat exchanger located in the charging device is connected to the thermal management system located in the liquid cooling device through an independent pipe. This can avoid mutual impact between connection pipes between different fifth heat exchangers and the thermal management system. Further, reliability of heat dissipation performed by the thermal management system on the liquid cooling cables connected to the plurality of groups of charging connectors in the charging pile can be improved.

In a possible implementation, each second water pump is located in the liquid cooling device, or each second water pump is located in the charging device. When each second water pump is located in the liquid cooling device, each second water pump is connected between the second liquid outlet of the first liquid storage tank and a second liquid outlet connector connected to the corresponding fifth heat exchanger, or each second water pump is connected between the second liquid inlet of the first liquid storage tank and a second liquid inlet connector connected to the corresponding fifth heat exchanger, or each second water pump is connected between the liquid inlet of the first coolant path and a second liquid inlet connector connected to the corresponding fifth heat exchanger. When each second water pump is located in the charging device, each second water pump is connected between the liquid inlet of the third coolant path of the corresponding fifth heat exchanger and a first liquid injection port connected to the corresponding fifth heat exchanger, or each second water pump is connected between the liquid outlet of the third coolant path of the corresponding fifth heat exchanger and a first liquid return port connected to the corresponding fifth heat exchanger.

In the foregoing technical solution, when the fifth heat exchanger in the charging pile is disposed in the charging device, the second water pump corresponding to the fifth heat exchanger may be disposed in the liquid cooling device, or may be disposed in the charging device. This helps improve flexibility of disposing the second water pump.

In a possible implementation, the liquid cooling cable connected to each group of charging connectors includes a plurality of fifth coolant paths, and the plurality of fifth coolant paths are connected to a fourth coolant path of a same fifth heat exchanger. A liquid inlet of each fifth coolant path is connected to a liquid outlet of the fourth coolant path of the same fifth heat exchanger, and a liquid outlet of each fifth coolant path is connected to a liquid inlet of the fourth coolant path of the same fifth heat exchanger.

In the foregoing technical solution, coolant may circulate between the fourth coolant path of the same fifth heat exchanger and the plurality of fifth coolant paths of the liquid cooling cable, so that the plurality of fifth coolant paths can be used to dissipate heat from a positive charging cable and a negative charging cable in the liquid cooling cable, to improve heat dissipation efficiency of the liquid cooling cable. In addition, because all the fifth coolant paths are independently connected to the same fifth heat exchanger, mutual impact between the plurality of fifth coolant paths can be avoided. This improves heat dissipation reliability of the liquid cooling cable.

In a possible implementation, the charging pile further includes one or more second liquid storage tanks. The one or more second liquid storage tanks are in a one-to-one correspondence with the one or more fifth heat exchangers, a liquid inlet of each second liquid storage tank is connected to a liquid outlet of a fourth coolant path of the corresponding fifth heat exchanger, and a liquid outlet of each second liquid storage tank is connected to a liquid inlet of a liquid cooling cable connected to the corresponding fifth heat exchanger.

In the foregoing technical solution, one second liquid storage tank is disposed between the liquid outlet of the fourth coolant path in each fifth heat exchanger and the liquid inlet of the liquid cooling cable, so that the cooled coolant in the fourth coolant path can flow into the second liquid storage tank in advance for storage. When the liquid cooling cable connected to the charging connector needs to be cooled, the coolant whose temperature decreases and that is stored in the second liquid storage tank may quickly flow into the liquid cooling cable. This helps improve timeliness of performing heat dissipation on the liquid cooling cable by the thermal management system.

In a possible implementation, the charging pile further includes a third water pump. The third water pump is connected between the liquid outlet of each second liquid storage tank and a liquid inlet of a liquid cooling cable connected to the second liquid storage tank, or the third water pump is connected between the liquid inlet of the fourth coolant path of each fifth heat exchanger and a liquid outlet of the liquid cooling cable connected to the fifth heat exchanger. Therefore, the third water pump may be configured to drive the coolant in the second liquid storage tank to flow into the third coolant path of the fifth heat exchanger, so that the thermal management system is configured to dissipate heat from the liquid cooling cable.

In a possible implementation, the charging pile further includes a plurality of charging modules, a switch, and a third heat exchanger, and the liquid cooling cable connected to each group of charging connectors is connected to output ends of the plurality of charging modules via the switch. The third heat exchanger includes a first gas path and a second coolant path, and the second coolant path is used to exchange heat with the first gas path. An inlet of the first gas path and an outlet of the first gas path are connected to an environment in which the switch is located. A liquid inlet of the second coolant path is connected to the second liquid outlet of the first liquid storage tank. A liquid outlet of the second coolant path is connected to the liquid inlet of the first coolant path, or a liquid outlet of the second coolant path is connected to the second liquid inlet of the first liquid storage tank.

In a possible implementation, the thermal management system further includes an expansion tank, and a liquid inlet of the expansion tank is connected between the liquid outlet of the first coolant path and the first liquid inlet of the first liquid storage tank.

In a possible implementation, when a temperature of an environment in which the thermal management system is located is lower than a preset temperature, the first compressor is in an off state, and the first coolant path is used to perform heat exchange with gas in the environment in which the thermal management system is located.

In a possible implementation, the thermal management system further includes a second compressor, a second expansion valve, and a fourth heat exchanger. The second compressor, the first heat exchanger, the second expansion valve, and the fourth heat exchanger are sequentially connected. The first heat exchanger further includes a second refrigerant path, the second refrigerant path is connected between the second compressor and the second expansion valve, and the second refrigerant path is used to exchange heat with the first coolant path.

According to a third aspect, a charging device is provided. The charging device includes one or more groups of charging connectors, one or more first liquid injection ports, and one or more first liquid return ports. Each group of charging connectors is configured to output electric energy to an electric vehicle, each first liquid injection port is configured to connect to a liquid outlet connector of a liquid cooling device, and each first liquid return port is configured to connect to a liquid inlet connector of the liquid cooling device. The one or more first liquid injection ports are in a one-to-one correspondence with the one or more first liquid return ports, each first liquid injection port is connected to a liquid inlet of a liquid cooling cable connected to at least one of one or more groups of charging connectors, and each first liquid return port is connected to a liquid outlet of the liquid cooling cable connected to the at least one group of charging connectors.

In the foregoing technical solution, a liquid cooling cable connected to each group of charging connectors in the charging device can form a coolant circulation loop with the external liquid cooling device through the first liquid injection port and the first liquid return port, so that coolant can circulate between the liquid cooling cable and the liquid cooling device, and the liquid cooling device can dissipate heat from the liquid cooling cable. This can meet a heat dissipation requirement of the liquid cooling cable when the charging device charges the electric vehicle at high power, improve efficiency and safety of charging the electric vehicle by the charging device, and ensure normal high-power charging of the electric vehicle.

In a possible implementation, when the one or more first liquid injection ports include one first liquid injection port, and the one or more first liquid return ports include one first liquid return port, the first liquid injection port is connected to a liquid inlet of the liquid cooling cable connected to each group of charging connectors, and the first liquid return port is connected to a liquid outlet of the liquid cooling cable connected to each charging connector. Alternatively, when the one or more first liquid injection ports include a plurality of first liquid injection ports, the one or more first liquid return ports include a plurality of first liquid return ports, and the one or more groups of charging connectors include a plurality of groups of charging connectors, the plurality of first liquid injection ports are connected, in a one-to-one correspondence, to liquid inlets of liquid cooling cables connected to the plurality of groups of charging connectors, and the plurality of first liquid return ports are connected, in a one-to-one correspondence, to liquid outlets of the liquid cooling cables connected to the plurality of groups of charging connectors.

In the foregoing technical solution, the liquid cooling cable connected to each group of charging connectors in the charging device may form a coolant circulation loop with the liquid cooling device through a group of interfaces. This can reduce complexity of a pipe connection between the charging device and the liquid cooling device, and facilitate cost optimization of the charging device.

Alternatively, the liquid cooling cables connected to all the groups of charging connectors in the charging device form coolant circulation loops with the liquid cooling device through different groups of interfaces. This can avoid mutual impact between coolant pipes connected to different liquid cooling cables in the charging device. Further, reliability of heat dissipation performed by the liquid cooling device on the liquid cooling cable connected to each group of charging connectors in the charging device can be improved.

In a possible implementation, the one or more first liquid injection ports include one first liquid injection port, the one or more first liquid return ports include one first liquid return port, and the charging device further includes one second water pump. The second water pump is connected between the first liquid injection port and the liquid inlet of the liquid cooling cable connected to each group of charging connectors, or the second water pump is connected between the first liquid return port and the liquid outlet of the liquid cooling cable connected to each group of charging connectors.

In the foregoing technical solution, the second water pump may be used to drive coolant in the liquid cooling device to flow to the liquid cooling cable connected to each group of charging connectors, so that the liquid cooling device is configured to dissipate heat from the liquid cooling cable connected to each group of charging connectors. In addition, disposing a small quantity of second water pumps can further reduce complexity of a pipe connection in the charging device, thereby helping optimize costs of the charging device.

In a possible implementation, the one or more first liquid injection ports include a plurality of first liquid injection ports, the one or more first liquid return ports include a plurality of first liquid return ports, and the charging device further includes a plurality of second water pumps. The plurality of second water pumps are respectively in a one-to-one correspondence with the plurality of first liquid injection ports and the liquid cooling cables connected to the plurality of groups of charging connectors, and each second water pump is connected between a corresponding first liquid injection port and a liquid inlet of a corresponding liquid cooling cable, or each second water pump is connected between a corresponding first liquid return port and a liquid outlet of a corresponding liquid cooling cable.

In the foregoing technical solution, the plurality of second water pumps may drive coolant in the liquid cooling device to flow to liquid cooling cables connected to different charging connectors, so that the liquid cooling device is configured to dissipate heat from the liquid cooling cables connected to each group of charging connectors. In addition, the groups of charging connectors are connected to different second water pumps. Therefore, heat dissipation performed by the liquid cooling device on a liquid cooling cable connected to another water pump may not be affected when a second water pump is faulty, so that reliability of heat dissipation performed by the liquid cooling device on the liquid cooling cables connected to the plurality of groups of charging connectors can be improved.

In a possible implementation, the charging device further includes a plurality of charging modules, a switch, and a third heat exchanger, and the liquid cooling cable connected to each group of charging connectors is connected to output ends of the plurality of charging modules via the switch. The third heat exchanger includes a first gas path and a second coolant path, and the second coolant path is used to exchange heat with the first gas path. A liquid inlet of the second coolant path is used to connect to the liquid outlet connector of the liquid cooling device, and a liquid outlet of the second coolant path is used to connect to the liquid inlet connector of the liquid cooling device.

In the foregoing technical solution, a coolant circulation loop may also be formed between the third heat exchanger in the charging device and the liquid cooling device, so that the coolant circulates between the third heat exchanger and the liquid cooling device. In this way, the liquid cooling device dissipates heat from the switch that is located in a power distribution cabin and that is connected between the charging module and a charger. This can meet a heat dissipation requirement of the switch when the charging device charges the electric vehicle at high power, improve efficiency and safety of charging the electric vehicle by the charging device, and ensure normal high-power charging of the electric vehicle.

In a possible implementation, the liquid inlet of the second coolant path is connected to the first liquid injection port, and the liquid outlet of the second coolant path is connected to the first liquid return port. Alternatively, the charging device further includes a second liquid injection port and a second liquid return port. The second liquid injection port is configured to connect to the liquid outlet connector of the liquid cooling device, the second liquid return port is configured to connect to the liquid inlet connector of the liquid cooling device, the liquid inlet of the second coolant path is connected to the second liquid injection port, and the liquid outlet of the second coolant path is connected to the second liquid return port.

In the foregoing technical solution, the third heat exchanger and the liquid cooling cable connected to the charging connector share a group of interfaces to connect to the liquid cooling device. This can reduce complexity of a pipe connection between the charging device and the liquid cooling device, and facilitate cost optimization of the charging device. Alternatively, the third heat exchanger may be connected to the liquid cooling device through a group of interfaces separately disposed in the charging device. This can avoid mutual impact between a coolant pipe connected to the liquid cooling cable and a coolant pipe connected to the third heat exchanger in the charging device. Further, reliability of heat dissipation performed by the liquid cooling device on the liquid cooling cable and the switch in the power distribution cabin can be improved.

According to a fourth aspect, a charging device is provided. The charging device includes one or more groups of charging connectors, one or more fifth heat exchangers, one or more first liquid injection ports, and one or more first liquid return ports. Each group of charging connectors is configured to output electric energy to an electric vehicle, each first liquid injection port is configured to connect to a liquid outlet connector of a liquid cooling device, and each first liquid return port is configured to connect to a liquid inlet connector of the liquid cooling device. Each fifth heat exchanger includes a third coolant path and a fourth coolant path, and the third coolant path is used to exchange heat with the fourth coolant path. The one or more first liquid injection ports are in a one-to-one correspondence with the one or more first liquid return ports, each first liquid injection port is connected to a liquid inlet of a third coolant path of at least one of the one or more fifth heat exchangers, and each first liquid return port is connected to a liquid outlet of the third coolant path of the at least one fifth heat exchanger. A liquid outlet of the fourth coolant path of each fifth heat exchanger is connected to a liquid inlet of a liquid cooling cable connected to at least one of the one or more groups of charging connectors, and a liquid inlet of the fourth coolant path of each fifth heat exchanger is connected to a liquid outlet of the liquid cooling cable connected to the at least one group of charging connectors.

In the foregoing technical solution, the third coolant path of each fifth heat exchanger in the charging device may form a coolant circulation loop with the external liquid cooling device through the first liquid injection port and the first liquid return port, and the fourth coolant path of each fifth heat exchanger and the liquid cooling cable connected to the charging connector form a coolant circulation loop. Therefore, the liquid cooling device may dissipate heat from the liquid cooling cable via the fifth heat exchanger. This can meet a heat dissipation requirement of the liquid cooling cable when the charging device charges the electric vehicle at high power, improve efficiency and safety of charging the electric vehicle by the charging device, and ensure normal high-power charging of the electric vehicle. In addition, because coolant in the liquid cooling device and coolant in the liquid cooling cable flow through different channels of the fifth heat exchanger, doping between the coolant in the liquid cooling device and the coolant in the liquid cooling cable can be avoided. This improves cleanliness of the coolant in the liquid cooling cable.

In a possible implementation, the one or more first liquid injection ports include one liquid injection port, the one or more first liquid return ports include one liquid return port, and the one or more fifth heat exchangers include one fifth heat exchanger. A liquid inlet of a third coolant path of the fifth heat exchanger is connected to the first liquid injection port, and a liquid outlet of the third coolant path of the fifth heat exchanger is connected to the first liquid return port. A liquid outlet of a fourth coolant path of the fifth heat exchanger is connected to a liquid inlet of a liquid cooling cable connected to each group of charging connectors, and a liquid inlet of the fourth coolant path of the fifth heat exchanger is connected to a liquid outlet of the liquid cooling cable connected to each group of charging connectors.

In the foregoing technical solution, the fifth heat exchanger is connected to the liquid cooling device through a group of interfaces, and the fifth heat exchanger is connected to the liquid cooling cable connected to each group of charging connectors, so that the liquid cooling device can dissipate heat from the liquid cooling cable connected to each group of charging connectors. This can reduce complexity of a coolant pipe connection between the charging device and the liquid cooling device, and can avoid an increase in costs of the charging device caused by a large quantity of fifth heat exchangers. This helps optimize costs of the charging device.

In a possible implementation, the one or more first liquid injection ports include a plurality of first liquid injection ports, the one or more first liquid return ports include a plurality of liquid return ports, the one or more fifth heat exchangers include a plurality of fifth heat exchangers, and the one or more groups of charging connectors include a plurality of groups of charging connectors. Liquid inlets of third coolant paths of the plurality of fifth heat exchangers are connected to the plurality of first liquid injection ports in a one-to-one correspondence, and liquid outlets of the third coolant paths of the plurality of fifth heat exchangers are connected to the plurality of first liquid return ports in a one-to-one correspondence. Liquid outlets of fourth coolant paths of the plurality of fifth heat exchangers are connected, in a one-to-one correspondence, to liquid inlets of liquid cooling cables connected to the plurality of groups of charging connectors, and liquid inlets of the fourth coolant paths of the plurality of fifth heat exchangers are connected to liquid outlets of the liquid cooling cables connected to the plurality of groups of charging connectors in a one-to-one correspondence.

In the foregoing technical solution, the fifth heat exchangers are connected to different liquid cooling cables, and a connection loop between each fifth heat exchanger and the liquid cooling device and a connection loop between each fifth heat exchanger and the liquid cooling cable are independent of each other. This can avoid a case in which heat dissipation performed by the liquid cooling device on a liquid cooling cable connected to another fifth heat exchanger is affected because a connection loop in which a fifth heat exchanger is located is faulty, so that reliability of heat dissipation performed by the liquid cooling device on the liquid cooling cables connected to the plurality of groups of charging connectors can be improved.

In a possible implementation, the charging device further includes one or more second water pumps. The one or more second water pumps are in a one-to-one correspondence with the one or more fifth heat exchangers. Each second water pump is connected between a liquid inlet of a third coolant path of a corresponding fifth heat exchanger and a first liquid injection port connected to the corresponding fifth heat exchanger, or each second water pump is connected between a liquid outlet of a third coolant path of a corresponding fifth heat exchanger and a first liquid return port connected to the corresponding fifth heat exchanger.

In the foregoing technical solution, the one or more second water pumps may be configured to drive coolant in the first liquid storage tank to flow to third coolant paths of different fifth heat exchangers. Further, the liquid cooling device can be configured to dissipate heat from the liquid cooling cable connected to each group of charging connectors. In addition, the fifth heat exchangers are connected to different second water pumps. Therefore, heat dissipation performed by the liquid cooling device on a liquid cooling cable connected to another second water pump may not be affected when a second water pump is faulty, so that reliability of heat dissipation performed by the liquid cooling device on the liquid cooling cables connected to the plurality of groups of charging connectors can be improved.

In a possible implementation, the liquid cooling cable connected to each group of charging connectors includes a plurality of fifth coolant paths, and the plurality of fifth coolant paths are connected to a fourth coolant path of a same fifth heat exchanger. A liquid inlet of each fifth coolant path is connected to a liquid outlet of the fourth coolant path of the same fifth heat exchanger, and a liquid outlet of each fifth coolant path is connected to a liquid inlet of the fourth coolant path of the same fifth heat exchanger.

Based on the foregoing design, the coolant may circulate between the fourth coolant path of the same fifth heat exchanger and the plurality of fifth coolant paths of the liquid cooling cable, so that the plurality of fifth coolant paths are used to dissipate heat from a positive charging cable and a negative charging cable in the liquid cooling cable, to improve heat dissipation efficiency of the liquid cooling cable. In addition, because all the fifth coolant paths are independently connected to a same fifth heat exchanger, mutual impact between the plurality of fifth coolant paths can be avoided. This improves heat dissipation reliability of the liquid cooling cable.

In a possible implementation, the charging device further includes one or more second liquid storage tanks, and the one or more second liquid storage tanks are in a one-to-one correspondence with the one or more fifth heat exchangers. A liquid inlet of each second liquid storage tank is connected to a liquid outlet of a fourth coolant path of the corresponding fifth heat exchanger, and a liquid outlet of each second liquid storage tank is connected to a liquid inlet of a liquid cooling cable connected to the corresponding fifth heat exchanger.

In a possible implementation, the charging device further includes a third water pump. The third water pump is connected between the liquid outlet of each second liquid storage tank and a liquid inlet of a liquid cooling cable connected to the second liquid storage tank, or the third water pump is connected between the liquid inlet of the fourth coolant path of each fifth heat exchanger and a liquid outlet of the liquid cooling cable connected to the fifth heat exchanger.

In a possible implementation, the charging device further includes a plurality of charging modules, a switch, and a third heat exchanger, and the liquid cooling cable connected to each group of charging connectors is connected to output ends of the plurality of charging modules via the switch. The third heat exchanger includes a first gas path and a second coolant path, and the second coolant path is used to exchange heat with the first gas path. An inlet of the first gas path and an outlet of the first gas path are connected to an environment in which the switch is located. A liquid inlet of the second coolant path is used to connect to the liquid outlet connector of the liquid cooling device, and a liquid outlet of the second coolant path is used to connect to the liquid inlet connector of the liquid cooling device.

In a possible implementation, the liquid inlet of the second coolant path is connected to the first liquid injection port, and the liquid outlet of the second coolant path is connected to the first liquid return port. Alternatively, the charging device further includes a second liquid injection port and a second liquid return port. The second liquid injection port is configured to connect to the liquid outlet connector of the liquid cooling device, the second liquid return port is configured to connect to the liquid inlet connector of the liquid cooling device, the liquid inlet of the second coolant path is connected to the second liquid injection port, and the liquid outlet of the second coolant path is connected to the second liquid return port.

For beneficial effect that is not described in detail in the second aspect to the fourth aspect, refer to beneficial effect of the first aspect. Details are not described herein again.

### BRIEF DESCRIPTION OF DRAWINGS

FIG. 1 is a diagram of a structure of a charging system according to an embodiment of this application;
FIG. 2 is a diagram of an application scenario of a charging pile according to an embodiment of this application;
FIG. 3 is a diagram of a structure of a charging pile according to an embodiment of this application;
FIG. 4 and FIG. 5 each are a diagram of an example of a specific structure of the charging pile shown in FIG. 3;
FIG. 6 is a diagram of an example of a structure in which the charging pile shown in FIG. 3 includes one first water pump;
FIG. 7 to FIG. 9 each are a diagram of an example of a specific structure in which the charging pile shown in FIG. 6 includes one second water pump;
FIG. 10 is a diagram of an example of a structure in which the charging pile shown in FIG. 3 includes a plurality of first water pumps;
FIG. 11 and FIG. 12 each are a diagram of an example of a specific structure in which the charging pile shown in FIG. 10 includes a plurality of second water pumps;
FIG. 13 is a diagram of a structure of another charging pile according to an embodiment of this application;
FIG. 14 is a diagram of a structure of still another charging pile according to an embodiment of this application;
FIG. 15 to FIG. 17 each are a diagram of an example of a specific structure of the charging pile shown in FIG. 14;
FIG. 18 is a diagram of an example of a structure in which the charging pile shown in FIG. 14 includes one fifth heat exchanger;
FIG. 19 to FIG. 22 each are a diagram of an example of a specific structure in which a charging pile shown in FIG. 18 includes one fifth heat exchanger;
FIG. 23 is a diagram of an example of a structure in which the charging pile shown in FIG. 14 includes a plurality of fifth heat exchangers;
FIG. 24 and FIG. 25 each are a diagram of an example of a specific structure in which the charging pile shown in FIG. 23 includes a plurality of fifth heat exchangers;
FIG. 26 and FIG. 27 each are a diagram of an example of a specific structure of a liquid cooling cable shown in FIG. 25; and
FIG. 28 is a diagram of another example of a structure in which the charging pile shown in FIG. 14 includes a plurality of fifth heat exchangers.

### DESCRIPTION OF EMBODIMENTS

For ease of understanding embodiments of this application, the following descriptions are provided before embodiments of this application are described.

In the descriptions of embodiments of this application, a connection may be an electrical connection, or may be a pipe connection. The electrical connection may be understood as that signal transmission is implemented between two electrical elements in a direct electrical connection manner or an indirect electrical connection manner. For example, that A is electrically connected to B may be understood as that A is directly electrically connected to B, or may be understood as that A is indirectly electrically connected to B via one or more other electrical elements.

In embodiments of this application, the terms "first" and "second" are merely intended for a purpose of description, and shall not be understood as an indication or implication of relative importance or an implicit indication of a quantity of indicated technical features. Therefore, a feature limited by "first" or "second" may explicitly or implicitly include one or more features. In addition, in descriptions of embodiments of this application, "a plurality of" means two or more, and "at least one" and "one or more" mean one, two, or more.

In descriptions of embodiments of this application, unless otherwise specified, "and/or" describes only an association relationship between associated objects and indicates that three relationships may exist. For example, A and/or B may indicate the following three cases: Only A exists, both A and B exist, and only B exists.

To facilitate understanding of technical solutions provided in embodiments of this application, an application scenario to which embodiments of this application are applicable is first described.

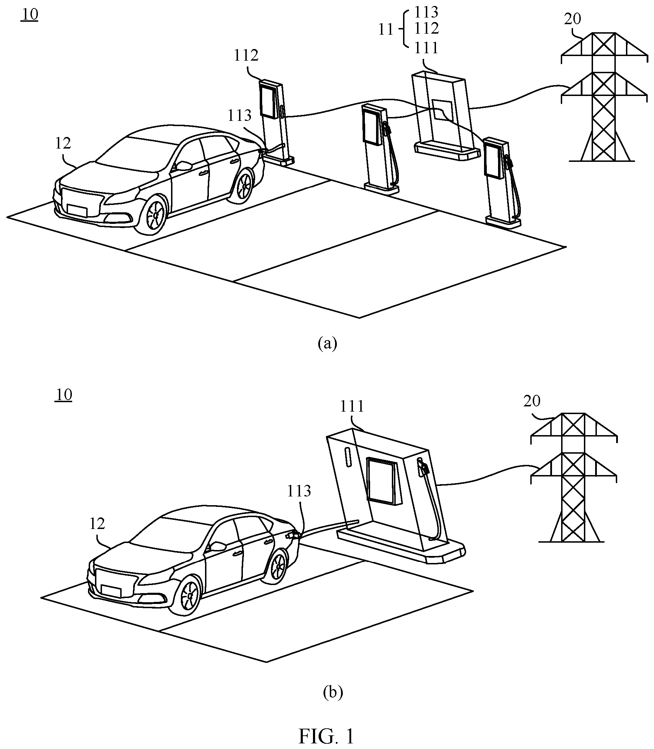

FIG. 1 is a diagram of a structure of a charging system 10 according to an embodiment of this application.

As shown in (a) and (b) in FIG. 1, the charging system 10 includes a charging device 11 and an electric vehicle 12. The charging device 11 is configured to: receive an alternating current output by a power grid 20, convert the alternating current into a stable direct current, and transmit the stable direct current to the electric vehicle 12, to charge the electric vehicle 12. Alternatively, in some other embodiments, the electric vehicle 12 may reversely output electric energy to the power grid 20 via the charging device 11.

In some embodiments, as shown in (a) in FIG. 1, the charging device 11 is a split charging device. Specifically, the charging device 11 includes a power unit 111, one or more charging terminals 112, and one or more chargers 113. The power unit 111 includes a plurality of charging modules (not shown in the figure), and output ends of the plurality of charging modules are connected to the one or more charging terminals 112. Each charging terminal 112 is connected to at least one of the one or more chargers 113, and each charger 113 is configured to connect to the electric vehicle 12. For example, one electric vehicle 12 is connected to one charger 113, or one electric vehicle 12 is connected to a plurality of chargers 113.

During specific implementation, the plurality of charging modules are configured to convert the alternating current output by the power grid 20 into a stable direct current, and then transmit the stable direct current to the charging terminal 112. The charging terminal 112 transmits the received direct current to the electric vehicle 12 via the connected charger 113.

It should be understood that, in this embodiment of this application, the plurality of charging modules include, for example, an alternating current-direct current (alternating current-direct current, AC-DC) conversion apparatus and a direct current-direct current (direct current-direct current, DC-DC) conversion apparatus. The AC-DC conversion apparatus is configured to convert the alternating current from the power grid 20 into a direct current, and then output the direct current to the DC-DC conversion apparatus. The DC-DC conversion apparatus is configured to further convert the received direct current into a stable direct current that meets a charging requirement of the electric vehicle 12.

In an example, the charging terminal 112 includes a switch (not shown in the figure), and the charger 113 includes a charging cable and a charger head. The output ends of the plurality of charging modules in the power unit 111 are connected to one end of the charging cable via the switch, and the other end of the charging cable is connected to the charger head. The charger head is configured to connect to a charging interface of the electric vehicle 12. Further, direct currents output by the plurality of charging modules are transmitted to the electric vehicle 12 through the charger 113.

For example, the switch may be located in a power distribution cabin of the charging terminal 112. The power distribution cabin may further include a copper bar, a shunt, and a fuse. The switch, the shunt, and the fuse are all fastened to the copper bar and connected between the plurality of charging modules and the charger 113. The shunt and the fuse are respectively configured to perform current detection and overcurrent protection on a circuit between the plurality of charging modules and the charger 113.

It should be understood that, in this embodiment of this application, the charging terminal 112 further includes a housing, a human-machine interaction interface, a charging control unit, a metering and billing unit, and the like, to perform information exchange, energy transmission, metering and billing, and the like with the electric vehicle 12. For example, the power distribution cabin may be disposed in the housing of the charging terminal 112.

It should be further understood that, in this embodiment of this application, the electric vehicle 12 is a transportation tool driven by electric energy. The electric vehicle 12 is a pure electric vehicle (pure electric vehicle/battery electric vehicle, pure EV/battery EV), a hybrid electric vehicle (hybrid electric vehicle, HEV), a range extended electric vehicle (range extended electric vehicle, REEV), a plug-in hybrid electric vehicle (plug-in hybrid electric vehicle, PHEV), or the like.

In some other embodiments, as shown in (b) in FIG. 1, the charging device 11 is an integrated charging device. Specifically, the power distribution cabin, the human-machine interaction interface, the charging control unit, the metering and billing unit, and the like in the charging terminal 112 may be disposed, together with the plurality of charging modules, in the power unit 111, for example, in a housing of the power unit 111. In addition, the charger 113 is alternatively directly connected to the power unit 111. In this way, the charging device 11 may include only the power unit 111 and the one or more chargers 113 connected to the power unit 111, and does not include the charging terminal 112.

As described in the background, as the charging device 11 continuously evolves to an ultra-fast charging device, charging power output by the plurality of charging modules in the power unit 111 to the electric vehicle 12 via the charger 113 continuously increases, so that ultra-fast charging can be performed on a power battery of the electric vehicle 12. However, as the charging power continuously increases, not only heat generated by the charging cable in the charger 113 increases, but also heat generated by the power battery of the electric vehicle 12 increases greatly. If the heat cannot be dissipated in time, a temperature of the charging cable and a temperature of the power battery increase together. However, an excessively high temperature easily affects normal high-power charging of the electric vehicle 12 by the charging device 11, and consequently, efficiency and safety of charging the electric vehicle 12 by the charging device 11 decrease.

The electric vehicle 12 usually has a thermal management system, and the thermal management system may provide a required cooling capacity for heat dissipation of the power battery. However, in addition to providing the cooling capacity for the power battery, the thermal management system further needs to provide a required cooling capacity for a motor, a passenger compartment, an air conditioner, and the like in the electric vehicle 12. Therefore, during actual application, the thermal management system can provide a limited cooling capacity for the power battery, and heat dissipation of the power battery by only the thermal management system cannot meet an increasing heat dissipation requirement of the power battery during high-power charging.

Therefore, heat dissipation of the charging cable and the power battery becomes a key problem in implementing high-power charging of the electric vehicle 12.

Based on the foregoing content, embodiments of this application provide a charging device and a charging pile. A thermal management system in the charging pile may separately provide coolant for a liquid cooling cable connected to a charging connector and an electric vehicle, to dissipate heat from the liquid cooling cable and a power battery of the electric vehicle. In this way, heat dissipation requirements of both the liquid cooling cable and the power battery during high-power charging can be met, efficiency and safety of charging the electric vehicle by the charging pile can be improved, the thermal management system can have high utilization, and costs of the charging pile can be optimized.

The following describes the charging pile provided in embodiments of this application with reference to accompanying drawings.

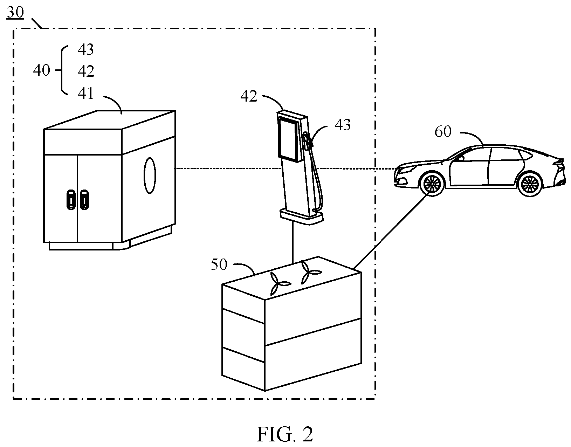

FIG. 2 is a diagram of an application scenario of a charging pile 30 according to an embodiment of this application. It should be noted that, for ease of understanding, in FIG. 2, a solid line indicates a pipe connection, and a dashed line indicates a power connection.

As shown in FIG. 2, the charging pile 30 includes a charging device 40 and a thermal management system. The charging device 40 is configured to charge an electric vehicle 60, and the thermal management system is configured to dissipate heat from a power battery in the electric vehicle 60 when the charging device 40 charges the electric vehicle 60.

It should be understood that, in this embodiment of this application, the charging device 40 may be the split charging device shown in (a) in FIG. 1. To be specific, the charging device 40 includes a power unit 41, a charging terminal 42, and a charger 43 shown in FIG. 2. Alternatively, the charging device 40 may be the integrated charging device shown in (b) in FIG. 1. To be specific, the charging terminal 42 may be integrated into the power unit 41, so that the charging device 40 includes only the power unit 41 and the charger 43. For specific descriptions of the charging device 40, refer to the related descriptions of the embodiment in FIG. 1. Details are not described herein again.

It should be further understood that, in this embodiment of this application, the thermal management system may be disposed in the charging device 40, for example, disposed in the charging terminal 42 of the charging device 40. Alternatively, the thermal management system may be separately disposed outside the charging device 40. For example, as shown in FIG. 2, the charging pile 30 further includes a liquid cooling device 50 located outside the charging device 40, and the thermal management system is disposed in the liquid cooling device 50.

The following describes a specific structure of the charging pile 30 with reference to the accompanying drawings.

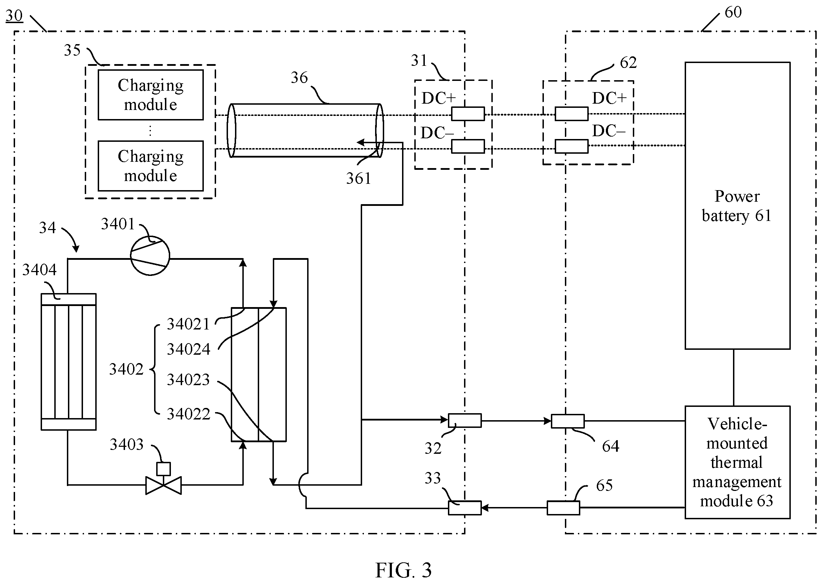

FIG. 3 is a diagram of a structure of a charging pile 30 according to an embodiment of this application. It should be noted that, for ease of understanding, in FIG. 3, a solid line indicates a pipe connection, and a dashed line indicates a power connection.

Refer to FIG. 3. The charging pile 30 includes one or more groups of charging connectors 31, a first liquid outlet connector 32, a first liquid inlet connector 33, and a thermal management system 34.

Each group of charging connectors 31 is configured to output electric energy to the electric vehicle 60.

Specifically, as shown in FIG. 3, the charging pile 30 further includes a plurality of charging modules 35 and a liquid cooling cable 36. Each group of charging connectors 31 is connected to output ends of the plurality of charging modules 35 through the liquid cooling cable 36. The electric vehicle 60 includes a power battery 61 and a group of charging interfaces 62, and the power battery 61 is connected to the group of charging interfaces 62. Each group of charging connectors 31 includes a positive direct current plug DC+ and a negative direct current plug DC-, and the group of charging interfaces 62 includes a positive direct current socket DC+ and a negative direct current socket DC-. The positive direct current plug DC+ and the negative direct current plug DC- are respectively configured to connect to the positive direct current socket DC+ and the negative direct current socket DC-. Therefore, the charging connector 31 may transmit, to the power battery 61 of the electric vehicle 60 through the connected charging interface 62, direct currents output by the plurality of charging modules 35, to charge the electric vehicle 60.

During specific implementation, the plurality of charging modules 35 and each group of charging connectors 31 may be disposed in the charging device 40 shown in FIG. 2. For example, the plurality of charging modules 35 are disposed in the power unit 41, and each group of charging connectors 31 and the liquid cooling cable 36 connected to the group of charging connectors 31 are disposed in the charger 43.

It should be understood that, in this embodiment of this application, the liquid cooling cable 36 connected to each group of charging connectors 31 includes a positive charging cable, a negative charging cable, and a cable liquid cooling pipe. The positive charging cable is connected between the output ends of the plurality of charging modules 35 and the positive direct current plug DC+ in the charging connector 31, and the negative charging cable is connected between the output ends of the plurality of charging modules 35 and the negative direct current plug DC-in the charging connector 31. The cable liquid cooling pipe is configured to circulate coolant, to perform liquid cooling heat dissipation on the positive charging cable and the negative charging cable.

For example, the positive charging cable and the negative charging cable are located outside the cable liquid cooling pipe and are connected to the cable liquid cooling pipe in a thermally conductive manner, or the positive charging cable and the negative charging cable are located inside the cable liquid cooling pipe and are covered by the coolant flowing in the cable liquid cooling pipe.

It should be noted that a specific structure of the liquid cooling cable 36 is merely an example, in this embodiment of this application, provided that the specific structure of the liquid cooling cable 36 enables the cable liquid cooling pipe to perform liquid cooling heat dissipation on the positive charging cable and the negative charging cable.

Still refer to FIG. 3. The first liquid outlet connector 32 is configured to connect to a liquid injection port 64 of the electric vehicle, and the first liquid inlet connector 33 is configured to connect to a liquid return port 65 of the electric vehicle. In addition, the first liquid outlet connector 32 is further connected to a liquid outlet of the thermal management system 34, and the first liquid inlet connector 33 is further connected to a liquid inlet of the thermal management system 34.

It should be understood that, in this embodiment of this application, the thermal management system 34 may be located in the charging device 40 shown in FIG. 2, for example, located in the charging terminal 42, or the thermal management system 34 may be separately located in the liquid cooling device 50 shown in FIG. 2. In addition, the first liquid outlet connector 32 and the first liquid inlet connector 33 may be located in the charger 43 shown in FIG. 2 together with the charging connector 31, that is, the charger 43 is a liquid cooling charging composite charger. Alternatively, in addition to the charger 43, the charging device 40 may further include a liquid cooling charger. The first liquid outlet connector 32 and the first liquid inlet connector 33 are separately disposed in the liquid cooling charger, and are connected to the thermal management system 34 via the liquid cooling charger.

For ease of description and understanding, this embodiment of this application is described by using an example in which the thermal management system 34 is located in the liquid cooling device 50, and the first liquid outlet connector 32 and the first liquid inlet connector 33 are separately disposed in the liquid cooling charger.

For example, the first liquid outlet connector 32 may be, for example, a plug with a bidirectional cut-off function, so that a risk of liquid leakage during an insertion and removal process of the first liquid outlet connector 32 and the liquid injection port 64 of the electric vehicle can be reduced. Similarly, the first liquid inlet connector 33 may also be a plug with a bidirectional cut-off function.

Based on the foregoing design, coolant in the thermal management system 34 may flow into the electric vehicle 60 via the first liquid outlet connector 32 and the liquid injection port 64 of the electric vehicle, and coolant in the electric vehicle 60 may flow back to the thermal management system 34 through the liquid return port 65 of the electric vehicle and the first liquid inlet connector 33. In this way, the coolant circulates between the thermal management system 34 and the electric vehicle 60, so that the thermal management system 34 can dissipate heat from the power battery 61.

During specific implementation, as shown in FIG. 3, the electric vehicle 60 further includes a vehicle-mounted thermal management module 63, and the vehicle-mounted thermal management module 63 is configured to perform temperature management on the power battery 61. A liquid inlet of the vehicle-mounted thermal management module 63 is connected to the liquid injection port 64 of the electric vehicle, and a liquid outlet of the vehicle-mounted thermal management module 63 is connected to the liquid return port 65 of the electric vehicle. In this way, the coolant in the thermal management system 34 may flow into the vehicle-mounted thermal management module 63 of the electric vehicle 60 via the first liquid outlet connector 32, and coolant in the vehicle-mounted thermal management module 63 may flow back to the thermal management system 34 through the first liquid inlet connector 33, so that the thermal management system 34 dissipates heat from the power battery 61.

In some embodiments, the vehicle-mounted thermal management module 63 includes a power battery heat exchanger and a vehicle-mounted thermal management system. The power battery heat exchanger is configured to be in contact with the power battery 61 in a thermally conductive manner, and the power battery heat exchanger is connected to the vehicle-mounted thermal management system through a pipe, to dissipate heat from the power battery 61 through circulation of coolant between the power battery heat exchanger and the vehicle-mounted thermal management system. In addition, a liquid inlet of the vehicle-mounted thermal management system is connected to the liquid injection port 64 of the electric vehicle, and a liquid outlet of the vehicle-mounted thermal management system is connected to the liquid return port 65 of the electric vehicle, so that the coolant circulates between the vehicle-mounted thermal management system and the thermal management system 34 to implement cyclic heat dissipation of the power battery.

For example, the power battery heat exchanger may be a liquid cooling plate with a coolant flow channel.

It should be understood that a specific structure of the vehicle-mounted thermal management module 63 is merely an example, in this embodiment of this application, provided that the vehicle-mounted thermal management module 63 can be used to circulate the coolant to exchange heat with the power battery 61, so as to dissipate heat from the power battery 61.

For example, the coolant in the thermal management system 34 and the coolant in the electric vehicle 60 are of a same type, for example, may be antifreeze of different specifications, for example, antifreeze of -35°C (that is, an ethylene glycol solution with a concentration of 50%). This helps reduce a risk of coolant deterioration and coolant pipe blockage caused by different types of coolant in the thermal management system 34 and the electric vehicle 60.

In the charging pile 30 provided in this embodiment of this application, the thermal management system 34 may form a coolant circulation loop with the vehicle-mounted thermal management module 63 of the electric vehicle 60 via the first liquid outlet connector 32 and the first liquid inlet connector 33. In this way, the coolant in the thermal management system 34 circulates between the thermal management system 34 and the vehicle-mounted thermal management module 63, so that the thermal management system 34 can dissipate heat from the power battery 61. Further, a heat dissipation requirement of the power battery 61 during high-power ultra-fast charging can be met. This helps improve efficiency and safety of charging the power battery 61 by the charging pile 30, to ensure normal high-power charging of the power battery 61.

In addition, in some solutions, a cooling capability of the vehicle-mounted thermal management module 63 is enhanced, and a cooling capacity of the vehicle-mounted thermal management module 63 is increased, to meet a heat dissipation requirement of the power battery 61 during high-power charging. However, a vehicle cooling system of the electric vehicle 60 needs to be rectified. As a result, a weight and a volume of the vehicle increase, and energy consumption of the vehicle also increases greatly. In addition, when the electric vehicle 60 performs fast charging with low power, a rectification part of the vehicle cooling system is in an idle state, and utilization of the cooling system is low.

Therefore, in this embodiment of this application, when the charging connector 31 in the charging pile 30 performs high-power ultra-fast charging on the electric vehicle 60, the thermal management system 34 in the charging pile 30 dissipates heat from the power battery 61, so that a heat dissipation requirement of the power battery 61 during high-power ultra-fast charging can be met, and a large-scale rectification of the vehicle cooling system can be avoided, to avoid an increase in the weight and the volume of the vehicle, and facilitate cost optimization of the electric vehicle 60.

Still refer to FIG. 3. The liquid outlet of the thermal management system 34 is further connected to a liquid inlet 361 of the liquid cooling cable connected to each group of charging connectors 31. The liquid inlet 361 of the liquid cooling cable may be a liquid inlet of the liquid cooling pipe in the liquid cooling cable 36. Based on the foregoing design, the cable liquid cooling pipe in the liquid cooling cable 36 may dissipate heat from the positive charging cable and the negative charging cable through the coolant provided by the thermal management system 34, so that the thermal management system 34 dissipates heat from the liquid cooling cable 36.

In the charging pile 30 provided in this embodiment of this application, the thermal management system 34 may be configured to separately dissipate heat from the power battery 61 of the electric vehicle 60 and the liquid cooling cable 36 connected to the charging connector 31. This can meet heat dissipation requirements of both the liquid cooling cable 36 and the power battery 61 during high-power charging, and improve efficiency and safety of charging the electric vehicle 60 by the charging pile 30, thereby ensuring normal high-power charging of the electric vehicle 60. In addition, because the power battery 61 and the liquid cooling cable 36 share the thermal management system 34 for heat dissipation, the thermal management system 34 has high utilization, and cost optimization of the charging pile 30 is facilitated.

The following describes a specific structure of the thermal management system 34 in the charging pile 30.

Still refer to FIG. 3. The thermal management system 34 includes a first compressor 3401, a first heat exchanger 3402, a first expansion valve 3403, and a second heat exchanger 3404 that are sequentially connected. During specific implementation, the first compressor 3401, the first heat exchanger 3402, the first expansion valve 3403, and the second heat exchanger 3404 are connected through a refrigerant pipe. In this embodiment of this application, the refrigerant pipe is a pipe used to circulate refrigerant, and the refrigerant may be, for example, freon or a liquid nitrogen compound.

The first heat exchanger 3402 includes a first refrigerant path and a first coolant path. The first refrigerant path is connected between the first compressor 3401 and the first expansion valve 3403, and the first refrigerant path is used to exchange heat with the first coolant path.

Specifically, as shown in FIG. 3, a liquid outlet 34021 of the first refrigerant path is connected to an inlet of the first compressor 3401, an outlet of the first compressor 3401 is connected to a liquid inlet of the second heat exchanger 3404, a liquid outlet of the second heat exchanger 3404 is connected to a first valve port of the first expansion valve 3403 (for example, a left valve port of the first expansion valve 3403 shown in FIG. 3), and a second valve port of the first expansion valve 3403 (for example, a right valve port of the first expansion valve 3403 shown in FIG. 3) is connected to a liquid inlet 34022 of the first refrigerant path.

In addition, a liquid outlet 34023 of the first coolant path is connected to the first liquid outlet connector 32 and the liquid inlet 361 of the liquid cooling cable connected to each group of charging connectors 31, and a liquid inlet 34024 of the first coolant path is connected to the first liquid inlet connector 33.

During specific implementation, the refrigerant sequentially circulates along the first compressor 3401, the second heat exchanger 3404, the first expansion valve 3403, and the first refrigerant path of the first heat exchanger 3402, and the thermal management system 34 operates in a refrigeration mode. In this case, the refrigerant flowing in the first refrigerant path of the first heat exchanger 3402 may absorb heat of the coolant flowing in the first coolant path, to cool the coolant flowing in the first coolant path. In addition, the coolant in the first coolant path may flow into the vehicle-mounted thermal management module 63 of the electric vehicle 60 via the first liquid outlet connector 32 and the liquid injection port 64 of the electric vehicle, and the coolant in the vehicle-mounted thermal management module 63 may flow back to the first coolant path through the liquid return port 65 of the electric vehicle and the first liquid inlet connector 33. In this way, the coolant circulates between the first coolant path and the vehicle-mounted thermal management module 63, so that the thermal management system 34 can perform cyclic heat dissipation on the power battery 61.

In addition, the coolant in the first coolant path may also flow into the cable liquid cooling pipe of the liquid cooling cable 36 through the liquid inlet 361 of the liquid cooling cable, to absorb heat generated by the positive charging cable and the negative charging cable in the liquid cooling cable 36. In this way, heat dissipation is performed on the liquid cooling cable 36.

It should be understood that, to implement cyclic heat dissipation on the liquid cooling cable 36 by the thermal management system 34, coolant that absorbs heat in the liquid cooling cable 36 also flows back to the thermal management system 34. A specific manner in which the coolant in the liquid cooling cable 36 flows back to the thermal management system 34 is described below, and details are not described herein again.

For example, the first heat exchanger 3402 may be an evaporator, and the second heat exchanger 3404 may be a condenser.

The following describes, with reference to the accompanying drawings, the specific manner in which the coolant in the liquid cooling cable 36 flows back to the thermal management system 34 mentioned above.

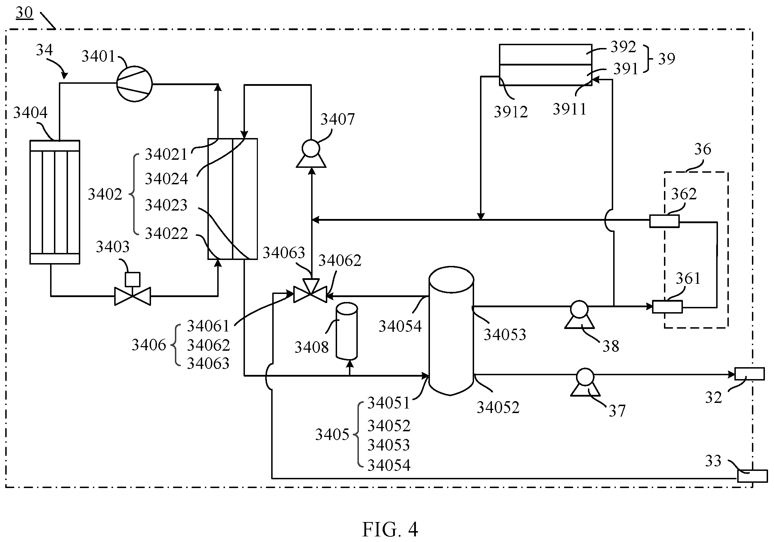

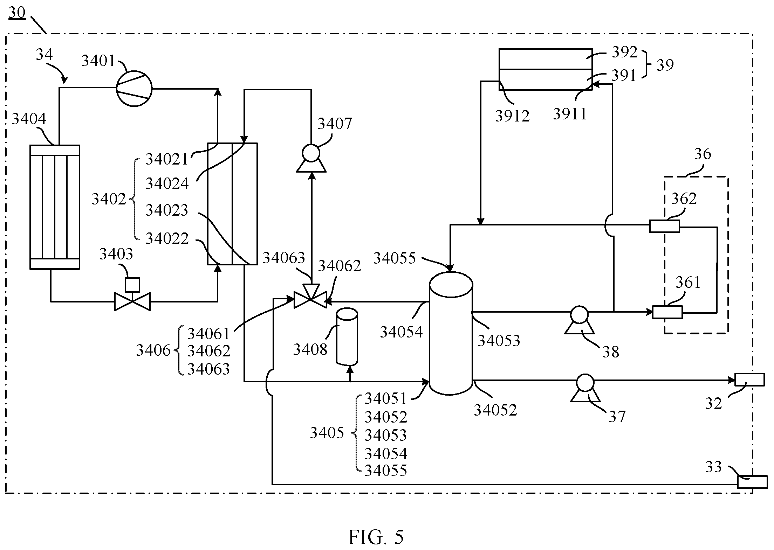

FIG. 4 and FIG. 5 each are a diagram of an example of a specific structure of the charging pile 30 shown in FIG. 3 according to an embodiment of this application.

With reference to FIG. 4 and FIG. 5, in some embodiments, the thermal management system 34 further includes a first liquid storage tank 3405. The liquid outlet 34023 of the first coolant path is connected to the first liquid outlet connector 32 and the liquid inlet 361 of the liquid cooling cable connected to each group of charging connectors 31 via the first liquid storage tank 3405.

During specific implementation, a first liquid inlet 34051 of the first liquid storage tank is connected to the liquid outlet 34023 of the first coolant path, a first liquid outlet 34052 of the first liquid storage tank is connected to the first liquid outlet connector 32, and a second liquid outlet 34053 of the first liquid storage tank is connected to the liquid inlet 361 of the liquid cooling cable connected to each group of charging connectors 31.

Based on the foregoing design, cooled coolant in the first coolant path of the first heat exchanger 3402 may flow into the first liquid storage tank 3405 in advance for storage. When the electric vehicle 60 and/or the liquid cooling cable 36 connected to the charging connector 31 need/needs to dissipate heat, coolant whose temperature decreases and that is stored in the first liquid storage tank 3405 may quickly flow into the electric vehicle 60 and/or the liquid cooling cable 36. This helps improve timeliness of performing heat dissipation by the thermal management system 34 on the power battery 61 of the electric vehicle 60 and the liquid cooling cable 36 connected to the charging connector 31, and further improves efficiency of charging the power battery 61 by the charging pile 30.

Further, for the electric vehicle 60, as shown in FIG. 4 and FIG. 5, the coolant in the electric vehicle 60 flows back to the first coolant path of the first heat exchanger 3402 again through the liquid return port 65 of the electric vehicle and the first liquid inlet connector 33. In this way, a coolant circulation loop is formed between the electric vehicle 60, the first liquid storage tank 3405, and the first heat exchanger 3402.

For the liquid cooling cable 36 connected to each group of charging connectors 31, in an example, as shown in FIG. 4, the liquid outlet 362 of the liquid cooling cable is connected to the liquid inlet 34024 of the first coolant path. In this way, similar to the electric vehicle 60, a coolant circulation loop is formed between the liquid cooling cable 36, the first liquid storage tank 3405, and the first heat exchanger 3402.

In the foregoing technical solution, both coolant flowing back to the liquid cooling cable 36 and coolant flowing back to the power battery 61 flow into the first liquid storage tank 3405 after being cooled by the first heat exchanger 3402. Therefore, the coolant in the first liquid storage tank 3405 can maintain a low temperature, so that the first liquid storage tank 3405 has a good cold storage capability.

In another example, as shown in FIG. 5, the liquid outlet 362 of the liquid cooling cable is connected to a second liquid inlet 34055 of the first liquid storage tank. In this way, the coolant in the liquid cooling cable 36 may flow back to the first liquid storage tank 3405 through the second liquid inlet 34055 of the first liquid storage tank, and is mixed with coolant that flows into the first liquid storage tank 3405 through the first coolant path. The coolant that has been mixed and cooled in the first liquid storage tank 3405 flows into the liquid cooling cable 36 again through the second liquid outlet 34053 of the first liquid storage tank.

In the foregoing technical solution, a coolant circulation loop is directly and independently formed between the liquid cooling cable 36 connected to each group of charging connectors 31 and the first liquid storage tank 3405. This helps improve efficiency of performing heat dissipation on the liquid cooling cable 36 by the thermal management system 34.

During specific implementation, in some embodiments, when an ambient temperature of the thermal management system 34 is lower than a preset temperature, the first compressor 3401 is in an off state. The first coolant path is used to exchange heat with gas in an environment in which the thermal management system 34 is located.

It should be understood that, when the temperature is low, for example, in winter, the ambient temperature of the thermal management system 34 is low. In this case, the first compressor 3401 is in the off state, and the coolant that flows back from the electric vehicle 60 and the liquid cooling cable 36 to the first coolant path may directly transfer heat to cold air in an environment in which the thermal management system 34 is located. In other words, the coolant in the first coolant path is cooled in a natural cooling manner. This can reduce energy consumption of the thermal management system 34 while implementing heat dissipation by the thermal management system 34 on the power battery 61 and the liquid cooling cable 36.

Still refer to FIG. 4 and FIG. 5. In some embodiments, a third liquid outlet 34054 of the first liquid storage tank is connected to the liquid inlet 34024 of the first coolant path. Based on the foregoing design, a coolant circulation loop is formed between the first liquid storage tank 3405 and the first coolant path through the third liquid outlet 34054 of the first liquid storage tank and the first liquid inlet 34051 of the first liquid storage tank.

During specific implementation, when each group of charging connectors 31 in the charging pile 30 does not transmit the electric energy to the electric vehicle 60, that is, when each charger 43 in the charging pile 30 is in an idle state, the first liquid storage tank 3405 may not provide coolant for the electric vehicle 60 and the liquid cooling cable 36 connected to each group of charging connectors 31. In this case, the coolant in the first liquid storage tank 3405 may flow into the first coolant path through the third liquid outlet 34054 of the first liquid storage tank for cooling, and the cooled coolant flows back to the first liquid storage tank 3405 again through the first liquid inlet 34051 of the first liquid storage tank.

Therefore, the coolant in the first liquid storage tank 3405 can maintain a low temperature, so that the first liquid storage tank 3405 has a good cold storage capability. This helps improve timeliness and heat dissipation effect of performing heat dissipation by the thermal management system 34 on the power battery 61 and the liquid cooling cable 36 connected to each group of charging connectors 31.

Still refer to FIG. 4 and FIG. 5. In some embodiments, the thermal management system 34 further includes a first three-way valve 3406. A first valve port 34061 of the first three-way valve is connected to the first liquid inlet connector 33, a second valve port 34062 of the first three-way valve is connected to the third liquid outlet 34054 of the first liquid storage tank, and a third valve port 34063 of the first three-way valve is connected to the liquid inlet 34024 of the first coolant path.

Based on the foregoing design, on/off states of different valve ports of the first three-way valve 3406 may be adjusted to switch heat exchange between the first heat exchanger 3402 and the coolant in the first liquid storage tank 3405, or heat exchange between the first heat exchanger 3402 and the coolant in the electric vehicle 60.

For example, in an example, the charging pile 30 is configured to: when each group of charging connectors 31 in the charging pile 30 does not transmit the electric energy to the electric vehicle 60, control the first three-way valve 3406 to connect a path between the first liquid inlet connector 33 and the liquid inlet 34024 of the first coolant path, and disconnect a path between the third liquid outlet 34054 of the first liquid storage tank and the liquid inlet 34024 of the first coolant path.

Specifically, when each group of charging connectors 31 does not charge the electric vehicle 60, the charging pile 30 may connect a path between the first valve port 34061 of the first three-way valve and the third valve port 34063 of the first three-way valve, and disconnect a path between the second valve port 34062 of the first three-way valve and the third valve port 34063 of the first three-way valve. In this way, the coolant in the first liquid storage tank 3405 may circulate in the first coolant path of the first heat exchanger 3402, and exchange heat with the first refrigerant path of the first heat exchanger 3402, to transfer heat to the first refrigerant path, and dissipate heat from the coolant in the first liquid storage tank 3405.

Therefore, the coolant in the first liquid storage tank 3405 can maintain a low temperature. In this way, when the charging connector 31 in the charging pile 30 charges the electric vehicle 60, the coolant with the low temperature stored in the first liquid storage tank 3405 may quickly flow into the electric vehicle 60 and the liquid cooling cable 36 connected to the currently operating charging connector 31, to improve timeliness and cooling effect of performing heat dissipation by the thermal management system 34 on the power battery 61 and the liquid cooling cable 36.

In another example, the charging pile 30 is further configured to: when a charging connector 31 in the one or more groups of charging connectors 31 of the charging pile 30 transmits electric energy to the electric vehicle 60, control the first three-way valve 3406 to connect the path between the first liquid inlet connector 33 and the liquid inlet 34024 of the first coolant path, and disconnect the path between the third liquid outlet 34054 of the first liquid storage tank and the liquid inlet 34024 of the first coolant path.

Specifically, when at least one group of charging connectors 31 in the charging pile 30 charges the electric vehicle 60, the charging pile 30 may connect the path between the second valve port 34062 of the first three-way valve and the third valve port 34063 of the first three-way valve, and disconnect the path between the first valve port 34061 of the first three-way valve and the third valve port 34063 of the first three-way valve. Therefore, the first heat exchanger 3402 can exchange heat with only the coolant in the electric vehicle 60, to help ensure heat dissipation effect of the thermal management system 34 on the power battery 61.

Still refer to FIG. 4 and FIG. 5. In some embodiments, to enable the coolant in the electric vehicle 60 to flow back to the first coolant path of the first heat exchanger 3402, the thermal management system 34 further includes a water pump 3407. The water pump 3407 is connected between the third valve port 34063 of the first three-way valve and the liquid inlet 34024 of the first coolant path.

Based on the foregoing design, the coolant in the electric vehicle 60 may be driven by the water pump 3407 to flow back to the first coolant path, so that the thermal management system 34 can dissipate heat from the power battery 61. In addition, during actual application, if the liquid outlet 362 of the liquid cooling cable is connected to the liquid inlet 34024 of the first coolant path, the water pump 3407 may also be configured to drive the coolant in the liquid cooling cable 36 to flow back to the first coolant path. In this way, the thermal management system 34 dissipates heat from the liquid cooling cable 36.

Still refer to FIG. 4 and FIG. 5. In some embodiments, the thermal management system 34 further includes an expansion tank 3408. A liquid inlet of the expansion tank 3408 is connected to a path between the liquid outlet 34023 of the first coolant path and the first liquid inlet 34051 of the first liquid storage tank. Based on the foregoing design, coolant that passes through the first coolant path to the first liquid storage tank 3405 may flow into the expansion tank 3408, so that the expansion tank 3408 has a pressure relief function. This improves operation reliability of the thermal management system 34.

The foregoing describes a specific structure of the thermal management system 34 with reference to the accompanying drawings. It should be understood that, during actual application, to enable the coolant in the thermal management system 34 to flow into the electric vehicle 60 and the liquid cooling cable 36, water pumps further need to be separately disposed between the thermal management system 34 and the electric vehicle 60 and between the thermal management system 34 and the liquid cooling cable 36.

During specific implementation, with reference to FIG. 4 and FIG. 5, in some embodiments, the charging pile 30 further includes one first water pump 37 and one or more second water pumps 38.

The first water pump 37 is connected between the first liquid outlet 34052 of the first liquid storage tank and the first liquid outlet connector 32. The one or more second water pumps 38 are connected between the second liquid outlet 34053 of the first liquid storage tank and the liquid inlet 361 of the liquid cooling cable connected to each group of charging connectors 31, or the one or more second water pumps 38 are connected between the second liquid inlet 34055 of the first liquid storage tank and the liquid outlet 362 of the liquid cooling cable connected to each group of charging connectors 31, or the one or more second water pumps 38 are connected between the liquid inlet 34024 of the first coolant path and the liquid outlet 362 of the liquid cooling cable connected to each group of charging connectors 31.

For example, FIG. 4 and FIG. 5 each show an example in which the charging pile 30 includes one second water pump 38 and the liquid cooling cable 36 connected to one group of charging connectors 31. The second water pump 38 is connected between the second liquid outlet 34053 of the first liquid storage tank and the liquid inlet 361 of the liquid cooling cable.

It should be understood that a specific arrangement of the one or more second water pumps 38 in the charging pile 30 is described below, and the foregoing is merely a brief description.

Based on the foregoing design, the first water pump 37 may drive the coolant in the first liquid storage tank 3405 to flow into the electric vehicle 60 via the first liquid outlet connector 32, so that the thermal management system 34 can dissipate heat from the power battery 61. In addition, the second water pump 38 may drive the coolant in the first liquid storage tank 3405 to flow into the liquid cooling cable 36 connected to each group of charging connectors 31, so that the thermal management system 34 can dissipate heat from the liquid cooling cable 36.

Refer to FIG. 3 to FIG. 5. In some embodiments, the charging pile 30 further includes a switch (not shown in the figure) and a third heat exchanger 39.

Each group of charging connectors 31 in the charging pile 30 is connected to the output ends of the plurality of charging modules 35 via the switch, and the switch is configured to control connection and disconnection of a circuit between the plurality of charging modules 35 and the charging connectors 31. Specifically, each group of charging connectors 31 is connected to one end of the liquid cooling cable 36, and the other end of the liquid cooling cable 36 is connected to the output ends of the plurality of charging modules 35 via the switch.

The third heat exchanger 39 includes a first gas path 392 and a second coolant path 391, and the second coolant path 391 is configured to exchange heat with the first gas path 392. An inlet of the first gas path 392 and an outlet of the first gas path 392 are connected to an environment in which the switch is located. A liquid inlet 3911 of the second coolant path is connected to the second liquid outlet 34053 of the first liquid storage tank. In addition, as shown in FIG. 4, a liquid outlet 3912 of the second coolant path is connected to the liquid inlet 34024 of the first coolant path. Alternatively, as shown in FIG. 5, a liquid outlet 3912 of the second coolant path is connected to the second liquid inlet 34055 of the first liquid storage tank.

During specific implementation, gas in the environment in which the switch is located is in the first gas path 392 after absorbing heat generated by the switch. In addition, the coolant in the first liquid storage tank 3405 flows into the second coolant path 391, to absorb heat of circulating gas in the first gas path 392, so as to cool the circulating gas in the first gas path 392. The coolant that absorbs heat in the second coolant path 391 may flow back to the first coolant path again, or flow back to the first liquid storage tank 3405 again. That is, the thermal management system 34 also forms a coolant circulation loop with the third heat exchanger 39. Further, the coolant circulates between the thermal management system 34 and the third heat exchanger 39, so that the thermal management system 34 can dissipate heat from the switch.

It should be understood that, in this embodiment of this application, both the switch and the third heat exchanger 39 may be located in a power distribution cabin of the charging terminal 42 shown in FIG. 2. For specific descriptions, refer to related descriptions of the power distribution cabin in the embodiment shown in FIG. 1. Details are not described herein again. In addition, to facilitate gas flowing in the first gas path 392 to absorb heat generated by the switch, the third heat exchanger 39 may be disposed close to the switch.

For example, the charging pile 30 further includes a fan (not shown in the figure). The fan is disposed on one side of the third heat exchanger 39, and an air exhaust vent of the fan faces the first gas path 392, to increase a speed of gas flowing in the first gas path 392. In this way, a speed at which the gas absorbs heat of the switch is increased. This improves heat dissipation efficiency of the switch.

In the charging pile 30 provided in this embodiment of this application, the thermal management system 34 may not only be configured to dissipate heat from the power battery 61 and the liquid cooling cable 36 connected to the charging connector 31, but also be configured to dissipate heat from the switch in the power distribution cabin. This can further improve utilization of the thermal management system 34, and further facilitate cost optimization of the charging pile 30.

The following describes the specific arrangement of the one or more second water pumps 38 in the charging pile 30.

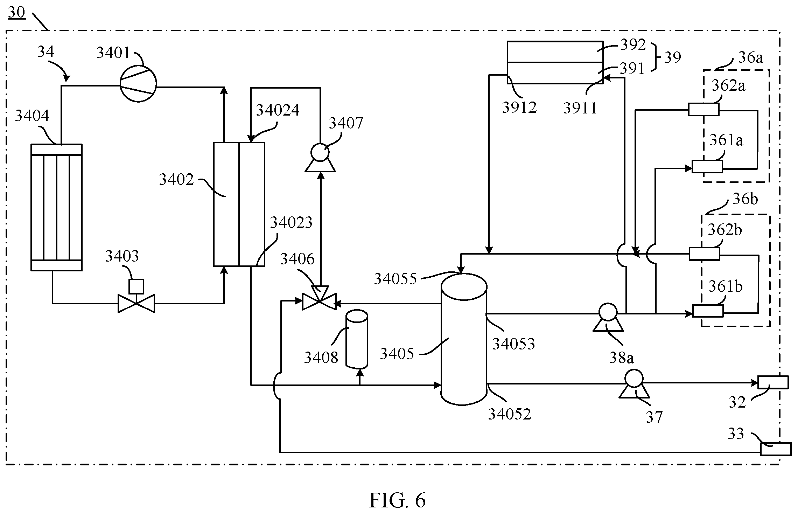

FIG. 6 is a diagram of an example of a specific structure of the charging pile 30 shown in FIG. 3 according to an embodiment of this application.

Refer to FIG. 6. In some embodiments, the charging pile 30 includes one second water pump 38, that is, includes a second water pump 38a.

The second water pump 38a is connected between the second liquid outlet 34053 of the first liquid storage tank and the liquid inlet 361 of the liquid cooling cable connected to each group of charging connectors 31 in the charging pile 30, or the second water pump 38a is connected between the second liquid inlet 34055 of the first liquid storage tank and the liquid outlet 362 of the liquid cooling cable connected to each group of charging connectors 31 in the charging pile 30, or the second water pump 38a is connected between the liquid inlet 34024 of the first coolant path and the liquid outlet 362 of the liquid cooling cable connected to each group of charging connectors 31 in the charging pile 30.

For example, in FIG. 6, the charging pile 30 includes two groups of charging connectors 31, one group of charging connectors 31 is connected to a liquid cooling cable 36a, and the other group of charging connectors 31 is connected to a liquid cooling cable 36b. The second water pump 38a is connected between the second liquid outlet 34053 of the first liquid storage tank and a liquid inlet 361a of the liquid cooling cable in the liquid cooling cable 36a, and between the liquid outlet 34053 of the first liquid storage tank and a liquid inlet 361b of the liquid cooling cable in the liquid cooling cable 36b. In other words, the second liquid outlet 34053 of the first liquid storage tank is connected to the liquid inlet 361a of the liquid cooling cable and the liquid inlet 361b of the liquid cooling cable in the liquid cooling cable 36b via the second water pump 38a. In addition, both the liquid outlet 362a of the liquid cooling cable in the liquid cooling cable 36a and the liquid outlet 362b of the liquid cooling cable in the liquid cooling cable 36b are connected to the second liquid inlet 34055 of the first liquid storage tank.

Based on the foregoing design, the thermal management system 34 may enable, via one second water pump 38, that is, the second water pump 38a, the coolant in the thermal management system 34 to flow to the liquid cooling cable 36 connected to each group of charging connectors 31, and a small quantity of second water pumps 38 may be disposed in the charging pile 30. In this way, complexity of a pipe connection in the charging pile 30 can be reduced, an increase in costs of the charging pile 30 can be reduced, and cost optimization of the charging pile 30 can be facilitated.

It should be understood that, in this embodiment of this application, when the thermal management system 34 is located in the liquid cooling device 50, and the plurality of charging modules 35 and each group of charging connectors 31 are located in the charging device 40, the first water pump 37 is disposed in the liquid cooling device 50. In addition, the second water pump 38a may also be disposed in the liquid cooling device 50, or the second water pump 38a may be disposed in the charging device 40.

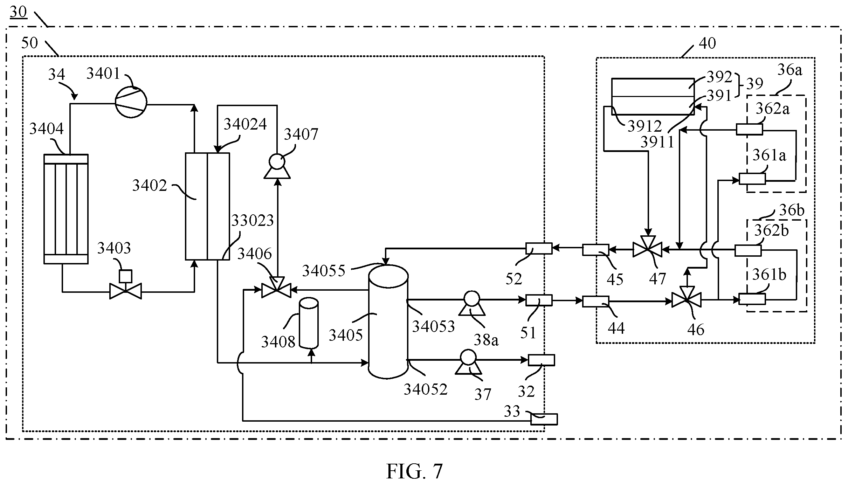

FIG. 7 to FIG. 9 each show an example of a specific disposing position of the second water pump 38a shown in FIG. 6 in the charging pile 30.

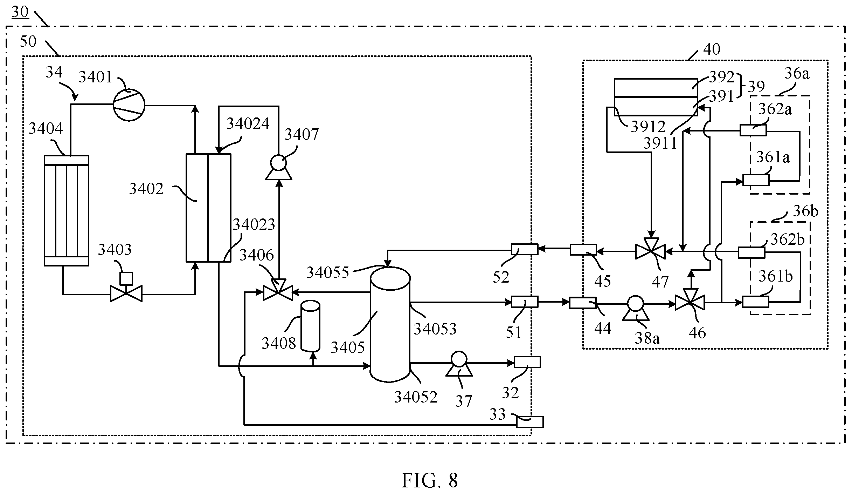

In some embodiments, with reference to FIG. 7 and FIG. 8, when the charging pile 30 includes one second water pump 38, that is, includes the second water pump 38a, the liquid cooling device 50 includes one second liquid outlet connector 51 and one second liquid inlet connector 52, and the charging device 40 includes one first liquid injection port 44 and one first liquid return port 45.

The second liquid outlet connector 51 is connected to the second liquid outlet 34053 of the first liquid storage tank, and the second liquid inlet connector 52 is connected to the second liquid inlet 34055 of the first liquid storage tank, or the second liquid inlet connector 52 is connected to the liquid inlet 34024 of the first coolant path. The first liquid injection port 44 is connected to the liquid inlet 361 of the liquid cooling cable connected to each group of charging connectors 31, and the first liquid return port 45 is connected to the liquid outlet 362 of the liquid cooling cable connected to each group of charging connectors 31. In addition, the first liquid injection port 44 is further connected to the second liquid outlet connector 51, and the first liquid return port 45 is further connected to the second liquid inlet connector 52.

For example, as shown in FIG. 7 and FIG. 8, the charging pile 30 still includes the liquid cooling cable 36a and the liquid cooling cable 36b that are connected to the two groups of charging connectors 31, and the first liquid injection port 44 is connected to the liquid inlet 361a of the liquid cooling cable in the liquid cooling cable 36a and the liquid inlet 361b of the liquid cooling cable in the liquid cooling cable 36b. The first liquid return port 45 is connected to the liquid outlet 362a of the liquid cooling cable in the liquid cooling cable 36a and the liquid outlet 362b of the liquid cooling cable in the liquid cooling cable 36b.

For example, the first liquid injection port 44 and the first liquid return port 45 may be disposed on a housing of the charging terminal 42 in the charging device 40.

Based on the foregoing design, the coolant in the first liquid storage tank 3405 in the liquid cooling device 50 may flow, through one liquid outlet connector 51 and one first liquid injection port 44 that are connected, into the liquid cooling cable 36 connected to each group of charging connectors 31. In addition, the coolant in the liquid cooling cable 36 may flow back to the first liquid storage tank 3405 or flow back to the first coolant path of the first heat exchanger 3402 through the first liquid return port 45 and the second liquid inlet connector 52 that are connected. In other words, a group of connectors in the liquid cooling device 50 is connected to a group of interfaces in the charging device 40 in a coordinated manner, so that the thermal management system 34 located in the liquid cooling device 50 can be connected to the liquid cooling cable 36 connected to each group of charging connectors 31 located in the charging device 40. This can reduce complexity of a pipe connection between the liquid cooling device 50 and the charging device 40, and facilitate cost optimization of the charging pile 30.

Further, in an example, as shown in FIG. 7, the second water pump 38a is disposed in the liquid cooling device 50. The second water pump 38a is connected between the second liquid outlet 34053 of the first liquid storage tank and the second liquid outlet connector 51, or the second water pump 38a is connected between the second liquid inlet 34055 of the first liquid storage tank and the second liquid inlet connector 52, or the second water pump 38a is connected between the liquid inlet 34024 of the first coolant path and the second liquid inlet connector 52. FIG. 7 shows an example in which the second water pump 38a is connected between the second liquid outlet 34053 of the first liquid storage tank and the second liquid outlet connector 51.

In the foregoing technical solution, the second water pump 38 located in the liquid cooling device 50 is connected to the liquid cooling cable 36 connected to each group of charging connectors 31 in the charging device 40 through a coordinated connection between a group of connectors in the liquid cooling device 50 and a group of interfaces in the charging device 40. This can reduce complexity of a pipe connection between the liquid cooling device 50 and the charging device 40, and facilitate cost optimization of the charging pile 30. In addition, because both the first water pump 37 and the second water pump 38 are disposed in the liquid cooling device 50, an integrated design of the liquid cooling device 50 is further facilitated.

In another example, as shown in FIG. 8, the second water pump 38a is disposed in the charging device 40. The second water pump 38a is connected between the first liquid injection port 44 and the liquid inlet 361 of the liquid cooling cable connected to each group of charging connectors 31, or the second water pump 38a is connected between the first liquid return port 45 and the liquid outlet 362 of the liquid cooling cable connected to each group of charging connectors 31. FIG. 8 shows an example in which the second water pump 38a is connected between the first liquid injection port 44 and the liquid inlet 361 of the liquid cooling cable connected to each group of charging connectors 31.

In the foregoing technical solution, the second water pump 38 located in the charging device 40 is connected to the thermal management system 34 in the liquid cooling device 50 through a coordinated connection between a group of connectors in the liquid cooling device 50 and a group of interfaces in the charging device 40. This can reduce complexity of a pipe connection between the liquid cooling device 50 and the charging device 40, and facilitate cost optimization of the charging pile 30.

In addition, a performance difference between the first water pump 37 that drives the first liquid storage tank 3405 to provide coolant to the electric vehicle 60 and the second water pump 38 that drives the first liquid storage tank 3405 to provide coolant to the liquid cooling cable 36 is large. For example, the water pumps differ greatly in a lift and a flow rate. If the first water pump 37 and the second water pump 38 are strongly coupled, for example, both the first water pump 37 and the second water pump 38 are disposed in the liquid cooling device 50, logic for the charging pile 30 to perform flow distribution and abnormal working condition protection on the first water pump 37 and the second water pump 38 may be complex.

Therefore, in this embodiment of this application, the first water pump 37 is disposed in the liquid cooling device 50, and the second water pump 38 is disposed in the charging device 40, so that the first water pump 37 and the second water pump 38 are decoupled. This can reduce mutual impact of the performance difference between the first water pump 37 and the second water pump 38, and reduce logic complexity of performing flow distribution and abnormal working condition protection by the charging pile 30 on the first water pump 37 and the second water pump 38.

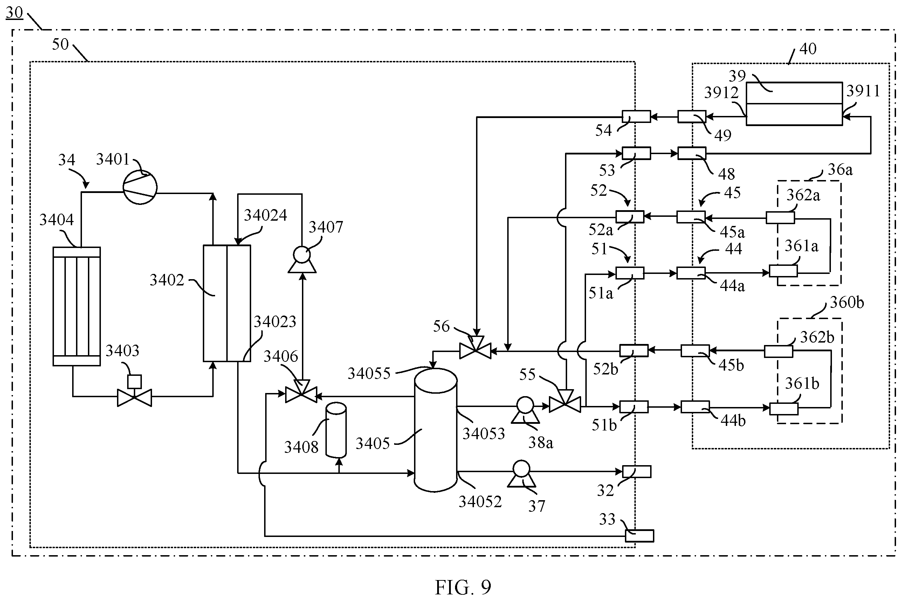

In some other embodiments, as shown in FIG. 9, when the charging pile 30 includes one second water pump 38, that is, includes the second water pump 38a, the liquid cooling device 50 includes a plurality of second liquid outlet connectors 51 and a plurality of second liquid inlet connectors 52, the charging device 40 includes a plurality of first liquid injection ports 44 and a plurality of first liquid return ports 45, and the charging pile 30 includes a plurality of groups of charging connectors 31.

Each second liquid outlet connector 51 is connected to the second liquid outlet 34053 of the first liquid storage tank, and each second liquid inlet connector 52 is connected to the second liquid inlet 34055 of the first liquid storage tank, or each second liquid inlet connector 52 is connected to the liquid inlet 34024 of the first coolant path. The plurality of first liquid injection ports 44 are connected, in a one-to-one correspondence, to liquid inlets 361 of liquid cooling cables connected to the plurality of groups of charging connectors 31, and the plurality of first liquid return ports 45 are connected, in a one-to-one correspondence, to liquid outlets 362 of the liquid cooling cables connected to the plurality of groups of charging connectors 31. In addition, the plurality of first liquid injection ports 44 are further connected to the plurality of second liquid outlet connectors 51 in a one-to-one correspondence, and the plurality of first liquid return ports 45 are connected to the plurality of second liquid inlet connectors 52 in a one-to-one correspondence. In other words, the liquid cooling cables 36 connected to all the groups of charging connectors 31 are connected to the thermal management system 34 in the liquid cooling device 50 through coordination between different connectors and different interfaces.

For example, as shown in FIG. 9, the charging pile 30 still includes the liquid cooling cable 36a and the liquid cooling cable 36b that are connected to the two groups of charging connectors 31. The liquid cooling device 50 includes two second liquid outlet connectors 51 and two second liquid inlet connectors 52, and the charging device 40 includes two first liquid injection ports 44 and two first liquid return ports 45. To be specific, the liquid cooling device 50 includes a second liquid outlet connector 51a, a second liquid outlet connector 51b, a second liquid inlet connector 52a, and a second liquid inlet connector 52b, and the charging device 40 includes a first liquid injection port 44a, a first liquid injection port 44b, a first liquid return port 45a, and a first liquid return port 45b.

Both the second liquid outlet connector 51a and the second liquid outlet connector 51b are connected to the second liquid outlet 34053 of the first liquid storage tank, and both the second liquid inlet connector 52a and the second liquid inlet connector 52b are connected to the second liquid inlet 34055 of the first liquid storage tank. The second liquid outlet connector 51a and the second liquid outlet connector 51b are further correspondingly connected to the first liquid injection port 44a and the first liquid injection port 44b, and the second liquid inlet connector 52a and the second liquid inlet connector 52b are further correspondingly connected to the first liquid return port 45a and the first liquid return port 45b. In addition, the first liquid injection port 44a and the first liquid injection port 44b are correspondingly connected to the liquid inlet 361a of the liquid cooling cable and the liquid inlet 361b of the liquid cooling cable, and the first liquid return port 45a and the first liquid return port 45b are correspondingly connected to the liquid outlet 362a of the liquid cooling cable and the liquid outlet 362b of the liquid cooling cable. That is, a connection pipe between the liquid cooling cable 36a and the thermal management system 34 and a connection pipe between the liquid cooling cable 36b and the thermal management system 34 are independent of each other.

Based on the foregoing design, connection pipes between the thermal management system 34 located in the liquid cooling device 50 and the liquid cooling cables 36 connected to all the groups of charging connectors 31 located in the charging device 40 are separately disposed. This can avoid mutual impact between pipes connected to different liquid cooling cables 36, to improve reliability of heat dissipation performed by the thermal management system 34 on the liquid cooling cable 36 connected to each group of charging connectors 31.

Further, in an example, as shown in FIG. 9, the second water pump 38a is disposed between the second liquid outlet 34053 of the first liquid storage tank and each second liquid outlet connector 51, or the second water pump 38a is connected between the second liquid inlet 34055 of the first liquid storage tank and each second liquid inlet connector 52, or the second water pump 38a is connected between the liquid inlet 34024 of the first coolant path and each second liquid inlet connector 52.

For example, FIG. 9 shows an example in which the second water pump 38a is connected between the second liquid outlet 34053 of the first liquid storage tank and the second liquid outlet connector 51a and between the second liquid outlet 34053 of the first liquid storage tank and the second liquid outlet connector 51b.

In the foregoing technical solution, the coolant in the thermal management system 34 located in the liquid cooling device 50 may flow to the liquid cooling cable 36 connected to each group of charging connectors 31 located in the charging device 40 via the second water pump 38, and connection pipes between the liquid cooling device 50 and the liquid cooling cables 36 connected to all the groups of charging connectors 31 are separately disposed. This can reduce an increase in costs of the charging pile 30, facilitate cost optimization of the charging pile 30, and avoid mutual impact between pipes connected to different liquid cooling cables 36, to improve reliability of heat dissipation performed by the thermal management system 34 on the liquid cooling cable 36 connected to each group of charging connectors 31.

Still refer to FIG. 7 to FIG. 9. In some embodiments, the third heat exchanger 39 is located in the charging device 40. The second coolant path 391 of the third heat exchanger 39 is connected to the thermal management system 34 located in the liquid cooling device 50 through the first liquid injection port 44 and the first liquid return port 45. Alternatively, the second coolant path 391 of the third heat exchanger 39 is connected to the thermal management system 34 located in the liquid cooling device 50 through a liquid injection port and a liquid return port that are separately disposed in the charging device 40.

Specifically, in an example, as shown in FIG. 7 and FIG. 8, when the liquid cooling device 50 includes one second liquid outlet connector 51 and one second liquid inlet connector 52, and the charging device 40 includes one first liquid injection port 44 and one first liquid return port 45, the liquid inlet 3911 of the second coolant path is connected to the first liquid injection port 44, and the liquid outlet 3912 of the second coolant path is connected to the first liquid return port 45.

Based on the foregoing design, the liquid cooling cable 36 connected to each group of charging connectors 31 in the charging device 40 and the third heat exchanger 39 share a group of interfaces to connect to the thermal management system 34 in the liquid cooling device 50. In this way, the thermal management system 34 can dissipate heat from the liquid cooling cable 36 and the switch in the power distribution cabin, complexity of a pipe connection between the charging device 40 and the liquid cooling device 50 can be further reduced, and cost optimization of the charging pile 30 is facilitated.

During specific implementation, as shown in FIG. 7 and FIG. 8, the charging device 40 further includes two second three-way valves, to be specific, includes a second three-way valve 46 and a second three-way valve 47. A first valve port of the second three-way valve 46 is connected to the first liquid injection port 44, a second valve port of the second three-way valve 46 is connected to the liquid inlet 361a of the liquid cooling cable in the liquid cooling cable 36a and the liquid inlet 361b of the liquid cooling cable in the liquid cooling cable 36b, and a third valve port of the second three-way valve 46 is connected to the liquid inlet 3911 of the second coolant path. Similarly, a first valve port of the second three-way valve 47 is connected to the first liquid return port 45, a second valve port of the second three-way valve 47 is connected to the liquid outlet 362a of the liquid cooling cable in the liquid cooling cable 36a and the liquid outlet 362b of the liquid cooling cable in the liquid cooling cable 36b, and a third valve port of the second three-way valve 47 is connected to the liquid outlet 3912 of the second coolant path.

In this way, the coolant flowing from the thermal management system 34 to the charging device 40 may be divided into two paths via the second three-way valve 46. One path flows into the second coolant path 391 of the third heat exchanger 39, and the other path flows into the liquid cooling cable 36a and the liquid cooling cable 36b. Similarly, coolant flowing out of the second coolant path 391 of the third heat exchanger 39 and coolant flowing out of the liquid cooling cable 36a and the liquid cooling cable 36b may be collected into one path via the second three-way valve 47, so that the coolant flows back to the thermal management system 34 through the first liquid return port 45.

In another example, as shown in FIG. 9, when the liquid cooling device 50 includes the plurality of second liquid outlet connectors 51 and the plurality of second liquid inlet connectors 52, and the charging device 40 includes the plurality of first liquid injection ports 44 and the plurality of first liquid return ports 45, the liquid cooling device 50 further includes a third liquid outlet connector 53 and a third liquid inlet connector 54, and the charging device 40 includes a second liquid injection port 48 and a second liquid return port 49.

The third liquid outlet connector 53 is connected to the second liquid outlet 34053 of the first liquid storage tank. The third liquid inlet connector 54 is connected to the second liquid inlet 34055 of the first liquid storage tank, or the third liquid inlet connector 54 is connected to the liquid inlet 34024 of the first coolant path. The second liquid injection port 48 is connected to the liquid inlet 3911 of the second coolant path, and the second liquid return port 49 is connected to the liquid outlet 3912 of the second coolant path. In addition, the second liquid injection port 48 is further connected to the third liquid outlet connector 53, and the second liquid return port 49 is further connected to the third liquid inlet connector 54.

In the foregoing technical solution, the third heat exchanger 39 located in the charging device 40 is connected to the thermal management system 34 through a group of interfaces separately disposed in the charging device 40 and a group of connectors separately disposed in the liquid cooling device 50. This can avoid mutual impact between a connection pipe between the third heat exchanger 39 and the thermal management system 34 and a connection pipe between the liquid cooling cable 36 and the thermal management system 34. Further, reliability of heat dissipation performed by the thermal management system 34 on the liquid cooling cable 36 and the switch in the power distribution cabin can be improved.

During specific implementation, as shown in FIG. 9, the liquid cooling device 50 further includes two third three-way valves, to be specific, includes a third three-way valve 55 and a third three-way valve 56. A first valve port of the third three-way valve 55 is connected to the second liquid outlet 34053 of the first liquid storage tank, a second valve port of the third three-way valve 55 is connected to the second liquid outlet connector 51a and the second liquid outlet connector 51b, and a third valve port of the third three-way valve 55 is connected to the third liquid outlet connector 53. Similarly, a first valve port of the third three-way valve 56 is connected to the second liquid inlet 34055 of the first liquid storage tank, a second valve port of the third three-way valve 56 is connected to the second liquid inlet connector 52a and the second liquid inlet connector 52b, and a third valve port of the third three-way valve 56 is connected to the third liquid inlet connector 54.

In this way, coolant output from the second liquid outlet 34053 of the first liquid storage tank may be divided into two paths via the third three-way valve 55. One path flows into the liquid cooling cable 36a and the liquid cooling cable 36b, and the other path flows into the second coolant path 391. Similarly, coolant flowing out of the liquid cooling cable 36a and the liquid cooling cable 36b and coolant flowing out of the third heat exchanger 39 may be collected into one path via the third three-way valve 56, and the coolant flows back to the first liquid storage tank 3405.

It should be understood that, that the third heat exchanger 39 shown in FIG. 9 is connected to the thermal management system 34 through a separately disposed interface is merely an example. For example, in some other embodiments, the liquid inlet 3911 of the second coolant path is connected to the first liquid injection port 44a, and the liquid outlet 3912 of the second coolant path is connected to the first liquid return port 45a.

Based on the foregoing design, the third heat exchanger 39 and the liquid cooling cable 36 connected to the group of charging connectors 31 share a group of interfaces to connect to the thermal management system 34 in the liquid cooling device 50. In this way, the thermal management system 34 can dissipate heat from the liquid cooling cable 36 and the switch in the power distribution cabin, complexity of a pipe connection between the charging device 40 and the liquid cooling device 50 can be further reduced, and cost optimization of the charging pile 30 is facilitated.

The foregoing describes, with reference to the accompanying drawings, a case in which the charging pile 30 shown in FIG. 6 includes one second water pump 38. The following describes, with reference to the accompanying drawings, a case in which the charging pile 30 includes a plurality of second water pumps 38.

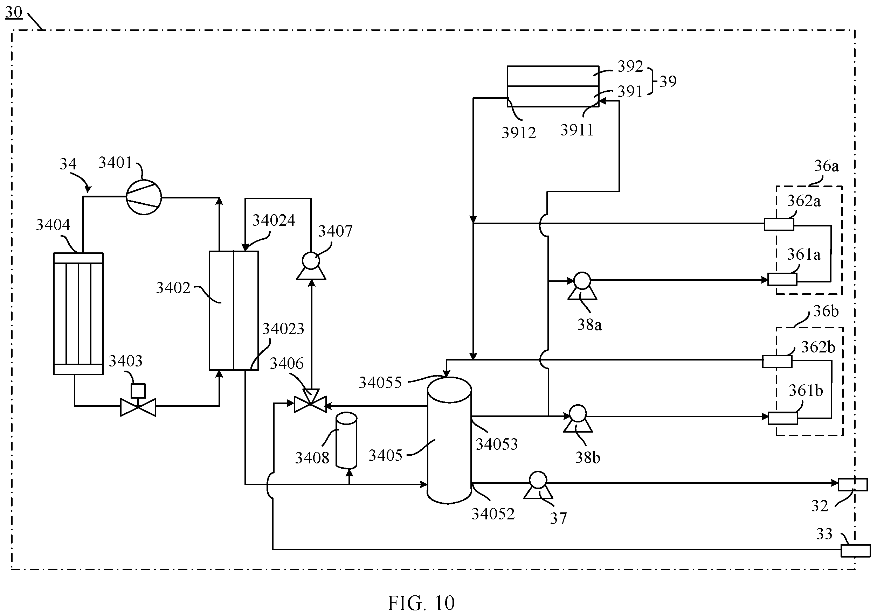

FIG. 10 is a diagram of an example of a specific structure of the charging pile 30 shown in FIG. 3 according to an embodiment of this application.

Different from the embodiments shown in FIG. 6 to FIG. 9, in the embodiment shown in FIG. 10, the charging pile 30 includes a plurality of second water pumps 38 and a plurality of groups of charging connectors 31. The plurality of second water pumps 38 are in a one-to-one correspondence with the plurality of groups of charging connectors 31, that is, the plurality of second water pumps 38 are in a one-to-one correspondence with liquid cooling cables 36 connected to the plurality of groups of charging connectors 31.

Each second water pump 38 is connected between the second liquid outlet 34053 of the first liquid storage tank and a liquid inlet 361 of a corresponding liquid cooling cable, or each second water pump 38 is connected between the second liquid inlet 34055 of the first liquid storage tank and a liquid outlet 362 of a corresponding liquid cooling cable, or each second water pump 38 is connected between the liquid inlet 34024 of the first coolant path and a liquid outlet 362 of a corresponding liquid cooling cable.

For example, in FIG. 10, the charging pile 30 still includes two groups of charging connectors 31, and the liquid cooling cable 36a and the liquid cooling cable 36b that are connected to the two groups of charging connectors 31. The charging pile 30 further includes two second water pumps 38, to be specific, includes a second water pump 38a and a second water pump 38b. The second water pump 38a is connected between the second liquid outlet 34053 of the first liquid storage tank and the liquid inlet 361a of the liquid cooling cable in the liquid cooling cable 36a, and the second water pump 38b is connected between the liquid outlet 34053 of the first liquid storage tank and the liquid inlet 361b of the liquid cooling cable in the liquid cooling cable 36b. In other words, the thermal management system 34 is separately connected to the liquid cooling cable 36a and the liquid cooling cable 36b via different second water pumps 38.

In the foregoing technical solution, the charging pile 30 includes a plurality of second water pumps 38 whose quantity is equal to a quantity of the plurality of groups of charging connectors 31, so that the thermal management system 34 can dissipate, via different second water pumps 38, heat from the liquid cooling cables 36 connected to all the groups of charging connectors 31. Therefore, when any second water pump 38 is faulty, heat dissipation performed by the thermal management system 34 on a liquid cooling cable 36 connected to another second water pump 38 may not be affected. Further, reliability of heat dissipation performed by the thermal management system 34 on the liquid cooling cables 36 connected to the plurality of groups of charging connectors 31 in the charging pile 30 can be improved.

It should be understood that, during actual application, similar to the embodiments shown in FIG. 7 to FIG. 9, when the thermal management system 34 is located in the liquid cooling device 50, and the plurality of charging modules 35 and each group of charging connectors 31 are located in the charging device 40, the plurality of second water pumps 38 may be disposed in the liquid cooling device 50, or the plurality of second water pumps 38 may be disposed in the charging device 40.

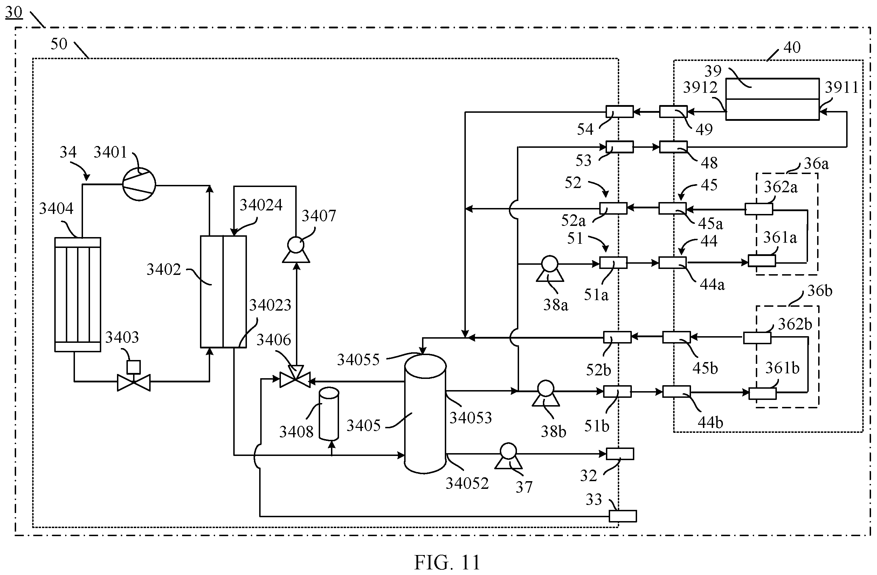

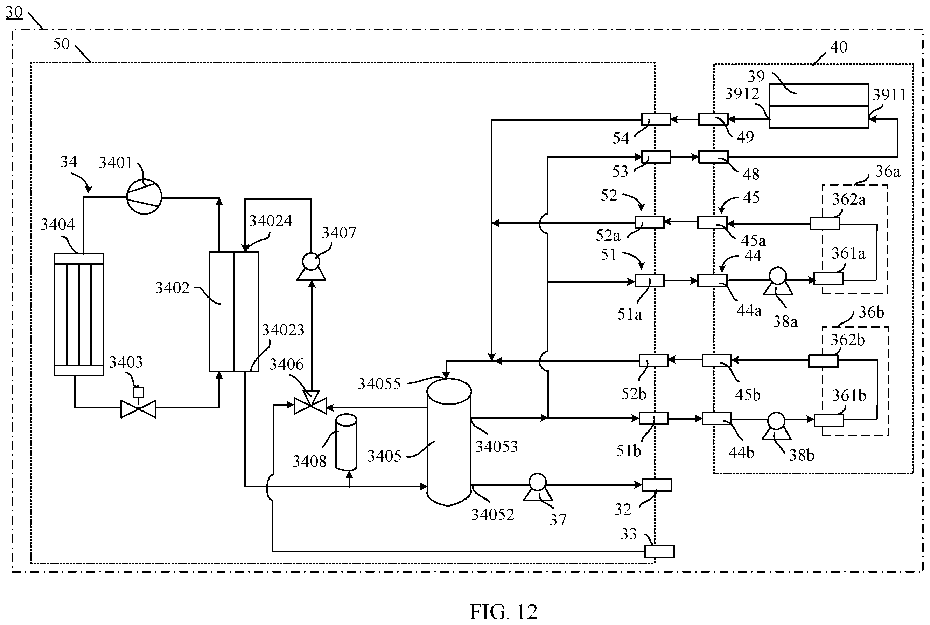

FIG. 11 and FIG. 12 each show an example of specific disposing positions of the plurality of second water pumps 38 shown in FIG. 10 in the charging pile 30.

In some embodiments, with reference to FIG. 11 and FIG. 12, when the charging pile 30 includes a plurality of second water pumps 38 and a plurality of groups of charging connectors 31, the liquid cooling device 50 includes a plurality of second liquid outlet connectors 51 and a plurality of second liquid inlet connectors 52, and the charging device 40 includes a plurality of first liquid injection ports 44 and a plurality of first liquid return ports 45.

The plurality of second liquid outlet connectors 51 are in a one-to-one correspondence with the plurality of second liquid inlet connectors 52. Each second liquid outlet connector 51 is connected to the second liquid outlet 34053 of the first liquid storage tank. Each second liquid inlet connector 52 is connected to the second liquid inlet 34055 of the first liquid storage tank, or each second liquid inlet connector 52 is connected to the liquid inlet 34024 of the first coolant path. The plurality of first liquid injection ports 44 are connected, in a one-to-one correspondence, to liquid inlets 361 of liquid cooling cables connected to the plurality of groups of charging connectors 31, and the plurality of first liquid return ports 45 are connected, in a one-to-one correspondence, to liquid outlets 362 of the liquid cooling cables connected to the plurality of groups of charging connectors 31. In addition, the plurality of first liquid injection ports 44 are further connected to the plurality of second liquid outlet connectors 51 in a one-to-one correspondence, and the plurality of first liquid return ports 45 are further connected to the plurality of second liquid inlet connectors 52 in a one-to-one correspondence.

Further, in an example, as shown in FIG. 11, the plurality of second water pumps 38 corresponding to the plurality of groups of charging connectors 31 are located in the liquid cooling device 50. Each second water pump 38 is connected between the second liquid outlet 34053 of the first liquid storage tank and a second liquid outlet connector 51 connected to the corresponding liquid cooling cable 36, or each second water pump 38 is connected between the second liquid inlet 34055 of the first liquid storage tank and a second liquid inlet connector 52 connected to the corresponding liquid cooling cable 36, or each second water pump 38 is connected between the liquid inlet 34024 of the first coolant path and a second liquid inlet connector 52 connected to the corresponding liquid cooling cable 36.

For example, as shown in FIG. 11, the charging pile 30 shown in FIG. 10 includes the liquid cooling cable 36a and the liquid cooling cable 36b that are connected to the two groups of charging connectors 31, and the corresponding second water pump 38a and second water pump 38b. The liquid cooling device 50 includes a second liquid outlet connector 51a, a second liquid outlet connector 51b, a second liquid inlet connector 52a, and a second liquid inlet connector 52b, and the charging device 40 includes a first liquid injection port 44a, a first liquid injection port 44b, a first liquid return port 45a, and a first liquid return port 45b. The first liquid storage tank 3405 forms a coolant circulation loop with the liquid cooling cable 36a via the second liquid outlet connector 51a, the second liquid inlet connector 52a, the first liquid injection port 44a, and the first liquid return port 45a, and the first liquid storage tank 3405 forms a coolant circulation loop with the liquid cooling cable 36b via the second liquid outlet connector 51b, the second liquid inlet connector 52b, the first liquid injection port 44b, and the first liquid return port 45b. For specific descriptions, refer to the embodiment shown in FIG. 9. Details are not described herein again.

The second water pump 38a and the second water pump 38b are located in the liquid cooling device 50 and respectively correspond to the liquid cooling cable 36a and the liquid cooling cable 36b. For example, the second water pump 38a is connected between the second liquid outlet 34053 of the first liquid storage tank and the second liquid outlet connector 51a, and the second water pump 38b is connected between the second liquid outlet 34053 of the first liquid storage tank and the second liquid outlet connector 51b. Therefore, a connection pipe between the second water pump 38a and the liquid cooling cable 36a and a connection pipe between the second water pump 38b and the liquid cooling cable 36b are independent of each other.

In the foregoing technical solution, each second water pump 38 located in the liquid cooling device 50 is connected, through an independent pipe, to a liquid cooling cable 36 connected to a corresponding charging connector 31 located in the charging device 40. This can avoid mutual impact between connection pipes between different second water pumps 38 and corresponding liquid cooling cables 36. Further, reliability of heat dissipation performed by the thermal management system 34 on the liquid cooling cables 36 connected to the plurality of groups of charging connectors 31 in the charging pile 30 can be improved. In addition, all the first water pump 37 and the plurality of second water pumps 38 are disposed in the liquid cooling device 50. This further facilitates an integrated design of the liquid cooling device 50.

In another example, as shown in FIG. 12, the plurality of second water pumps 38 corresponding to the plurality of groups of charging connectors 31 are located in the charging device 40. Each second water pump 38 is connected between the liquid inlet 361 of the corresponding liquid cooling cable and a first liquid injection port 44 connected to the corresponding liquid cooling cable 36, or each second water pump 38 is connected between the liquid outlet 362 of the corresponding liquid cooling cable and a first liquid return port 45 connected to the corresponding liquid cooling cable 36.

For example, as shown in FIG. 12, the charging pile 30 shown in FIG. 10 includes the liquid cooling cable 36a and the liquid cooling cable 36b that are connected to the two groups of charging connectors 31, and the corresponding second water pump 38a and second water pump 38b. The liquid cooling device 50 includes a second liquid outlet connector 51a, a second liquid outlet connector 51b, a second liquid inlet connector 52a, and a second liquid inlet connector 52b, and the charging device 40 includes a first liquid injection port 44a, a first liquid injection port 44b, a first liquid return port 45a, and a first liquid return port 45b. For a specific connection relationship between the liquid cooling cable 36a and the liquid cooling cable 36b, refer to the embodiment shown in FIG. 11. Details are not described herein again.

The second water pump 38a and the second water pump 38b are located in the charging device 40 and respectively correspond to the liquid cooling cable 36a and the liquid cooling cable 36b. For example, the second water pump 38a is connected between the first liquid injection port 44a and the liquid inlet 361a of the liquid cooling cable in the liquid cooling cable 36a, and the second water pump 38b is connected between the first liquid injection port 44b and the liquid inlet 361b of the liquid cooling cable in the liquid cooling cable 36b. Therefore, a connection pipe between the second water pump 38a and the thermal management system 34 and a connection pipe between the second water pump 38b and the thermal management system 34 are separately disposed.

In the foregoing technical solution, each second water pump 38 located in the charging device 40 is connected, through an independent pipe, to the thermal management system 34 located in the liquid cooling device 50. This can avoid mutual impact between connection pipes between different second water pumps 38 and the thermal management system 34. Further, reliability of heat dissipation performed by the thermal management system 34 on the liquid cooling cables 36 connected to the plurality of groups of charging connectors 31 in the charging pile 30 can be improved.

In addition, the first water pump 37 is disposed in the liquid cooling device 50, and the plurality of second water pumps 38 are disposed in the charging device 40, so that the first water pump 37 and the plurality of second water pumps 38 are decoupled. This can reduce mutual impact of a performance difference between the first water pump 37 and the plurality of second water pumps 38, and reduce logic complexity of flow distribution and abnormal working condition protection performed by the charging pile 30 on the first water pump 37 and the plurality of second water pumps 38.

Still refer to FIG. 11 and FIG. 12. In some embodiments, when the third heat exchanger 39 is located in the charging device 40, the second coolant path 391 of the third heat exchanger 39 is connected to the thermal management system 34 located in the liquid cooling device 50 through any first liquid injection port 44 and any first liquid return port 45. Alternatively, the second coolant path 391 of the third heat exchanger 39 is connected to the thermal management system 34 located in the liquid cooling device 50 through the second liquid injection port 48 and the second liquid return port 49 that are separately disposed in the charging device 40. For specific descriptions, refer to the embodiments shown in FIG. 7 to FIG. 9. Details are not described herein again.

The foregoing describes, with reference to the accompanying drawings, a specific manner of disposing the second water pump 38 disposed between the thermal management system 34 and the liquid cooling cable 36. The following continues to describe another structure of the charging pile 30 with reference to the accompanying drawings.

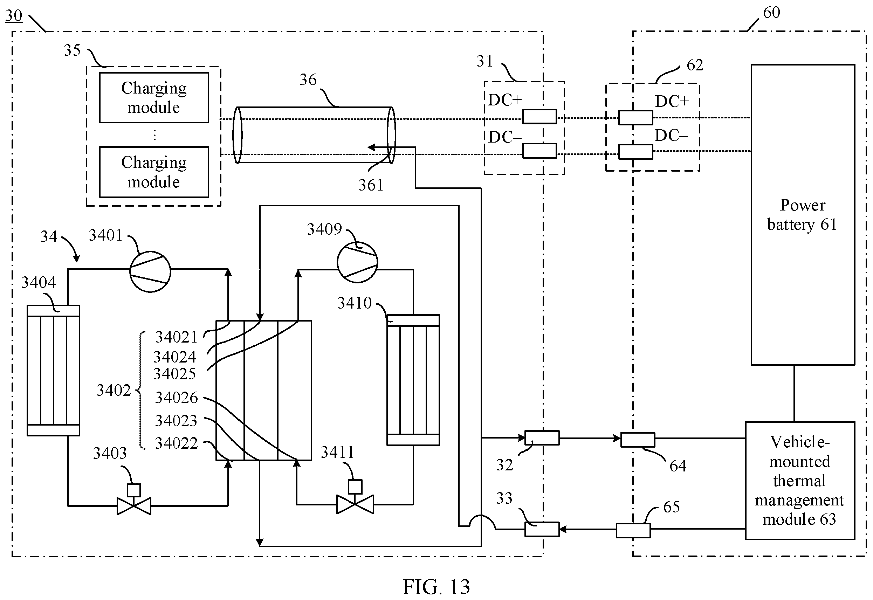

FIG. 13 is a diagram of a structure of another charging pile 30 according to an embodiment of this application.

Different from the embodiments shown in FIG. 3 to FIG. 12, in the charging pile 30 shown in FIG. 13, the thermal management system 34 may form two refrigerant loops via a first heat exchanger 3402.

Specifically, the thermal management system 34 further includes a second compressor 3409, a second expansion valve 3411, and a fourth heat exchanger 3410. The second compressor 3409, the first heat exchanger 3402, the second expansion valve 3411, and the fourth heat exchanger 3410 are sequentially connected through a refrigerant pipe. The first heat exchanger 3402 further includes a second refrigerant path, and the second refrigerant path is connected between the second compressor 3409 and the second expansion valve 3411. Similar to the first refrigerant path, the second refrigerant path is also configured to perform heat exchange with the first coolant path.

Specifically, a liquid outlet 34025 of the second refrigerant path is connected to an inlet of the second compressor 3409, an outlet of the second compressor 3409 is connected to a liquid inlet of the fourth heat exchanger 3410, a liquid outlet of the fourth heat exchanger 3410 is connected to a first valve port of the second expansion valve 3411 (for example, a right valve port of the second expansion valve 3411 shown in FIG. 13), and a second valve port of the second expansion valve 3411 (for example, a left valve port of the second expansion valve 3411 shown in FIG. 13) is connected to a liquid inlet 34026 of the second refrigerant path.

During specific implementation, refrigerant sequentially circulates along the second compressor 3409, the fourth heat exchanger 3410, the second expansion valve 3411, and the second refrigerant path of the first heat exchanger 3402, and the thermal management system 34 operates in a refrigeration mode. In this case, a refrigerant circulation loop is formed between the first compressor 3401, the second heat exchanger 3404, the first expansion valve 3403, and the first refrigerant path of the first heat exchanger 3402, and another refrigerant circulation loop is formed between the second compressor 3409, the fourth heat exchanger 3410, the second expansion valve 3411, and the second refrigerant path of the first heat exchanger 3402.

Based on the foregoing design, both the two refrigerant loops may be configured to cool coolant flowing in the first coolant path of the first heat exchanger 3402, to improve heat dissipation efficiency of the coolant in the first coolant path. Further, heat dissipation efficiency of the thermal management system 34 for a power battery 61 of an electric vehicle 60 and a liquid cooling cable 36 connected to each group of charging connectors 31 can be improved.

For example, the fourth heat exchanger 3410 may be a condenser.

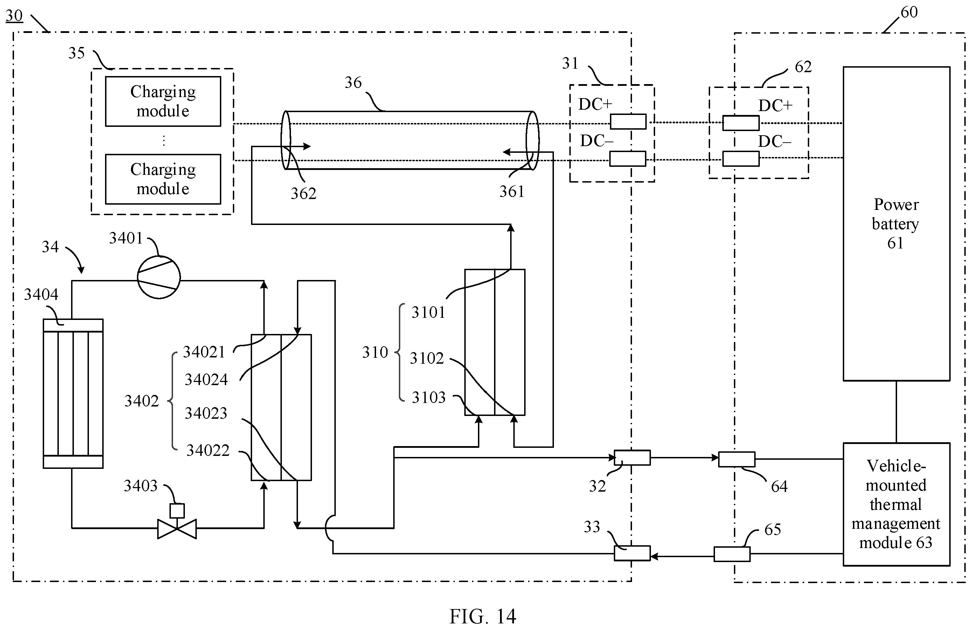

FIG. 14 is a diagram of a structure of still another charging pile 30 according to an embodiment of this application.

Different from the embodiments shown in FIG. 3 to FIG. 13, in the embodiment shown in FIG. 14, to avoid mutual doping of coolant in a thermal management system 34 and coolant in a liquid cooling cable 36, the charging pile 30 further includes one or more fifth heat exchangers configured to isolate the coolant in the thermal management system 34 and the coolant in the liquid cooling cable 36.

Specifically, as shown in FIG. 14, the charging pile 30 includes one or more groups of charging connectors 31, a first liquid outlet connector 32, a first liquid inlet connector 33, the thermal management system 34, and one or more fifth heat exchangers 310. Each group of charging connectors 31 is configured to output electric energy to an electric vehicle 60, the first liquid outlet connector 32 is configured to connect to a liquid injection port 64 of the electric vehicle, and the first liquid inlet connector 33 is configured to connect to a liquid return port 65 of the electric vehicle.

The thermal management system 34 includes a first compressor 3401, a first heat exchanger 3402, a first expansion valve 3403, and a second heat exchanger 3404 that are sequentially connected. A first refrigerant path of the first heat exchanger 3402 is connected between the first compressor 3401 and the first expansion valve 3403. A liquid outlet 34023 of a first coolant path of the first heat exchanger 3402 is connected to the first liquid outlet connector 32, and a liquid inlet 34024 of the first coolant path of the first heat exchanger 3402 is connected to the first liquid inlet connector 33. Further, coolant may circulate between the first heat exchanger 3402 and the electric vehicle 60, so that the thermal management system 34 can dissipate heat from a power battery 61 of the electric vehicle 60. For specific descriptions, refer to the embodiment shown in FIG. 3. Details are not described herein again.

In addition, each fifth heat exchanger 310 includes a third coolant path and a fourth coolant path, and the third coolant path is used to exchange heat with the fourth coolant path. A liquid inlet 3103 of the third coolant path in each fifth heat exchanger 310 is connected to the liquid outlet 34023 of the first coolant path in the first heat exchanger 3402. In addition, a liquid outlet 3102 of the fourth coolant path in each fifth heat exchanger 310 is connected to a liquid inlet 361 of a liquid cooling cable connected to at least one of the one or more groups of charging connectors 31 of the charging pile 30. A liquid inlet 3101 of the fourth coolant path in each fifth heat exchanger 310 is connected to a liquid outlet 362 of a liquid cooling cable connected to at least one of the one or more groups of charging connectors 31 of the charging pile 30.

It should be understood that a specific connection manner between fourth coolant paths of the one or more fifth heat exchangers 310 and liquid cooling cables 36 connected to the one or more groups of charging connectors 31 is described below, and the foregoing is merely a brief description.

In the foregoing technical solution, the coolant in the liquid cooling cable 36 may circulate in the fourth coolant path in the fifth heat exchanger 310, and the thermal management system 34 may provide the coolant to the third coolant path in the fifth heat exchanger 310, to absorb heat of the coolant in the fourth coolant path, so that the thermal management system 34 can dissipate heat from the liquid cooling cable 36. In addition, because the coolant in the thermal management system 34 and the coolant in the liquid cooling cable 36 flow in different paths of the fifth heat exchanger 310, doping of the coolant in the thermal management system 34 and the coolant in the liquid cooling cable 36 can be avoided. This helps improve cleanliness of the coolant in the thermal management system 34 and the coolant in the liquid cooling cable 36.

It should be understood that, to implement cyclic heat dissipation on the liquid cooling cable 36 by the thermal management system 34, coolant that absorbs heat in the third coolant path of the fifth heat exchanger 310 also flows back to the thermal management system 34. The following describes, with reference to the accompanying drawings, a specific manner in which the coolant in the third coolant path flows back to the thermal management system 34.

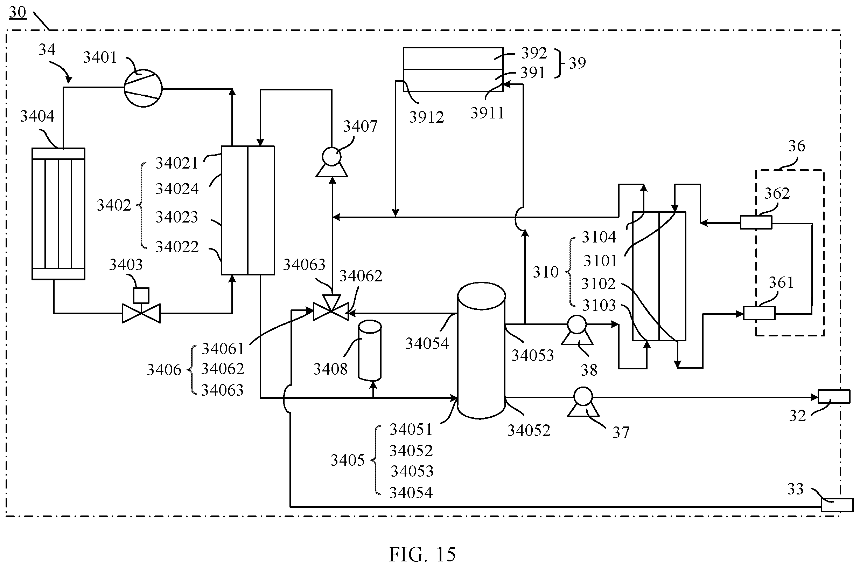

FIG. 15 to FIG. 17 each are a diagram of an example of a specific structure of the charging pile 30 shown in FIG. 14 according to an embodiment of this application.

With reference to FIG. 15 to FIG. 17, in some embodiments, the thermal management system 34 further includes a first liquid storage tank 3405. The liquid outlet 34023 of the first coolant path is connected to the first liquid outlet connector 32 and the liquid inlet 3103 of the third coolant path in each fifth heat exchanger 310 via the first liquid storage tank 3405.

During specific implementation, a first liquid inlet 34051 of the first liquid storage tank is connected to the liquid outlet 34023 of the first coolant path, a first liquid outlet 34052 of the first liquid storage tank is connected to the first liquid outlet connector 32, and a second liquid outlet 34053 of the first liquid storage tank is connected to the liquid inlet 3103 of the third coolant path in each fifth heat exchanger 310.

Based on the foregoing design, the cooled coolant in the first coolant path of the first heat exchanger 3402 may flow into the first liquid storage tank 3405 in advance for storage. When the electric vehicle 60 and/or the liquid cooling cable 36 connected to the charging connector 31 need/needs to dissipate heat, the coolant whose temperature decreases and that is stored in the first liquid storage tank 3405 may quickly flow into the electric vehicle 60 and/or the fifth heat exchanger 310. This helps improve timeliness of performing heat dissipation by the thermal management system 34 on the power battery 61 of the electric vehicle 60 and the liquid cooling cable 36 connected to the charging connector 31, and further improves efficiency of charging the power battery 61 by the charging pile 30.

In an example, as shown in FIG. 15, a liquid outlet 3104 of the third coolant path in each fifth heat exchanger 310 is connected to the liquid inlet 34024 of the first coolant path. In this way, a coolant circulation loop is formed between the third coolant path in each fifth heat exchanger 310, the first liquid storage tank 3405, and the first heat exchanger 3402.

In the foregoing technical solution, the coolant flowing back to the fifth heat exchanger 310 flows into the first liquid storage tank 3405 after being cooled by the first heat exchanger 3402. Therefore, coolant in the first liquid storage tank 3405 can maintain a low temperature, so that the first liquid storage tank 3405 has a good cold storage capability.

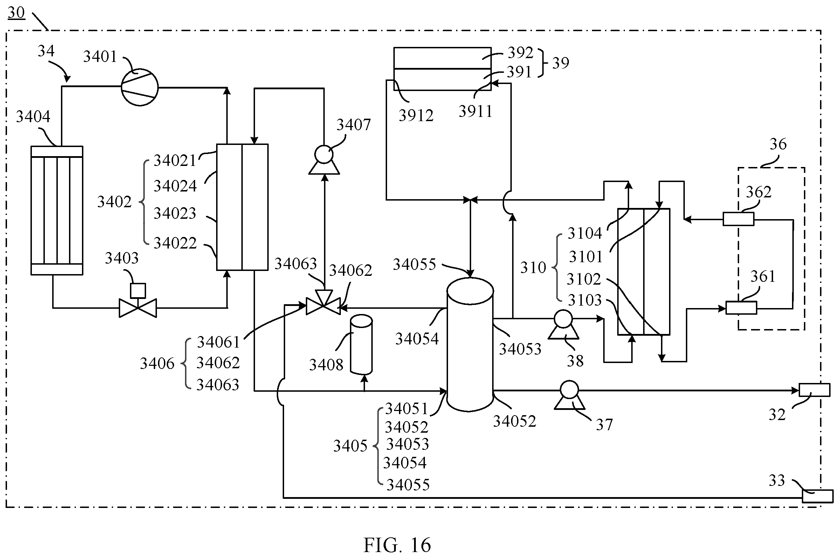

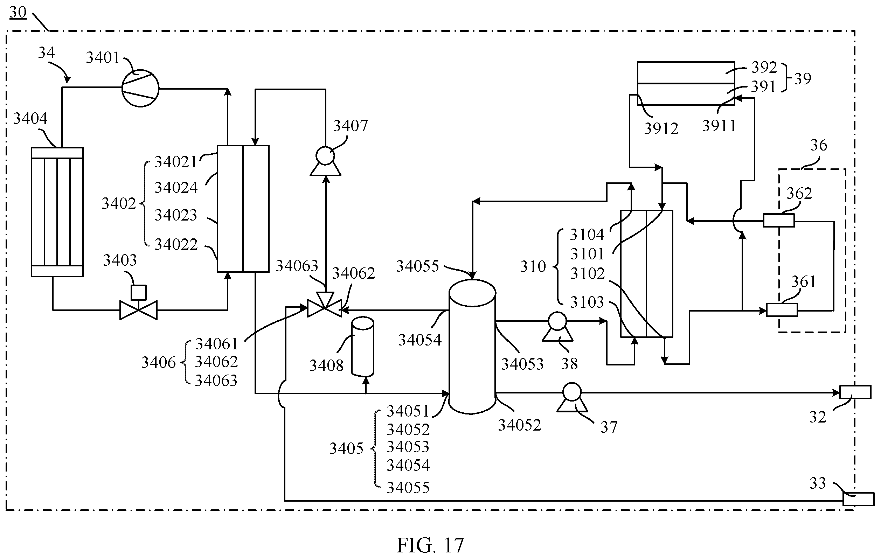

In another example, as shown in FIG. 16 and FIG. 17, the liquid outlet 3104 of the third coolant path in each fifth heat exchanger 310 is connected to a second liquid inlet 34055 of the first liquid storage tank. In this way, the coolant in the third coolant path may flow back to the first liquid storage tank 3405 through the second liquid inlet 34055 of the first liquid storage tank, and is mixed with the coolant that flows into the first liquid storage tank 3405 through the first coolant path. Further, the second liquid outlet 34053 of the first liquid storage tank flows into the third coolant path again.

In the foregoing technical solution, a coolant circulation loop is directly and independently formed between the third coolant path of each fifth heat exchanger 310 and the first liquid storage tank 3405. This helps improve performing heat dissipation on the liquid cooling cable 36 by the thermal management system 34 via the fifth heat exchanger 310.

It should be understood that, for a part that is not described in detail about the thermal management system 34, refer to related descriptions in the embodiments shown in FIG. 3 and FIG. 4. Details are not described herein again.

Still refer to FIG. 15 to FIG. 17. In some embodiments, to enable the coolant in the thermal management system 34 to flow into the electric vehicle 60 and the third coolant path of each fifth heat exchanger 310, the charging pile 30 further includes one first water pump 37 and one or more second water pumps 38.

The first water pump 37 is connected between the first liquid outlet 34052 of the first liquid storage tank and the first liquid outlet connector 32.

The one or more second water pumps 38 are in a one-to-one correspondence with the one or more fifth heat exchangers 310. Each second water pump 38 is connected between the second liquid outlet 34053 of the first liquid storage tank and a liquid inlet 3103 of a third coolant path in a corresponding fifth heat exchanger 310, or each second water pump 38 is connected between the second liquid inlet 34055 of the first liquid storage tank and a liquid outlet 3104 of a third coolant path in a corresponding fifth heat exchanger 310, or each second water pump 38 is connected between the liquid inlet 34024 of the first coolant path and a liquid outlet 3104 of a third coolant path in a corresponding fifth heat exchanger 310. In other words, the charging pile 30 includes the second water pumps 38 whose quantity is equal to a quantity of the fifth heat exchangers 310, so that the thermal management system 34 is connected to all the fifth heat exchangers 310 via different second water pumps 38.

For example, FIG. 15 to FIG. 17 each show an example in which the charging pile 30 includes one second water pump 38 and one fifth heat exchanger 310, and the second water pump 38 is connected between the second liquid outlet 34053 of the first liquid storage tank and the liquid inlet 3103 of the third coolant path of the fifth heat exchanger 310.

In the foregoing technical solution, the thermal management system 34 in the charging pile 30 is connected to all the fifth heat exchangers 310 via different second water pumps 38, so that the thermal management system 34 dissipates, via different second water pumps 38, heat from liquid cooling cables 36 connected to all the fifth heat exchanger 310. Therefore, when any second water pump 38 is faulty, that the thermal management system 34 provides coolant to a fifth heat exchanger 310 connected to another second water pump 38 may not be affected. Further, reliability of heat dissipation performed by the thermal management system 34 on the liquid cooling cables 36 connected to the plurality of groups of charging connectors 31 in the charging pile 30 can be improved.

In the foregoing technical solution, the coolant in the thermal management system 34 can flow to the third coolant path of each fifth heat exchanger 310 via one second water pump 38. This can implement heat dissipation on the liquid cooling cable 36 connected to each group of charging connectors 31 by the thermal management system 34, and further reduce complexity of a pipe connection in the charging pile 30. In addition, a small quantity of second water pumps 38 can also reduce an increase in costs of the charging pile 30. This helps optimize costs of the charging pile 30.

Still refer to FIG. 15 to FIG. 17. In some embodiments, the charging pile 30 further includes a switch (not shown in the figure) and a third heat exchanger 39. Each group of charging connectors 31 in the charging pile 30 is connected to output ends of a plurality of charging modules 35 via the switch. The third heat exchanger 39 includes a second coolant path 391 and a first gas path 392. The second coolant path 391 is configured to exchange heat with the first gas path 392. An inlet of the first gas path 392 and an outlet of the first gas path 392 are connected to an environment in which the switch is located.

In an example, as shown in FIG. 15, a liquid inlet 3911 of the second coolant path is connected to the second liquid outlet 34053 of the first liquid storage tank, and a liquid outlet 3912 of the second coolant path is connected to the liquid inlet 34024 of the first coolant path. Alternatively, as shown in FIG. 16, a liquid inlet 3911 of the second coolant path is connected to the second liquid outlet 34053 of the first liquid storage tank, and a liquid outlet 3912 of the second coolant path is connected to the second liquid inlet 34055 of the first liquid storage tank.

Based on the foregoing design, the thermal management system 34 may not only be configured to dissipate heat from the power battery 61 and the liquid cooling cable 36 connected to the charging connector 31, but also be configured to dissipate heat from the switch in the power distribution cabin. This can further improve utilization of the thermal management system 34, and further facilitate cost optimization of the charging pile 30.

In still another example, as shown in FIG. 17, the liquid inlet 3911 of the second coolant path is connected to the liquid outlet 3102 of the fourth coolant path of the fifth heat exchanger 310 in the charging pile 30, and the liquid outlet 3912 of the second coolant path is connected to the liquid inlet 3101 of the fourth coolant path of the fifth heat exchanger 310.

Based on the foregoing design, when the thermal management system 34 is configured to dissipate heat from the switch in the power distribution cabin, doping of the coolant in the thermal management system 34 and the coolant in the third heat exchanger 39 can be avoided. This helps improve cleanliness of the coolant in the thermal management system 34 and the coolant in the third heat exchanger 39.

It should be understood that, for specific descriptions of the switch and the third heat exchanger 39, refer to related descriptions in the embodiments shown in FIG. 3 to FIG. 5. Details are not described herein again.

The following describes a specific connection manner between the one or more fifth heat exchangers 310 and the liquid cooling cables 36 connected to the one or more groups of charging connectors 31.

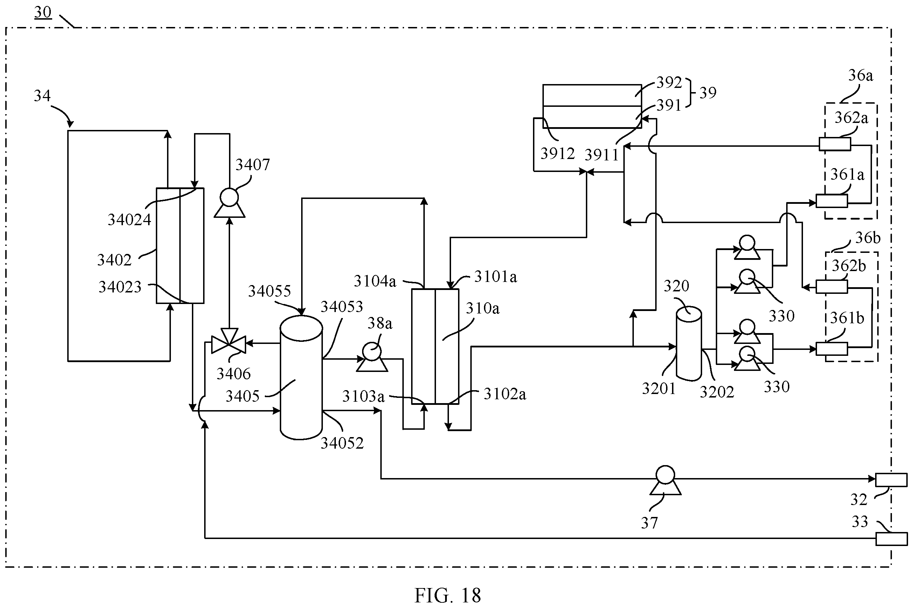

FIG. 18 is a diagram of an example of a specific structure of the charging pile 30 shown in FIG. 14 according to an embodiment of this application.

Refer to FIG. 18. In some embodiments, the charging pile 30 includes one fifth heat exchanger 310, that is, includes a fifth heat exchanger 310a.

A liquid outlet 3102a of a fourth coolant path in the fifth heat exchanger 310a is connected to the liquid inlet 361 of the liquid cooling cable connected to each group of charging connectors 31 in the charging pile 30, and a liquid inlet 3101a of the fourth coolant path in the fifth heat exchanger 310a is connected to the liquid outlet 362 of the liquid cooling cable connected to each group of charging connectors 31 in the charging pile 30.

For example, as shown in FIG. 18, the charging pile 30 includes a liquid cooling cable 36a and a liquid cooling cable 36b that are connected to two groups of charging connectors 31. A liquid inlet 3103a of a third coolant path in the fifth heat exchanger 310a is connected to the second liquid outlet 34053 of the first liquid storage tank, a liquid outlet 3104a of the third coolant path in the fifth heat exchanger 310a is connected to the second liquid inlet 34055 of the first liquid storage tank, and a second water pump 38a corresponding to the fifth heat exchanger 310a is connected between the second liquid outlet 34053 of the first liquid storage tank and the liquid inlet 3103a of the third coolant path in the fifth heat exchanger 310a.

In addition, the liquid outlet 3102a of the fourth coolant path in the fifth heat exchanger 310a is connected to a liquid inlet 361a of the liquid cooling cable in the liquid cooling cable 36a and a liquid inlet 361b of the liquid cooling cable in the liquid cooling cable 36b. The liquid inlet 3101a of the fourth coolant path in the fifth heat exchanger 310a is connected to a liquid outlet 362a of the liquid cooling cable in the liquid cooling cable 36a and a liquid outlet 362b of the liquid cooling cable in the liquid cooling cable 36b. Therefore, the thermal management system 34 may dissipate heat from the liquid cooling cable 36a and the liquid cooling cable 36b via the fifth heat exchanger 310a.

Based on the foregoing design, the thermal management system 34 can dissipate, via one fifth heat exchanger 310, that is, the fifth heat exchanger 310a, heat from the liquid cooling cable 36 connected to each group of charging connectors 31 in the charging pile 30, and a small quantity of fifth heat exchangers 310 may be disposed in the charging pile 30. In this way, complexity of a pipe connection in the charging pile 30 can be reduced, an increase in costs of the charging pile 30 can be reduced, and cost optimization of the charging pile 30 can be facilitated.

It should be understood that, during actual application, when the thermal management system 34 is located in the liquid cooling device 50, and the plurality of charging modules 35 and each group of charging connectors 31 are located in the charging device 40, the fifth heat exchanger 310a may be disposed in the liquid cooling device 50, or the fifth heat exchanger 310a may be disposed in the charging device 40.

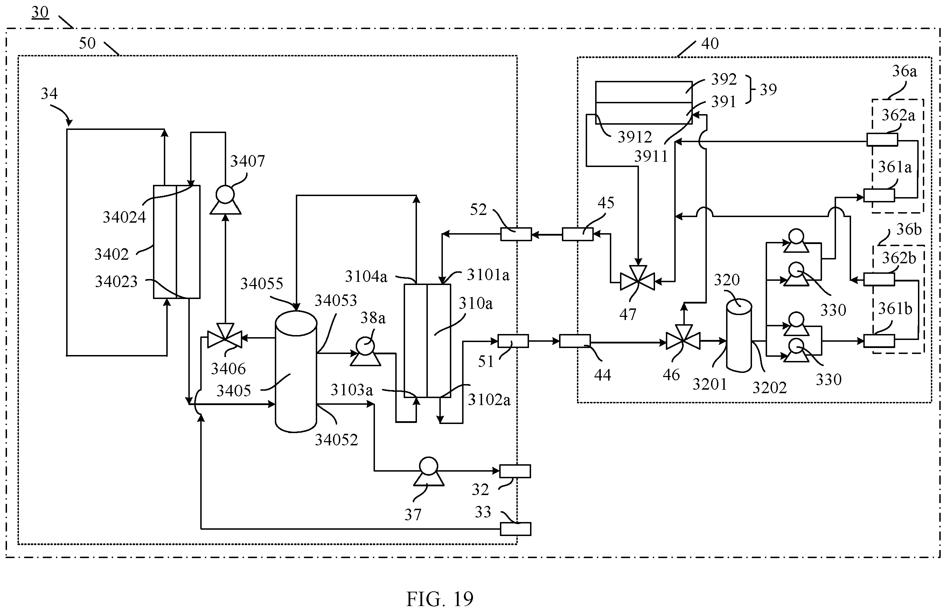

FIG. 19 to FIG. 22 each show an example of a specific disposing position of the fifth heat exchanger 310a shown in FIG. 18 in the charging pile 30.

In some embodiments, with reference to FIG. 19 to FIG. 22, when the charging pile 30 includes one fifth heat exchanger 310, that is, includes the fifth heat exchanger 310a, the liquid cooling device 50 includes one second liquid outlet connector 51 and one second liquid inlet connector 52, and the charging device 40 includes one first liquid injection port 44 and one first liquid return port 45. The second liquid outlet connector 51 is connected to the first liquid injection port 44, and the second liquid inlet connector 52 is connected to the first liquid return port 45.

In an example, as shown in FIG. 19, the fifth heat exchanger 310a is located in the liquid cooling device 50. The liquid outlet 3102a of the fourth coolant path in the fifth heat exchanger 310a is connected to the second liquid outlet connector 51, and the liquid inlet 3101a of the fourth coolant path in the fifth heat exchanger 310a is connected to the second liquid inlet connector 52. In addition, the first liquid injection port 44 is connected to the liquid inlet 361 of the liquid cooling cable connected to each group of charging connectors 31, and the first liquid return port 45 is connected to the liquid outlet 362 of the liquid cooling cable connected to each group of charging connectors 31.

For example, as shown in FIG. 19, the charging pile 30 includes the liquid cooling cable 36a and the liquid cooling cable 36b that are connected to the two groups of charging connectors 31. The first liquid injection port 44 is connected to the liquid inlet 361a of the liquid cooling cable in the liquid cooling cable 36a and the liquid inlet 361b of the liquid cooling cable in the liquid cooling cable 36b, and the first liquid return port 45 is connected to the liquid outlet 362a of the liquid cooling cable in the liquid cooling cable 36a and the liquid outlet 362b of the liquid cooling cable in the liquid cooling cable 36b.

Based on the foregoing design, the fifth heat exchanger 310a located in the liquid cooling device 50 is connected to the liquid cooling cable 36 connected to each group of charging connectors 31 in the charging device 40 through a coordinated connection between a group of connectors in the liquid cooling device 50 and a group of interfaces in the charging device 40. This can reduce complexity of a pipe connection between the liquid cooling device 50 and the charging device 40, and facilitate cost optimization of the charging pile 30.

It should be understood that, when the fifth heat exchanger 310a is located in the liquid cooling device 50, the second water pump 38a corresponding to the fifth heat exchanger 310a is also located in the liquid cooling device 50. Therefore, all the first water pump 37, the second water pump 38a, and the fifth heat exchanger 310a are disposed in the liquid cooling device 50. This facilitates an integrated design of the liquid cooling device 50.

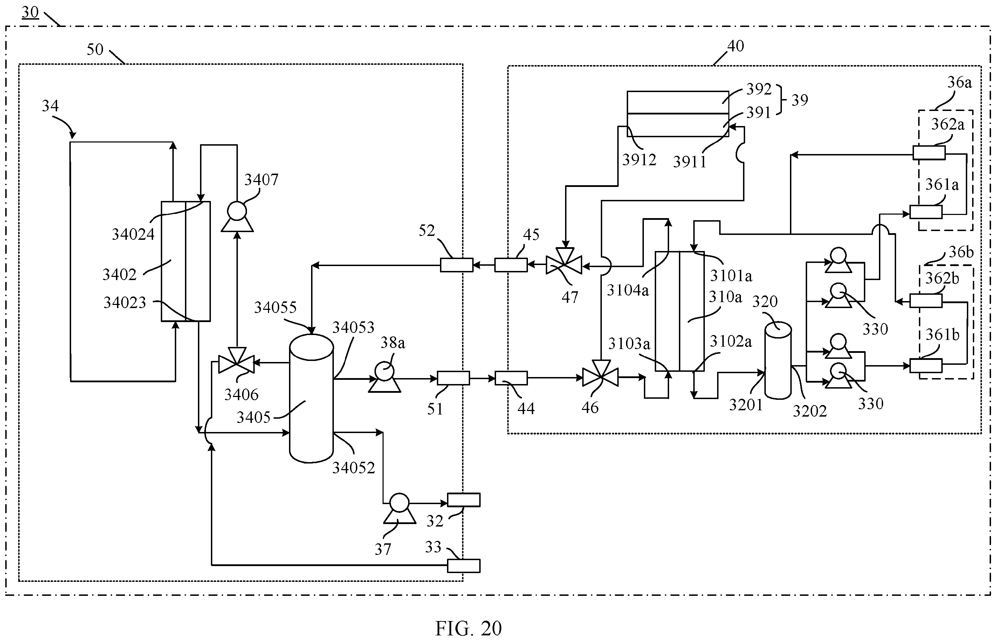

In another example, as shown in FIG. 20 to FIG. 22, the fifth heat exchanger 310a is located in the charging device 40. The second liquid outlet connector 51 is connected to the second liquid outlet 34053 of the first liquid storage tank. The second liquid inlet connector 52 is connected to the second liquid inlet 34055 of the first liquid storage tank, or the second liquid inlet connector 52 is connected to the liquid inlet 34024 of the first coolant path of the first heat exchanger 3402. In addition, the first liquid injection port 44 is connected to the liquid inlet 3103a of the third coolant path in the fifth heat exchanger 310a, and the first liquid return port 45 is connected to the liquid outlet 3104a of the third coolant path in the fifth heat exchanger 310a.

Based on the foregoing design, the fifth heat exchanger 310a located in the charging device 40 is connected to the thermal management system 34 in the liquid cooling device 50 through a coordinated connection between a group of connectors in the liquid cooling device 50 and a group of interfaces in the charging device 40. This can reduce complexity of a pipe connection between the liquid cooling device 50 and the charging device 40, and facilitate cost optimization of the charging pile 30.

It should be understood that, when the fifth heat exchanger 310a is located in the charging device 40, the second water pump 38a corresponding to the fifth heat exchanger 310a may be located in the liquid cooling device 50 or the charging device 40.

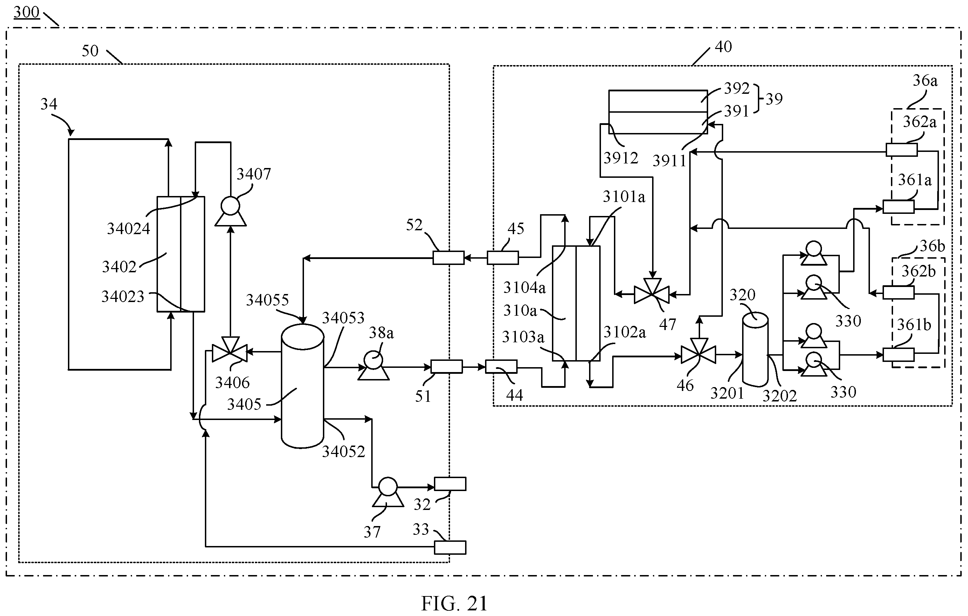

For example, as shown in FIG. 20 and FIG. 21, the second water pump 38a is located in the liquid cooling device 50. The second water pump 38a is connected between the second liquid outlet 34053 of the first liquid storage tank and the second liquid outlet connector 51, or the second water pump 38a is connected between the second liquid inlet 34055 of the first liquid storage tank and the second liquid inlet connector 52, or the second water pump 38a is connected between the liquid inlet 34024 of the first coolant path and the second liquid inlet connector 52.

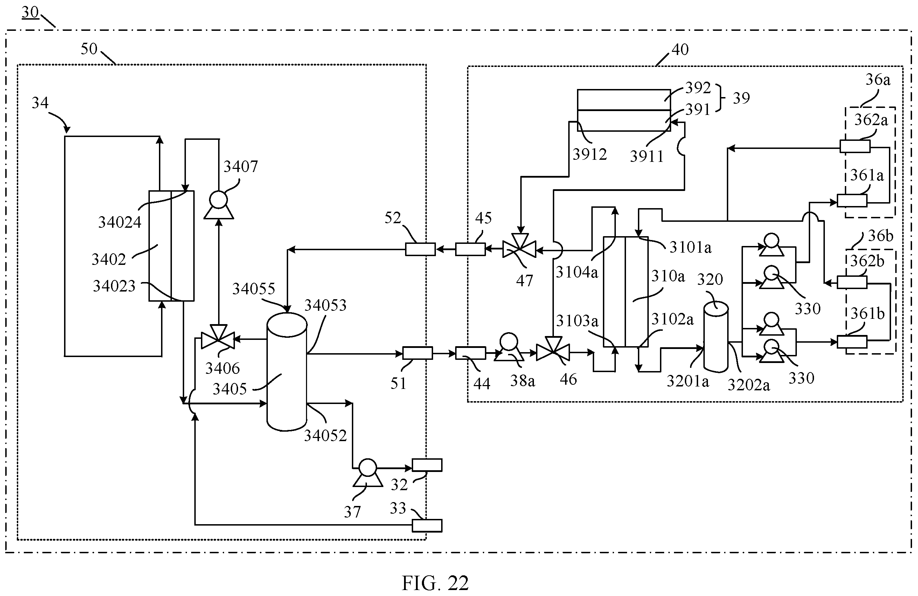

For another example, as shown in FIG. 22, the second water pump 38a is located in the charging device 40. The second water pump 38a is connected between the first liquid injection port 44 and the liquid inlet 3103a of the third coolant path in the fifth heat exchanger 310a, or the second water pump 38a is connected between the first liquid return port 45 and the liquid outlet 3104a of the third coolant path in the fifth heat exchanger 310a.

In the foregoing technical solution, when the fifth heat exchanger 310a is located in the charging device 40, the second water pump 38a corresponding to the fifth heat exchanger 310a may be disposed in the liquid cooling device 50 or the charging device 40. This helps improve flexibility of disposing the second water pump 38 in the charging pile 30.

Still refer to FIG. 19 to FIG. 22. In this embodiment of this application, the third heat exchanger 39 may also be located in the charging device 40.

In an example, as shown in FIG. 19, when the fifth heat exchanger 310a is located in the liquid cooling device 50, the liquid cooling device 50 includes one second liquid outlet connector 51 and one second liquid inlet connector 52, and the charging device 40 includes one first liquid injection port 44 and one first liquid return port 45, the liquid inlet 3911 of the second coolant path in the third heat exchanger 39 is connected to the first liquid injection port 44, and the liquid outlet 3912 of the second coolant path is connected to the first liquid return port 45. In this way, the second coolant path 391 is connected to the fourth coolant path of the fifth heat exchanger 310a in the liquid cooling device 50 through a coordinated connection between a group of connectors in the liquid cooling device 50 and a group of interfaces in the charging device 40.

In the foregoing technical solution, the liquid cooling cable 36 connected to each group of charging connectors 31 in the charging device 40 and the third heat exchanger 39 share a group of interfaces to connect to the fifth heat exchanger 310a in the liquid cooling device 50. In this way, the thermal management system 34 can dissipate heat from the liquid cooling cable 36 and the switch in the power distribution cabin via the fifth heat exchanger 310a, complexity of a pipe connection between the charging device 40 and the liquid cooling device 50 can be further reduced, and cost optimization of the charging pile 30 is facilitated.

In another example, as shown in FIG. 20 and FIG. 22, when the fifth heat exchanger 310a is located in the charging device 40, the liquid cooling device 50 includes one second liquid outlet connector 51 and one second liquid inlet connector 52, and the charging device 40 includes one first liquid injection port 44 and one first liquid return port 45, the liquid inlet 3911 of the second coolant path in the third heat exchanger 39 is connected to the first liquid injection port 44, and the liquid outlet 3912 of the second coolant path is connected to the first liquid return port 45. In this way, the second coolant path 391 is connected to the thermal management system 34 in the liquid cooling device 50 through a coordinated connection between a group of connectors in the liquid cooling device 50 and a group of interfaces in the charging device 40.

In the foregoing technical solution, the fifth heat exchanger 310a in the charging device 40 and the third heat exchanger 39 share a group of interfaces to connect to the thermal management system 34 in the liquid cooling device 50. In this way, the thermal management system 34 can dissipate heat from the liquid cooling cable 36 and the switch in the power distribution cabin, complexity of a pipe connection between the charging device 40 and the liquid cooling device 50 can be further reduced, and cost optimization of the charging pile 30 is facilitated.

In still another example, as shown in FIG. 21, when the fifth heat exchanger 310a is located in the charging device 40, the liquid cooling device 50 includes one second liquid outlet connector 51 and one second liquid inlet connector 52, and the charging device 40 includes one first liquid injection port 44 and one first liquid return port 45, the liquid inlet 3911 of the second coolant path in the third heat exchanger 39 is connected to the liquid outlet 3102a of the fourth coolant path in the fifth heat exchanger 310a, and the liquid outlet 3912 of the second coolant path in the third heat exchanger 39 is connected to the liquid inlet 3101a of the fourth coolant path in the fifth heat exchanger 310a.

Based on the foregoing design, when the thermal management system 34 is configured to dissipate heat from the switch in the power distribution cabin, doping of the coolant in the thermal management system 34 and the coolant in the third radiator 39 can be avoided. This helps improve cleanliness of the coolant in the thermal management system 34 and the coolant in the third heat exchanger 39.

During specific implementation, as shown in FIG. 19 to FIG. 22, the coolant flowing into the charging device 40 may be divided into two paths via the second three-way valve 46. One path flows into the second coolant path 391, and the other path flows into the fifth heat exchanger 310a or the liquid cooling cable 36. Similarly, the coolant flowing out of the second coolant path 391 and the coolant flowing out of the fifth heat exchanger 310a may be collected into one path via the second three-way valve 47, or the coolant flowing out of the second coolant path 391 and the coolant flowing out of the liquid cooling cable 36 may be collected into one path via the second three-way valve 47, so that the coolant flows back to the liquid cooling device 50 through the first liquid return port 45. For specific descriptions, refer to the embodiments shown in FIG. 7 and FIG. 8. Details are not described herein again.

The foregoing describes, with reference to the accompanying drawings, a case in which the charging pile 30 shown in FIG. 18 includes one fifth heat exchanger 310. The following describes, with reference to the accompanying drawings, a case in which the charging pile 30 includes a plurality of fifth heat exchangers 310.

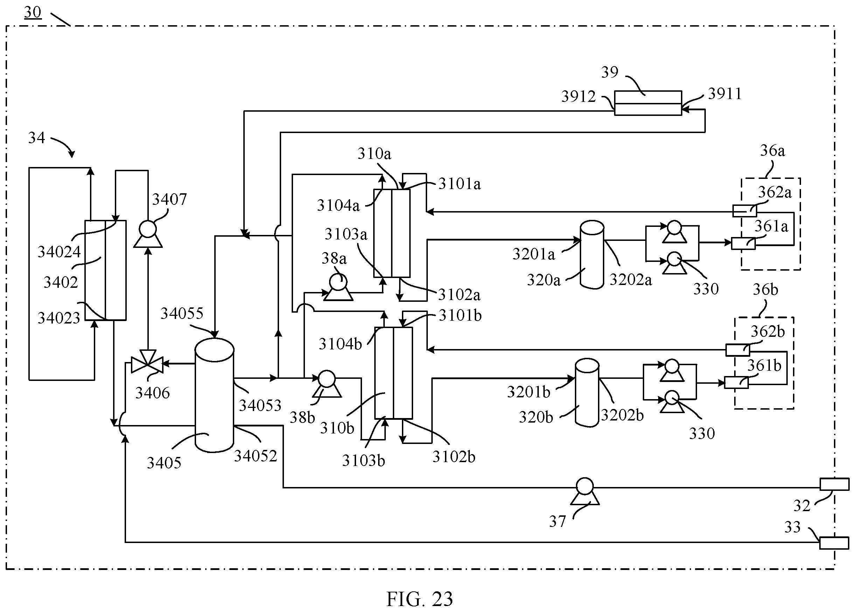

FIG. 23 is a diagram of an example of a specific structure of the charging pile 30 shown in FIG. 14 according to an embodiment of this application.

Different from the embodiments shown in FIG. 18 to FIG. 22, in the embodiment shown in FIG. 23, the charging pile 30 includes a plurality of fifth heat exchangers 310 and a plurality of groups of charging connectors 31. The plurality of fifth heat exchangers 310 are in a one-to-one correspondence with the plurality of groups of charging connectors 31, that is, the plurality of fifth heat exchangers 310 are in a one-to-one correspondence with the liquid cooling cables 36 connected to the plurality of groups of charging connectors 31. The liquid outlet 3102 of the fourth coolant path in each fifth heat exchanger 310 is connected to a liquid inlet 361 of a corresponding liquid cooling cable, and the liquid inlet 3101 of the fourth coolant path in each fifth heat exchanger 310 is connected to a liquid outlet 362 of the corresponding liquid cooling cable.

For example, as shown in FIG. 23, the charging pile 30 still includes the liquid cooling cable 36a and the liquid cooling cable 36b that are connected to the two groups of charging connectors 31. The charging pile 30 further includes two fifth heat exchangers 310, that is, includes a fifth heat exchanger 310a and a fifth heat exchanger 310b. A liquid inlet 3103a of a third coolant path in the fifth heat exchanger 310a and a liquid inlet 3103b of a third coolant path in the fifth heat exchanger 310b are connected to the second liquid outlet 34053 of the first liquid storage tank, and a liquid outlet 3104a of the third coolant path in the fifth heat exchanger 310a and a liquid outlet 3104b of the third coolant path in the fifth heat exchanger 310b are connected to the second liquid inlet 34055 of the first liquid storage tank.

In addition, a liquid outlet 3102a of a fourth coolant path in the fifth heat exchanger 310a is connected to the liquid inlet 361a of the liquid cooling cable in the liquid cooling cable 36a, and a liquid inlet 3101a of the fourth coolant path in the fifth heat exchanger 310a is connected to the liquid outlet 362a of the liquid cooling cable in the liquid cooling cable 36a. Similarly, a liquid outlet 3102b of a fourth coolant path in the fifth heat exchanger 310b is connected to the liquid inlet 361b of the liquid cooling cable in the liquid cooling cable 36b, and a liquid inlet 3101b of the fourth coolant path in the fifth heat exchanger 310b is connected to the liquid outlet 362b of the liquid cooling cable in the liquid cooling cable 36b. Therefore, the thermal management system 34 separately dissipates heat from the liquid cooling cable 36a and the liquid cooling cable 36b via different fifth heat exchangers 310.

In the foregoing technical solution, the charging pile 30 includes a plurality of fifth heat exchangers 310 whose quantity is equal to a quantity of the plurality of groups of charging connectors 31, so that the thermal management system 34 can dissipate, via different fifth heat exchangers 310, heat from the liquid cooling cables 36 connected to all the groups of charging connectors 31. Therefore, when any fifth heat exchanger 310 is faulty, heat dissipation performed by the thermal management system 34 on a liquid cooling cable 36 connected to another fifth heat exchanger 310 may not be affected. Further, reliability of heat dissipation performed by the thermal management system 34 on the liquid cooling cables 36 connected to the plurality of groups of charging connectors 31 in the charging pile 30 can be improved.

It should be understood that, during actual application, when the thermal management system 34 is located in the liquid cooling device 50, and the plurality of charging modules 35 and each group of charging connectors 31 are located in the charging device 40, the plurality of fifth heat exchangers 310 may also be disposed in the liquid cooling device 50, or the plurality of fifth heat exchangers 310 may be disposed in the charging device 40.

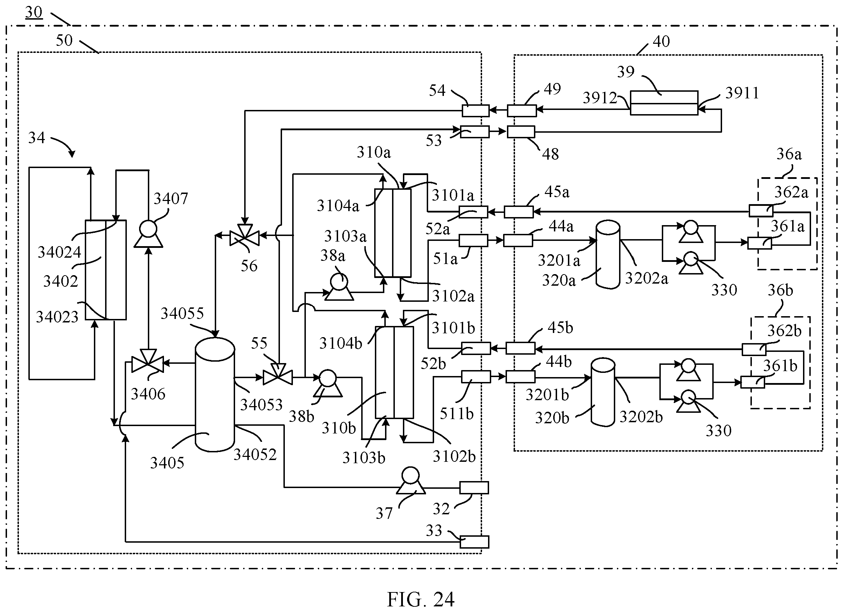

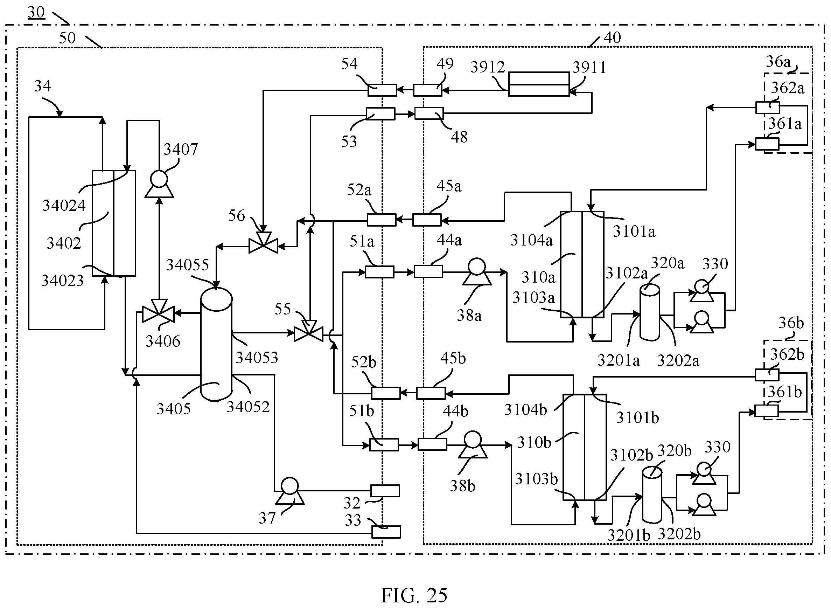

FIG. 24 and FIG. 25 each show an example of specific disposing positions of the plurality of fifth heat exchangers 310 shown in FIG. 23 in the charging pile 30.

In some embodiments, when the charging pile 30 includes a plurality of fifth heat exchangers 310 and a plurality of groups of charging connectors 31, the liquid cooling device 50 includes a plurality of second liquid outlet connectors 51 and a plurality of second liquid inlet connectors 52, and the charging device 40 includes a plurality of first liquid injection ports 44 and a plurality of first liquid return ports 45. The plurality of second liquid outlet connectors 51 are in a one-to-one correspondence with the plurality of second liquid inlet connectors 52, the plurality of second liquid outlet connectors 51 are further connected to the plurality of first liquid injection ports 44 in a one-to-one correspondence, and the plurality of second liquid inlet connectors 52 are further connected to the plurality of first liquid return ports 45 in a one-to-one correspondence.

In an example, as shown in FIG. 24, the plurality of fifth heat exchangers 310 are located in the liquid cooling device 50. Liquid outlets 3102 of fourth coolant paths of the plurality of fifth heat exchangers 310 are connected to the plurality of second liquid outlet connectors 51 in a one-to-one correspondence, and liquid inlets 3101 of the fourth coolant paths of the plurality of fifth heat exchangers are connected to the plurality of second liquid inlet connectors 52 in a one-to-one correspondence. In addition, the plurality of first liquid injection ports 44 are connected, in a one-to-one correspondence, to liquid inlets 361 of liquid cooling cables connected to the plurality of groups of charging connectors 31, and the plurality of first liquid return ports 45 are connected, in a one-to-one correspondence, to liquid outlets 362 of the liquid cooling cables connected to the plurality of groups of charging connectors 31.

For example, as shown in FIG. 24, the charging pile 30 shown in FIG. 23 includes a liquid cooling cable 36a and a liquid cooling cable 36b that are connected to two groups of charging connectors 31, and two fifth heat exchangers 310 (namely, a fifth heat exchanger 310a and a fifth heat exchanger 310b). The liquid cooling device 50 includes a second liquid outlet connector 51a, a second liquid outlet connector 51b, a second liquid inlet connector 52a, and a second liquid inlet connector 52b, and the charging device 40 includes a first liquid injection port 44a, a first liquid injection port 44b, a first liquid return port 45a, and a first liquid return port 45b. The second liquid outlet connector 51a and the second liquid outlet connector 51b are correspondingly connected to the first liquid injection port 44a and the first liquid injection port 44b, and the second liquid inlet connector 52a and the second liquid inlet connector 52b are correspondingly connected to the first liquid return port 45a and the first liquid return port 45b.

A liquid outlet 3102a of a fourth coolant path in the fifth heat exchanger 310a is connected to the second liquid outlet connector 51a, and a liquid inlet 3101a of the fourth coolant path in the fifth heat exchanger 310a is connected to the second liquid inlet connector 51b. The first liquid injection port 44a is connected to a liquid inlet 361a of the liquid cooling cable in the liquid cooling cable 36a, and the first liquid return port 45a is connected to a liquid outlet 362a of the liquid cooling cable in the liquid cooling cable 36a. Similarly, a liquid outlet 3102b of a fourth coolant path in the fifth heat exchanger 310b is connected to the second liquid outlet connector 51b, and a liquid inlet 3101b of the fourth coolant path in the fifth heat exchanger 310b is connected to the second liquid inlet connector 52b. The first liquid injection port 44b is connected to a liquid inlet 361b of the liquid cooling cable in the liquid cooling cable 36b, and the first liquid return port 45b is connected to a liquid outlet 362b of the liquid cooling cable in the liquid cooling cable 36b.

Based on the foregoing design, a connection pipe between the fifth heat exchanger 310a in the liquid cooling device 50 and the liquid cooling cable 36a and a connection pipe between the fifth heat exchanger 310b and the liquid cooling cable 36b are independent of each other.

In the foregoing technical solution, each fifth heat exchanger 310 located in the liquid cooling device 50 is connected, through an independent pipe, to a liquid cooling cable 36 connected to a corresponding charging connector 31 located in the charging device 40. This can avoid mutual impact between connection pipes between different fifth heat exchangers 310 and corresponding liquid cooling cables 36. Further, reliability of heat dissipation performed by the thermal management system 34 on the liquid cooling cables 36 connected to the plurality of groups of charging connectors 31 in the charging pile 30 can be improved.

It should be understood that, when the plurality of fifth heat exchangers 310 are located in the liquid cooling device 50, the plurality of second water pumps 38 corresponding to the plurality of fifth heat exchangers 310 may also be located in the liquid cooling device 50. For example, as shown in FIG. 24, the second water pump 38a and the second water pump 38b that correspond to the fifth heat exchanger 310a and the fifth heat exchanger 310b are also located in the liquid cooling device 50. Therefore, all the first water pump 37, the second water pump 38a, and the fifth heat exchanger 310 in the charging pile 30 are disposed in the liquid cooling device 50. This facilitates an integrated design of the liquid cooling device 50.

In another example, as shown in FIG. 25, the plurality of fifth heat exchangers 310 are located in the charging device 40. Each of the plurality of second liquid outlet connectors 51 is connected to the second liquid outlet 34053 of the first liquid storage tank, and each of the plurality of second liquid inlet connectors 52 is connected to the second liquid inlet 34055 of the first liquid storage tank, or each second liquid inlet connector 52 is connected to the liquid inlet 34024 of the first coolant path in the first heat exchanger 3402. In addition, the plurality of first liquid injection ports 44 are connected to liquid inlets 3103 of third coolant paths of the plurality of fifth heat exchangers 310 in a one-to-one correspondence, and the plurality of first liquid return ports 45 are connected to liquid outlets 3104 of the third coolant paths of the plurality of fifth heat exchangers 310 in a one-to-one correspondence. The fourth coolant path in each fifth heat exchanger 310 is connected to a corresponding liquid cooling cable 36.

For example, as shown in FIG. 25, the charging pile 30 shown in FIG. 23 includes the liquid cooling cable 36a and the liquid cooling cable 36b that are connected to the two groups of charging connectors 31, and the two fifth heat exchangers 310 (namely, the fifth heat exchanger 310a and the fifth heat exchanger 310b). The second liquid outlet connector 51a and the second liquid outlet connector 51b in the liquid cooling device 50 are correspondingly connected to the first liquid injection port 44a and the first liquid injection port 44b in the charging device 40, and the second liquid inlet connector 52a and the second liquid inlet connector 52b in the liquid cooling device 50 are correspondingly connected to the first liquid return port 45a and the first liquid return port 45b in the charging device 40.

The second liquid outlet connector 51a and the second liquid outlet connector 51b are connected to the second liquid outlet 34053 of the first liquid storage tank, and the second liquid inlet connector 52a and the second liquid inlet connector 52b are connected to the second liquid inlet 34055 of the first liquid storage tank. In addition, the first liquid injection port 44a and the first liquid injection port 44b are correspondingly connected to the liquid inlet 3103a of the third coolant path in the fifth heat exchanger 310a and the liquid inlet 3103b of the third coolant path in the fifth heat exchanger 310b, and the first liquid return port 45a and the first liquid return port 45b are correspondingly connected to the liquid outlet 3104a of the third coolant path in the fifth heat exchanger 310a and the liquid outlet 3104b of the third coolant path in the fifth heat exchanger 310b. In addition, the fourth coolant path in the fifth heat exchanger 310a is connected to the liquid cooling cable 36a, and the fourth coolant path in the fifth heat exchanger 310b is connected to the liquid cooling cable 36b.

Based on the foregoing design, a connection pipe between the fifth heat exchanger 310a located in the charging device 40 and the thermal management system 34 located in the liquid cooling device 50 and a connection pipe between the fifth heat exchanger 310b located in the charging device 40 and the thermal management system 34 located in the liquid cooling device 50 are independent of each other.

In the foregoing technical solution, each fifth heat exchanger 310 located in the charging device 40 is connected to the thermal management system 34 located in the liquid cooling device 50 through an independent pipe. This can avoid mutual impact between connection pipes between different fifth heat exchangers 310 and the thermal management system 34. Further, reliability of heat dissipation performed by the thermal management system 34 on the liquid cooling cables 36 connected to the plurality of groups of charging connectors 31 in the charging pile 30 can be improved.

It should be understood that, when the plurality of fifth heat exchangers 310 are located in the charging device 40, the plurality of second water pumps 38 corresponding to the plurality of fifth heat exchangers 310 may be located in the liquid cooling device 50 or the charging device 40.

In an example, the plurality of second water pumps 38 corresponding to the plurality of fifth heat exchangers 310 are located in the charging device 40. Each second water pump 38 is connected between the liquid inlet 3103 of the third coolant path in the corresponding fifth heat exchanger 310 and a first liquid injection port 44 connected to the corresponding fifth heat exchanger 310, or each second water pump 38 is connected between the liquid outlet 3104 of the third coolant path in the corresponding fifth heat exchanger 310 and a first liquid return port 45 connected to the corresponding fifth heat exchanger 310.

For example, as shown in FIG. 25, the second water pump 38a and the second water pump 38b that correspond to the fifth heat exchanger 310a and the fifth heat exchanger 310b are located in the charging device 40. The second water pump 38a is connected between the liquid inlet 3103a of the third coolant path in the fifth heat exchanger 310a and the first liquid injection port 44a, and the second water pump 38b is connected between the liquid inlet 3103b of the third coolant path in the fifth heat exchanger 310b and the first liquid injection port 44b.

In another example, the plurality of second water pumps 38 corresponding to the plurality of fifth heat exchangers 310 are located in the liquid cooling device 50. Each second water pump 38 is connected between the second liquid outlet 34053 of the first liquid storage tank and a second liquid outlet connector 51 connected to the corresponding fifth heat exchanger 310, or each second water pump 38 is connected between the second liquid inlet 34055 of the first liquid storage tank and a second liquid inlet connector 52 connected to the corresponding fifth heat exchanger 310, or each second water pump 38 is connected between the liquid inlet 34024 of the first coolant path in the first heat exchanger 3402 and a second liquid inlet connector 52 connected to the corresponding fifth heat exchanger 310.

For example, the second water pump 38a corresponding to the fifth heat exchanger 310a may alternatively be connected between the second liquid outlet 34053 of the first liquid storage tank and the second liquid outlet connector 51a, and the second water pump 38b corresponding to the fifth heat exchanger 310b is connected between the second liquid outlet 34053 of the first liquid storage tank and the second liquid outlet connector 51b.

In the foregoing technical solution, when the plurality of fifth heat exchangers 310 are located in the charging device 40, the second water pumps 38 corresponding to the plurality of fifth heat exchangers 310 may be disposed in the liquid cooling device 50 or the charging device 40. This helps improve flexibility of disposing the second water pump 38 in the charging pile 30.

Still refer to FIG. 24 and FIG. 25. In some embodiments, the third heat exchanger 39 is also located in the charging device 40. The second coolant path 391 of the third heat exchanger 39 is connected to the thermal management system 34 located in the liquid cooling device 50 through the second liquid injection port 48 and the second liquid return port 49 that are separately disposed in the charging device 40.

During specific implementation, the coolant output from the second liquid outlet 34053 of the first liquid storage tank may be divided into two paths via the third three-way valve 55 disposed in the liquid cooling device 50. One path flows into the liquid cooling cable 36, and the other path flows into the second coolant path 391. Similarly, the coolant flowing out of the second coolant path 391 and the coolant flowing out of the fifth heat exchanger 310 may be collected into one path via the third three-way valve 56 disposed in the liquid cooling device 50, and the coolant flows back to the first liquid storage tank 3405. For specific descriptions, refer to the embodiment shown in FIG. 9. Details are not described herein again.

It should be understood that a manner in which the second coolant path 391 is connected to the thermal management system 34 is merely an example. In some other embodiments, the liquid inlet 3911 of the second coolant path and the liquid outlet 3912 of the second coolant path are respectively connected to one first liquid injection port 44 and one first liquid return port 45 in the charging device 40, for example, connected to the first liquid injection port 44a and the first liquid return port 45a. Therefore, the coolant in the thermal management system 34 may also flow through the second coolant path 391, to dissipate heat from the switch in the power distribution cabin.

It should be further understood that, in this embodiment of this application, when each fifth heat exchanger 310 in the charging pile 30 is located in the charging device 40, to improve heat dissipation efficiency of the liquid cooling cable 36, the liquid cooling cable 36 connected to each fifth heat exchanger 310 may include a plurality of fifth coolant paths.

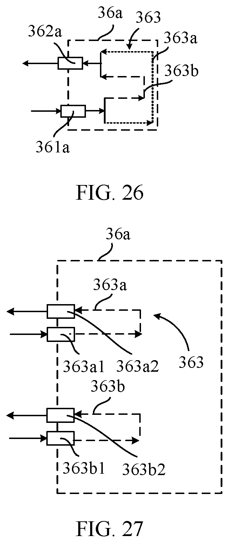

Specifically, in some embodiments, FIG. 26 and FIG. 27 each are a diagram of an example of a specific structure of the liquid cooling cable 36a shown in FIG. 25. When each fifth heat exchanger 310 in the charging pile 30 is located in the charging device 40, a cable liquid cooling pipe in the liquid cooling cable 36a includes a plurality of fifth coolant paths 363. The plurality of fifth coolant paths 353 are configured to circulate coolant, to dissipate heat from a positive charging cable and a negative charging cable. The plurality of fifth coolant paths 353 are connected to a same fifth heat exchanger 310, for example, connected to the fifth heat exchanger 310a.

In an example, as shown in FIG. 26, liquid inlets of the plurality of fifth coolant paths 353 are connected and then used as the liquid inlet 361a of the liquid cooling cable in the liquid cooling cable 36a, and liquid outlets of the plurality of fifth coolant paths 353 are connected and then used as a liquid outlet 362a of the liquid cooling cable in the liquid cooling cable 36a.

For example, as shown in FIG. 26, the liquid cooling cable 36a includes two fifth coolant paths 353, that is, includes a fifth coolant path 353a and a fifth coolant path 353b. A liquid inlet of the fifth coolant path 353a and a liquid inlet of the fifth coolant path 353b are connected and then used as the liquid inlet 361a of the liquid cooling cable, and a liquid outlet of the fifth coolant path 353a and a liquid outlet of the fifth coolant path 353b are connected and then used as the liquid outlet 362a of the liquid cooling cable.

Based on the foregoing design, the coolant may circulate between the fourth coolant path of the same fifth heat exchanger 310 and the plurality of fifth coolant paths 353 of the liquid cooling cable 36a, so that the plurality of fifth coolant paths 353 are used to dissipate heat from the positive charging cable and the negative charging cable in the liquid cooling cable 36a, to improve heat dissipation efficiency of the thermal management system 34 for the liquid cooling cable 36a. In addition, because the plurality of fifth coolant paths 353 are connected to a same fifth heat exchanger 310 through a group of liquid ports, complexity of pipe connections between the plurality of fifth coolant paths 353 in the liquid cooling cable 36a and the fifth heat exchanger 310 can be reduced, and cost optimization of the charging pile 30 is facilitated.

In another example, as shown in FIG. 27, liquid inlets of the plurality of fifth coolant paths 353 are separately disposed and jointly used as the liquid inlet 361a of the liquid cooling cable in the liquid cooling cable 36a, and liquid outlets of the plurality of fifth coolant paths 353 are separately disposed and jointly used as the liquid outlet 362a of the liquid cooling cable in the liquid cooling cable 36a.

For example, as shown in FIG. 25 and FIG. 27, the liquid cooling cable 36a includes two fifth coolant paths 353, that is, includes a fifth coolant path 353a and a fifth coolant path 353b. A liquid inlet 353a1 of a fifth coolant path in the fifth coolant path 353a and a liquid inlet 353b1 of a fifth coolant path in the fifth coolant path 353b are jointly used as the liquid inlet 361a of the liquid cooling cable in the liquid cooling cable 36a, to connect to the liquid outlet 3102a of the fourth coolant path in the fifth heat exchanger 310a. Similarly, a liquid outlet 353a2 of the fifth coolant path in the fifth coolant path 353a and a liquid outlet 353b2 of the fifth coolant path in the fifth coolant path 353b are jointly used as the liquid outlet 362a of the liquid cooling cable in the liquid cooling cable 36a, to connect to the liquid inlet 3101a of the fourth coolant path in the fifth heat exchanger 310a.

Based on the foregoing design, the coolant may circulate between the fourth coolant path of the same fifth heat exchanger 310 and the plurality of fifth coolant paths 353 of the liquid cooling cable 36a, so that the plurality of fifth coolant paths 353 are used to dissipate heat from the positive charging cable and the negative charging cable in the liquid cooling cable 36a, to improve heat dissipation efficiency of the liquid cooling cable 36a. In addition, because all the fifth coolant paths 353 are independently connected to the same fifth heat exchanger 310, mutual impact between the plurality of fifth coolant paths 353 can be avoided. This improves heat dissipation reliability of the liquid cooling cable 36a.

It should be understood that, in this embodiment of this application, related descriptions of the plurality of fifth coolant paths 353 in the liquid cooling cable 36a are applicable to the liquid cooling cable 36 connected to each group of charging connectors 31 in the charging pile 30.

It should be further understood that, that the charging pile 30 in the foregoing embodiment includes the second water pumps 38 and the fifth heat exchangers 310 whose quantities are equal is merely an example. In some other embodiments, the quantity of the second water pumps 38 and the quantity of the fifth heat exchangers 310 in the charging pile 30 may alternatively be unequal.

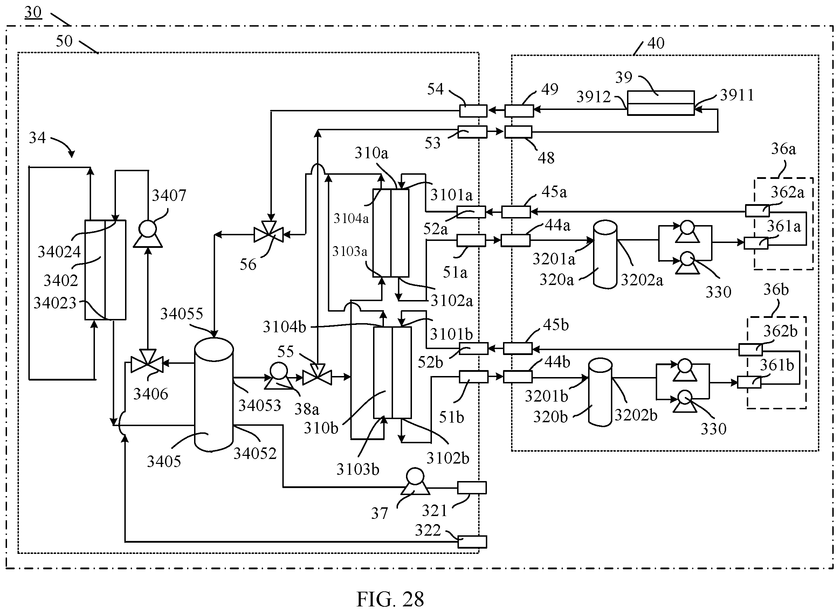

For example, in some embodiments, FIG. 28 is a diagram of another example of a specific structure in which the charging pile 30 shown in FIG. 14 includes a plurality of fifth heat exchangers 310. As shown in FIG. 28, the charging pile 30 includes one second water pump 38 and a plurality of fifth heat exchangers 310.

The second water pump 38 is connected between the second liquid outlet 34053 of the first liquid storage tank and the liquid inlet 3103 of the third coolant path in each fifth heat exchanger 310, or the second water pump 38 is connected between the second liquid inlet 34055 of the first liquid storage tank and the liquid outlet 3104 of the third coolant path in each fifth heat exchanger 310, or the second water pump 38 is connected between the liquid inlet 34024 of the first coolant path and the liquid outlet 3104 of the third coolant path in each fifth heat exchanger 310.

Based on the foregoing design, the thermal management system 34 in the charging pile 30 can dissipate, via one second water pump 38, heat from the liquid cooling cables 36 connected to the plurality of fifth heat exchangers 310. A small quantity of second water pumps 38 can reduce complexity of a pipe connection in the charging pile 30, reduce an increase in costs of the charging pile 30, and facilitate cost optimization of the charging pile 30.

During specific implementation, the second water pump 38 and the plurality of fifth heat exchangers 310 may be located in the liquid cooling device 50 together.

For example, as shown in FIG. 28, the charging pile 30 includes the liquid cooling cable 36a and the liquid cooling cable 36b that are connected to the two groups of charging connectors 31, the fifth heat exchanger 310a, and the fifth heat exchanger 310b. The charging pile 30 further includes one second water pump 38, that is, includes the second water pump 38a. All the second water pump 38a, the fifth heat exchanger 310a, and the fifth heat exchanger 310b are located in the liquid cooling device 50. The second water pump 38a is connected between the second liquid outlet 34053 of the first liquid storage tank and the liquid inlet 3103a of the third coolant path in the fifth heat exchanger 310a, and between the second liquid outlet 34053 of the first liquid storage tank and the liquid inlet 3103 of the third coolant path in the fifth heat exchanger 310b.

The foregoing describes a specific manner of disposing the fifth heat exchanger 310 in the charging pile 30 with reference to the accompanying drawings. The following continues to describe another structure of the charging pile 30 with reference to the accompanying drawings.

Refer to FIG. 18 to FIG. 25. In some embodiments, the charging pile 30 further includes one or more second liquid storage tanks 320. The one or more second liquid storage tanks 320 are in a one-to-one correspondence with the one or more fifth heat exchangers 310 in the charging pile 30, a liquid inlet 3201 of each second liquid storage tank is connected to a liquid outlet 3102 of a fourth coolant path in a corresponding fifth heat exchanger 310, and a liquid outlet 3202 of each second liquid storage tank is connected to a liquid inlet 361 of a liquid cooling cable connected to a corresponding fifth heat exchanger 310. In other words, each fifth heat exchanger 310 in the charging pile 30 is connected to the liquid cooling cable 36 via one second liquid storage tank 320.

For example, as shown in FIG. 18 to FIG. 22, the charging pile 30 includes one fifth heat exchanger 310 (namely, the fifth heat exchanger 310a) and the liquid cooling cable 36a and the liquid cooling cable 36b that are connected to the two groups of charging connectors 31, and the charging pile 30 further includes one second liquid storage tank 320. A liquid inlet 3201 of the second liquid storage tank is connected to the liquid outlet 3102a of the fourth coolant path in the fifth heat exchanger 310a, and a liquid outlet 3202 of the second liquid storage tank is connected to the liquid inlet 361a of the liquid cooling cable in the liquid cooling cable 36a and the liquid inlet 361b of the liquid cooling cable in the liquid cooling cable 36b.

In another example, as shown in FIG. 23 to FIG. 25, the charging pile 30 includes the liquid cooling cable 36a and the liquid cooling cable 36b that are connected to the two groups of charging connectors 31, and two fifth heat exchangers 310 (namely, the fifth heat exchanger 310a and the fifth heat exchanger 310b). The charging pile 30 further includes two second liquid storage tanks 320, that is, includes a second liquid storage tank 320a and a first liquid storage tank 320b.

A liquid inlet 3201a of the second liquid storage tank in the second liquid storage tank 320a is connected to the liquid outlet 3102a of the fourth coolant path in the fifth heat exchanger 310a, and a liquid outlet 3202a of the second liquid storage tank in the second liquid storage tank 320a is connected to the liquid inlet 361a of the liquid cooling cable in the liquid cooling cable 36a. Similarly, a liquid inlet 3201b of the second liquid storage tank in the second liquid storage tank 320b is connected to the liquid outlet 3102b of the fourth coolant path in the fifth heat exchanger 310b, and a liquid outlet 3202b of the second liquid storage tank in the second liquid storage tank 320b is connected to the liquid inlet 361b of the liquid cooling cable in the liquid cooling cable 36b.

Based on the foregoing design, cooled coolant in the fourth coolant path of each fifth heat exchanger 310 may flow into the second liquid storage tank 320 in advance for storage. When the liquid cooling cable 36 connected to the charging connector 31 needs to dissipate heat, the coolant whose temperature decreases and that is stored in the second liquid storage tank 320 may quickly flow into the liquid cooling cable 36. This helps improve timeliness of performing heat dissipation on the liquid cooling cable 36 by the thermal management system 34 via the fifth heat exchanger 310.

Further, in some embodiments, still as shown in FIG. 18 to FIG. 25, to enable the coolant in the second liquid storage tank 320 to flow into the liquid cooling cable 36, the charging pile 30 further includes a third water pump 330. The third water pump 330 is connected between the liquid outlet 3202 of each second liquid storage tank and the liquid inlet 361 of the liquid cooling cable connected to each second liquid storage tank 320, or the third water pump 330 is connected between the liquid inlet 3101 of the fourth coolant path in each fifth heat exchanger 310 and the liquid outlet 362 of the liquid cooling cable connected to each fifth heat exchanger 310. In other words, the liquid outlet 3202 of each second liquid storage tank is connected to the liquid inlet 361 of the liquid cooling cable via the third water pump 330, or the liquid inlet 3101 of the fourth coolant path in each fifth heat exchanger 310 is connected to the liquid outlet 362 of the liquid cooling cable via the third water pump 330.

For example, FIG. 18 to FIG. 25 each show an example in which the third water pump 330 is connected between the liquid outlet 3202 of each second liquid storage tank and the liquid inlet 361 of the liquid cooling cable connected to each second liquid storage tank 320. In addition, during specific implementation, the liquid outlet 3202 of each second liquid storage tank is connected to the liquid inlet 361 of the liquid cooling cable via two third water pumps 330 connected in parallel.

Based on the foregoing design, the third water pump 330 may drive the coolant in the second liquid storage tank 320 to flow into the liquid cooling cable 36, so that the thermal management system 34 can dissipate heat from the liquid cooling cable 36 via the fifth heat exchanger 310.

It should be understood that a quantity of third water pumps 330 connected to the liquid outlet 3202 of each second liquid storage tank is merely an example. For example, in some other embodiments, the liquid outlet 3202 of each second liquid storage tank may alternatively be connected to the liquid inlet 361 of the liquid cooling cable via one third water pump 330, or the liquid outlet 3202 of each second liquid storage tank may be connected to the liquid inlet 361 of the liquid cooling cable via three third water pumps 330 connected in parallel. In this embodiment of this application, a quantity of the third water pumps 330 needs to meet only a requirement that the coolant in the second liquid storage tank 320 can be driven to flow into the liquid cooling cable 36.

It should be understood that, for parts of the charging pile 30 shown in FIG. 14 to FIG. 28 that are not described in detail, refer to the embodiments shown in FIG. 3 to FIG. 13. Details are not described herein again.

An embodiment of this application further provides a charging device. The charging device includes one or more groups of charging connectors, one or more first liquid injection ports, and one or more first liquid return ports. Each group of charging connectors is configured to output electric energy to an electric vehicle, each first liquid injection port is configured to connect to a liquid outlet connector of a liquid cooling device, and each first liquid return port is configured to connect to a liquid inlet connector of the liquid cooling device. The one or more first liquid injection ports are in a one-to-one correspondence with the one or more first liquid return ports, each first liquid injection port is connected to a liquid inlet of a liquid cooling cable connected to at least one of the one or more groups of charging connectors, and each first liquid return port is connected to a liquid outlet of the liquid cooling cable connected to the at least one group of charging connectors. For specific descriptions, refer to related descriptions in the embodiments shown in FIG. 3 to FIG. 13. Details are not described herein again.

An embodiment of this application further provides a charging device. The charging device includes one or more groups of charging connectors, one or more fifth heat exchangers, one or more first liquid injection ports, and one or more first liquid return ports. Each group of charging connectors is configured to output electric energy to an electric vehicle, each first liquid injection port is configured to connect to a liquid outlet connector of a liquid cooling device, and each first liquid return port is configured to connect to a liquid inlet connector of the liquid cooling device. Each fifth heat exchanger includes a third coolant path and a fourth coolant path, and the third coolant path is used to exchange heat with the fourth coolant path. The one or more first liquid injection ports are in a one-to-one correspondence with the one or more first liquid return ports, each first liquid injection port is connected to a liquid inlet of a third coolant path of at least one of the one or more fifth heat exchangers, and each first liquid return port is connected to a liquid outlet of the third coolant path of the at least one fifth heat exchanger. A liquid outlet of the fourth coolant path of each fifth heat exchanger is connected to a liquid inlet of a liquid cooling cable connected to at least one of the one or more groups of charging connectors, and a liquid inlet of the fourth coolant path of each fifth heat exchanger is connected to a liquid outlet of the liquid cooling cable connected to the at least one group of charging connectors. For specific descriptions, refer to related descriptions in the embodiments shown in FIG. 14 to FIG. 28. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A charging pile, wherein the charging pile comprises one or more groups of charging connectors, a thermal management system, a first liquid outlet connector, and a first liquid inlet connector, each of the one or more groups of charging connectors is configured to output electric energy to an electric vehicle, the first liquid outlet connector is configured to connect to a liquid injection port of the electric vehicle, and the first liquid inlet connector is configured to connect to a liquid return port of the electric vehicle;
the thermal management system comprises a first compressor, a first heat exchanger, a first expansion valve, and a second heat exchanger that are sequentially connected, the first heat exchanger comprises a first refrigerant path and a first coolant path, the first refrigerant path is connected between the first compressor and the first expansion valve, and the first refrigerant path is used to exchange heat with the first coolant path; and
a liquid outlet of the first coolant path is connected to the first liquid outlet connector and a liquid inlet of a liquid cooling cable connected to each group of charging connectors, and a liquid inlet of the first coolant path is connected to the first liquid inlet connector.

2. The charging pile according to claim 1, wherein the thermal management system further comprises a first liquid storage tank, and the liquid outlet of the first coolant path is connected to the first liquid outlet connector and the liquid inlet of the liquid cooling cable connected to each group of charging connectors via the first liquid storage tank; and
a first liquid inlet of the first liquid storage tank is connected to the liquid outlet of the first coolant path, a first liquid outlet of the first liquid storage tank is connected to the first liquid outlet connector, and a second liquid outlet of the first liquid storage tank is connected to the liquid inlet of the liquid cooling cable connected to each group of charging connectors.

3. The charging pile according to claim 2, wherein a liquid outlet of the liquid cooling cable connected to each group of charging connectors is connected to the liquid inlet of the first coolant path, or a liquid outlet of the liquid cooling cable connected to each group of charging connectors is connected to a second liquid inlet of the first liquid storage tank.

4. The charging pile according to claim 3, wherein a third liquid outlet of the first liquid storage tank is connected to the liquid inlet of the first coolant path, and
wherein the thermal management system further comprises a first three-way valve, a first valve port of the first three-way valve is connected to the first liquid inlet connector, a second valve port of the first three-way valve is connected to the third liquid outlet of the first liquid storage tank, and a third valve port of the first three-way valve is connected to the liquid inlet of the first coolant path.

5. The charging pile according to claim 4, wherein the charging pile is configured to:
when a charging connector in the one or more groups of charging connectors transmits electric energy to the electric vehicle, control the first three-way valve to connect the path between the first liquid inlet connector and the liquid inlet of the first coolant path, and disconnect the path between the third liquid outlet of the first liquid storage tank and the liquid inlet of the first coolant path.

6. The charging pile according to any one of claims 3 to5, wherein the charging pile further comprises one first water pump and one second water pump;
the first water pump is connected between the first liquid outlet of the first liquid storage tank and the first liquid outlet connector; and
the second water pump is connected between the second liquid outlet of the first liquid storage tank and the liquid inlet of the liquid cooling cable connected to each group of charging connectors, or the second water pump is connected between the second liquid inlet of the first liquid storage tank and the liquid outlet of the liquid cooling cable connected to each group of charging connectors, or the second water pump is connected between the liquid inlet of the first coolant path and the liquid outlet of the liquid cooling cable connected to each group of charging connectors.

7. The charging pile according to any one of claims 3 to 5, wherein the charging pile further comprises one first water pump and a plurality of second water pumps, and the one or more groups of charging connectors comprise a plurality of groups of charging connectors;
the first water pump is connected between the first liquid outlet of the first liquid storage tank and the first liquid outlet connector; and
the plurality of second water pumps are in a one-to-one correspondence with liquid cooling cables connected to the plurality of groups of charging connectors, each of the plurality of second water pumps is connected between the second liquid outlet of the first liquid storage tank and a liquid inlet of a corresponding liquid cooling cable, or each second water pump is connected between the second liquid inlet of the first liquid storage tank and a liquid outlet of a corresponding liquid cooling cable, or each second water pump is connected between the liquid inlet of the first coolant path and a liquid outlet of a corresponding liquid cooling cable.

8. A charging pile, wherein the charging pile comprises one or more groups of charging connectors, one or more fifth heat exchangers, a thermal management system, a first liquid outlet connector, and a first liquid inlet connector, each of the one or more groups of charging connectors is configured to output electric energy to an electric vehicle, the first liquid outlet connector is configured to connect to a liquid injection port of the electric vehicle, and the first liquid inlet connector is configured to connect to a liquid return port of the electric vehicle;
the thermal management system comprises a first compressor, a first heat exchanger, a first expansion valve, and a second heat exchanger that are sequentially connected, the first heat exchanger comprises a first refrigerant path and a first coolant path, the first refrigerant path is connected between the first compressor and the first expansion valve, and the first refrigerant path is used to exchange heat with the first coolant path;
a liquid outlet of the first coolant path is connected to the first liquid outlet connector, and a liquid inlet of the first coolant path is connected to the first liquid inlet connector;
each of the one or more fifth heat exchangers comprises a third coolant path and a fourth coolant path, a liquid inlet of the third coolant path is connected to the liquid outlet of the first coolant path, and the third coolant path is used to exchange heat with the fourth coolant path; and
a liquid outlet of the fourth coolant path of each fifth heat exchanger is connected to a liquid inlet of a liquid cooling cable connected to at least one of the one or more groups of charging connectors, and a liquid inlet of the fourth coolant path of each fifth heat exchanger is connected to a liquid outlet of the liquid cooling cable connected to the at least one group of charging connectors.

9. The charging pile according to claim 8, wherein the thermal management system further comprises a first liquid storage tank, and the liquid outlet of the first coolant path is connected to the first liquid outlet connector and the liquid inlet of the third coolant path via the first liquid storage tank; and
a first liquid inlet of the first liquid storage tank is connected to the liquid outlet of the first coolant path, a first liquid outlet of the first liquid storage tank is connected to the first liquid outlet connector, and a second liquid outlet of the first liquid storage tank is connected to the liquid inlet of the third coolant path.

10. The charging pile according to claim 9, wherein a liquid outlet of the third coolant path is connected to the liquid inlet of the first coolant path, or a liquid outlet of the third coolant path is connected to a second liquid inlet of the first liquid storage tank.

11. The charging pile according to claim 10, wherein a third liquid outlet of the first liquid storage tank is connected to the liquid inlet of the first coolant path, and
wherein the thermal management system further comprises a first three-way valve, a first valve port of the first three-way valve is connected to the first liquid inlet connector, a second valve port of the first three-way valve is connected to the third liquid outlet of the first liquid storage tank, and a third valve port of the first three-way valve is connected to the liquid inlet of the first coolant path.

12. The charging pile according to claim 11, wherein the charging pile is configured to:
when a charging connector in the one or more groups of charging connectors transmits electric energy to the electric vehicle, control the first three-way valve to connect the path between the first liquid inlet connector and the liquid inlet of the first coolant path, and disconnect the path between the third liquid outlet of the first liquid storage tank and the liquid inlet of the first coolant path.

13. The charging pile according to any one of claims 10 to 12, wherein the charging pile further comprises a first water pump and one or more second water pumps;
the first water pump is connected between the first liquid outlet of the first liquid storage tank and the first liquid outlet connector; and
the one or more second water pumps are in a one-to-one correspondence with the one or more fifth heat exchangers, each of the one or more second water pumps is connected between the second liquid outlet of the first liquid storage tank and a liquid inlet of a third coolant path of a corresponding fifth heat exchanger, or each second water pump is connected between the second liquid inlet of the first liquid storage tank and a liquid outlet of a third coolant path of a corresponding fifth heat exchanger, or each second water pump is connected between the liquid inlet of the first coolant path and a liquid outlet of a third coolant path of a corresponding fifth heat exchanger.

14. The charging pile according to claim 13, wherein when the one or more fifth heat exchangers comprise one fifth heat exchanger, a liquid outlet of a fourth coolant path of the fifth heat exchanger is connected to a liquid inlet of a liquid cooling cable connected to each group of charging connectors, and a liquid inlet of the fourth coolant path of the fifth heat exchanger is connected to a liquid outlet of the liquid cooling cable connected to each group of charging connectors; or
when the one or more fifth heat exchangers comprise a plurality of fifth heat exchangers, and the one or more groups of charging connectors comprise a plurality of groups of charging connectors, the plurality of fifth heat exchangers are in a one-to-one correspondence with liquid cooling cables connected to the plurality of groups of charging connectors, a liquid outlet of a fourth coolant path of each of the plurality of fifth heat exchangers is connected to a liquid inlet of a corresponding liquid cooling cable, and a liquid inlet of the fourth coolant path of each of the plurality of fifth heat exchangers is connected to a liquid outlet of the corresponding liquid cooling cable.

15. The charging pile according to any one of claims 10 to 14, wherein the charging pile further comprises one or more second liquid tanks; and
the one or more second liquid storage tanks are in a one-to-one correspondence with the one or more fifth heat exchangers, a liquid inlet of each second liquid storage tank is connected to a liquid outlet of a fourth coolant path of a corresponding fifth heat exchanger, and a liquid outlet of each second liquid storage tank is connected to a liquid inlet of a liquid cooling cable connected to the corresponding fifth heat exchanger.
